(19) **Europäisches Patentamt**
**European Patent Office**
**Office européen des brevets**

(11) **EP 3 196 714 B2**

(12) # NEUE EUROPÄISCHE PATENTSCHRIFT
### Nach dem Einspruchsverfahren

(45) Veröffentlichungstag und Bekanntmachung des Hinweises auf die Entscheidung über den Einspruch:
**23.08.2023 Patentblatt 2023/34**

(45) Hinweis auf die Patenterteilung:
**16.12.2020 Patentblatt 2020/51**

(21) Anmeldenummer: **16171914.1**

(22) Anmeldetag: **30.05.2016**

(51) Internationale Patentklassifikation (IPC):
***G05B 17/02*** *(2006.01)*

(52) Gemeinsame Patentklassifikation (CPC):
**G05B 17/02;** G05B 2219/23446

(54) **SIMULATIONSVERFAHREN UND SIMULATIONSVORRICHTUNG**

SIMULATION METHOD AND SIMULATION DEVICE

PROCÉDÉ ET DISPOSITIF DE SIMULATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.01.2016 DE 102016100771**
**13.05.2016 DE 102016108933**

(43) Veröffentlichungstag der Anmeldung:
**26.07.2017 Patentblatt 2017/30**

(73) Patentinhaber: **dSPACE GmbH**
**33102 Paderborn (DE)**

(72) Erfinder: **Meyer, Gerrit**
**33098 Paderborn (DE)**

(74) Vertreter: **Gesthuysen Patentanwälte**
**Partnerschaftsgesellschaft mbB**
**Huyssenallee 68**
**45128 Essen (DE)**

(56) Entgegenhaltungen:
**DE-A1-102005 048 464**

• **S. UEBENER: "Evaluierung und Anwendung eines Emulators für elektrische Maschinen in der Entwicklung von Elektro- und Hybridfahrzeugen", Dissertation, 2015, pages 1-180, Universität Paderborn**

**EP 3 196 714 B2**

**Beschreibung**

Die Erfindung betrifft einerseits ein Verfahren zur Simulation einer an ein Regelungsgerät anschließbaren peripheren Schaltungsanordnung und andererseits eine Simulationsvorrichtung zur Simulation einer an ein Regelungsgerät anschließbaren peripheren Schaltungsanordnung.

Aus der PCT-Druckschrift WO 2010 010022 A1 ist eine Schaltung zur Nachbildung - das heißt zur Simulation - einer elektrischen Last an einem Anschluss einer Testschaltung bekannt. Einige Bestandteile der Figur 3 der o.g. PCT-Druckschrift sind vorliegend als Figur 1c zum besseren Verständnis des Standes der Technik beigefügt. In der Druckschrift wird insbesondere eine steuerbare Spannungsquelle als vierquadrantenfähige Umschaltvorrichtung 17 mit einer internen Spannungsquelle 18 vorgeschlagen. Ein von der vierquadrantenfähigen Umschaltvorrichtung 17 zu der Testschaltung 3 fließender Strom kann insbesondere via Induktivität 14 eines Brückenquerzweigs eingekoppelt werden. Je nach Anforderungen an die Dynamik der Schaltung zur Simulation und je nach Ausprägung von Erfordernissen, eine ungewollte Überlagerung des Stromes im Brückenquerzweig mit Rippelströmen bzw. eine ungewollte - gegebenenfalls hochfrequente - Wechselstromüberlagerung des Stromes im Brückenquerzweig zumindest zu reduzieren oder zu vermeiden, könnte sich die aus der Druckschrift bekannte steuerbare Spannungsquelle 13 als nicht ausreichend für hochgradig präzise Simulationsanwendungen erweisen.

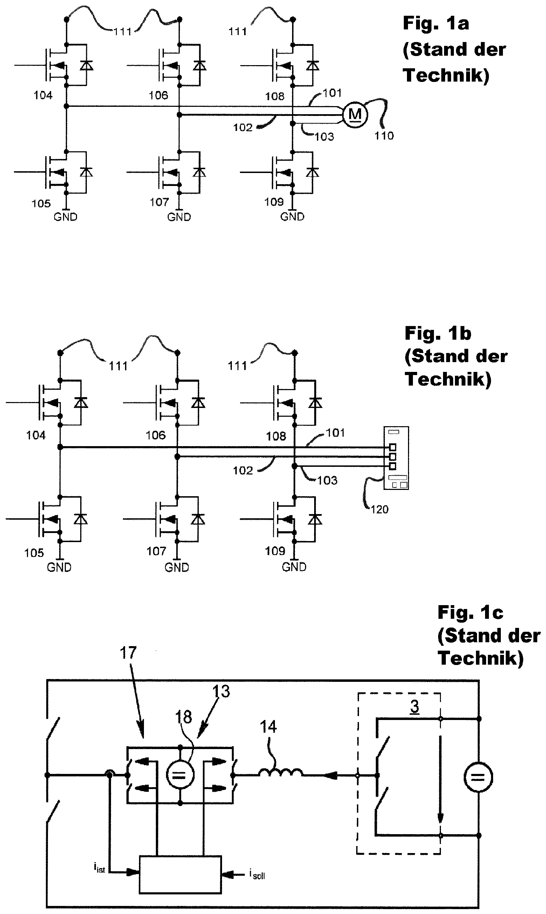

Zum allgemeinen Fachwissen gehört es, dass ein mehrphasiger - insbesondere dreiphasiger - elektrischer Verbraucher, beispielsweise ein Elektromotor 110 aus der Figur 1a, hier als ein Drei-Phasen-Elektromotor ausgestaltet, mit einer Versorgungsschaltung verbunden werden kann, wobei pro Phase beispielsweise jeweils eine zugeordnete Halbbrückenschaltung zur Stromsteuerung an der jeweiligen Phase angeschlossen werden kann. Die Figur 1a zeigt ein Beispiel aus dem Stand der Technik, wobei die drei Phasen 101, 102, 103 eines Elektromotors 110 mittels einer ersten Halbbrücke 104, 105, einer zweiten Halbbrücke 106, 107 und einer dritten Halbbrücke 108, 109 versorgt werden, wobei diese drei Halbbrücken aus Feldeffekttransistoren 104, 105, 106, 107, 108, 109, abgekürzt FETs, gebildet sind. Die Drain-Anschlüsse der FETs 104, 106, 108 sind mit einer gemeinsamen Betriebsspannung 111 verbunden. Die Source-Anschlüsse der FETs 105, 107, 109 sind mit einem gemeinsamen Referenzpotential GND verbunden. Die drei Halbbrücken aus Figur 1a können in ein Regelungsgerät integriert werden, das den Elektromotor 110 ansteuert.

Die Figur 1b ist abgesehen davon, dass im Vergleich zu Figur 1a der Elektromotor 110 durch eine Elektromotor-Simulationsvorrichtung 120 ersetzt ist, identisch zu Figur 1a. Es ist eine aus dem Stand der Technik allgemein bekannte Herangehensweise, eine periphere Schaltungsanordnung, beispielsweise den Elektromotor 110 aus Figur 1a, durch eine Simulationsvorrichtung, beispielsweise eine Elektromotor-Simulationsvorrichtung 120 aus Figur 1b, für Testzwecke zu ersetzen. Ein häufig auftretendes Problem bekannter Elektromotor-Simulationsvorrichtungen ist, dass diese entweder nicht ausreichend genau die Realität nachbilden, oder dass die bekannten Elektromotor-Simulationsvorrichtungen nicht flexibel genug auf veränderte zu simulierende Elektromotoren umrüstbar sind oder derartige Umrüstungen sehr umfangreiche Hardware-Änderungen erfordern, die zeitraubend sind.

Für einen Test eines Steuergerätes bzw. eines Regelungsgerätes, das in einer später vorgesehenen Verwendung mit einer peripheren Schaltungsanordnung, beispielsweise mit einer elektrischen Last, möglicherweise mit einen Elektromotor, verbunden werden soll, wird häufig eine entsprechende Testumgebung - insbesondere eine Simulationsvorrichtung - eingesetzt.

Es ist bekannt, dass ein auf dem eingangs genannten technischen Gebiet tätiger Fachmann, der eine Simulationsvorrichtung zur Simulation einer an ein Regelungsgerät anschließbaren peripheren Schaltungsanordnung bereitstellen möchte, häufig auf eine Simulationsvorrichtung zurückgreift, die eine Recheneinheit umfasst, auf der ein ausführbaren Modellcode installiert ist. Der Modellcode baut auf einem mathematischen Modell der peripheren Schaltungsanordnung auf. Das mathematische Modell wird beispielsweise in einem mehrere Schritte umfassenden Verfahren, z. B. umfassend eine Programmierung, eine sogenannten Code-Generierung und einen Übersetzungsschritt, in einen auf einer Recheneinheit ausführbaren Modellcode umgewandelt.
Mittels einer zyklischen Ausführung, also einer zyklischen Abarbeitung des Modellcodes werden in Abhängigkeit von Eingangsvariablen vordefinierte Ausgangsvariablen zyklisch berechnet, die beispielsweise für eine Bereitstellung von Spannungen und/oder Strömen zu Simulationszwecken benutzt bzw. weiterverarbeitet werden können.

Der Test unter Verwendung einer Simulationsvorrichtung kann insbesondere den Vorteil mit sich bringen, dass sich das Steuergerät bzw. das Regelungsgerät funktional überprüften lässt, ohne dass das Steuergerät bzw. Regelungsgerät in dessen "echte" Arbeitsumgebung gebracht werden muss. Das zu testende Regelungsgerät - oft als zu testendes "Steuergerät" bezeichnet - wird in dem oben beschriebenen Kontext fachsprachlich häufig das "device under test", abgekürzt als das "DUT", genannt. Häufig wird das Regelungsgerät bzw. das DUT mit einer entsprechend eingerichteten Simulationsvorrichtung elektrisch verbunden um zu testen, ob das Regelungsgerät in gewünschter Weise reagiert, ob also das Regelungsgerät auf bestimmte - über seine Schnittstellen empfangene - Zustandsgrößen mit einer geeigneten Ausgabe von - über seine Schnittstellen ausgegebene - Ausgangsgrößen reagiert. Dazu wird die relevante Umgebung eines Regelungsgerätes ganz oder teilweise simuliert.

In allgemein bekannten Testszenarien umfasst die nachzubildende Umgebung des zu testenden Regelungsgerätes, insbesondere auch leistungselektrische Bauteile. Beispielsweise kann es für den Test eines Regelungsgerätes erforderlich sein, eine Nachbildung also eine Simulation eines Elektromotors oder einer anderen elektrischen Last bereitzustellen, die insbesondere auch eine Induktivitätssimulation umfasst. Derartige Umgebungen können prinzipiell sowohl softwareseitig als auch mittels Hardware simuliert werden. Häufig kommt für den Test eines Regelungsgerätes mit leistungselektrischen Ausgängen und/oder Eingängen eine Simulationsvorrichtung eine speziell gestaltete Hardware und eine entsprechend adaptierte Simulationssoftware zum Einsatz.

Eine Besonderheit bei einer Simulation einer induktiven Last, um bei diesem Beispiel einer simulierten elektrischen Last zu bleiben, besteht insbesondere darin, dass in der Simulation berücksichtigt werden muss, dass eine Änderung der - die korrespondierende echte induktive Last durchdringende - magnetischen Flussdichte, die beispielsweise durch einen Schaltvorgang im Regelungsgerät hervorgerufen werden kann, zu einer induzierten Spannung führt. Die damit einhergehenden nichtlinearen Strom- und Spannungsverläufe, sollen in der Simulation der elektrischen Last so realitätsnah wie möglichst nachgebildet werden. Mit anderen Worten ausgedrückt, soll die in der Testphase des Regelungsgerätes verwendete Simulationsvorrichtung das in der späteren Praxisphase auftretende Verhalten einer "echten" induktiven Last möglichst gleichartig widerspiegeln.

Die bisher zur Verfügung stehenden Simulationsvorrichtungen, insbesondere die für eine sogenannte "Hardware-in-the-Loop-Simulation" - abgekürzt "HIL-Simulation" - geeigneten Simulationsvorrichtungen, mangelt es an ausreichender Skalierbarkeit bzw. an ausreichender Adaptierbarkeit, d.h. eine Skalierung und Adaptierung der bisherigen Simulationsvorrichtungen beispielsweise zum Zwecke einer Anpassung der Simulationsvorrichtung an unterschiedliche zu simulierende induktive Lasten, erfordert in vielen Fällen umfangreiche Hardwareänderungen. Die Probleme, die sich aus der beschriebenen unzureichenden Skalierbarkeit bzw. unzureichenden Adaptierbarkeit ergeben, sind bisher oft nur mittels Umbau- bzw. Umrüstungsarbeiten an der Simulationsvorrichtung lösbar, insbesondere dann, wenn sich die elektrotechnischen Kenngrößen der nacheinander zu simulierenden induktiven Lasten erheblich voneinander unterscheiden.

Es besteht ein Bedarf in der Industrie und in der Forschung/Entwicklung, insbesondere in der Produktentwicklung und in der Qualitätssicherung, für ein verbessertes Verfahren zur Simulation und eine verbesserte Simulationsvorrichtung zur Simulation einer peripheren Schaltungsanordnung, beispielsweise zur Simulation einer induktiven Last. Häufig bestehen Anforderungen an die Simulation des dynamischen Verhaltens der induktiven Last mittels eines Modellcodes derart, dass die zum Modellcode zugehörigen und zyklisch zu berechnenden Modellvariablen beispielsweise in Ausführungszeiten berechenbar sein müssen, die im Bereich von einigen Millisekunden oder sogar nur von einigen Mikrosekunden liegen. Hierbei ist mit einer Ausführungszeit die Zeitspanne gemeint, die eine Recheneinheit benötigt, um einen Simulations-Modellcode einmal abzuarbeiten. Mit anderen Worten ausgedrückt, wird der Modellcode während einer Simulation zyklisch ausgeführt, wobei bevorzugt jede Abarbeitung des Modellcodes innerhalb einer vordefinierten Ausführungszeit erfolgt und die Abarbeitung des Modellcodes im Wesentlichen solange wiederholt wird, wie die Simulation läuft. Eine modellbasierte Simulation, wie sie auf der genannten Simulationsvorrichtung stattfindet, setzt eine zyklische - also eine wiederholt ausführbare - Abarbeitung des Modellcodes auf der Recheneinheit der Simulationsvorrichtung voraus. Prinzipiell ist eine Verwendung rechnergestützter Simulationsmodelle und eine Verwendung zugehöriger ausführbarer Modellcodes bekannt, mit denen die oben genannten Ausführungszeiten für die zyklische Modellcode-Abarbeitung sichergestellt werden können, nämlich beispielsweise Simulationsmodelle, die mittels einer numerischen Entwicklungs- und Simulationsumgebung erstellt werden können. Ein Beispiel für eine Entwicklungs- und Simulationsumgebung umfassend ein graphische Programmier-Umgebung ist das Softwareprodukt SIMULINK des Unternehmens The MathWorks. Ein Beispiel für eine Erstellung eines ausführbaren Modellcodes, beispielsweise mittels des Softwareproduktes SIMULINK, ist in dem US-Patent US 9,020,798 B2 erwähnt (Anmelder des US-Patents ist wie bei der vorliegenden Erfindung die dSPACE digital signal processing and control engineering GmbH).

Es kommt jedoch in der Praxis häufig nicht allein darauf an, die Modellvariablen zur Beschreibung des sich dynamisch ändernden Zustandes der induktiven Last innerhalb der vorgegebenen Ausführungszeit mittels des Modellcodes bereitzustellen, sondern es kann beispielsweise erforderlich sein, die Simulation der peripheren Schaltungsanordnung, beispielsweise die Simulation der induktiven Last, derart auszuführen, dass an den elektrischen Verbindungsstellen zwischen der Simulationsvorrichtung und dem/den Regelungsgerät/en insbesondere Spannungen und/oder Ströme bereitgestellt werden, die einen hohen Grad an Übereinstimmung mit den dynamisch veränderlichen Spannungen und/oder Strömen bei einer "echten" - also nicht simulierten - peripheren Schaltungsanordnung aufweisen. Die nicht simulierte periphere Schaltungsanordnung umfasst beispielsweise eine induktive Last.

Anders ausgedrückt ist es ein Erfordernis, einem Anwender ein Verfahren zur Simulation und eine Simulationsvorrichtung bereitzustellen, die eingerichtet sind, um an den vorgesehenen elektrischen Anschlüssen der Simulationsvorrichtung für das Regelungsgerät entsprechende Ströme und/oder Spannungen einzustellen, die lediglich jeweils vordefinierte maximal zulässige Abweichungen von den korrespondierenden Strömen und/oder Spannungen aus einem späteren Anwendungsfall des Regelungsgerätes aufweisen.

Vor diesem Hintergrund besteht die Aufgabe der Erfindung darin, einerseits ein Verfahren zur Simulation einer an ein Regelungsgerät anschließbaren peripheren Schaltungsanordnung anzugeben und andererseits eine Simulationsvorrichtung anzugeben, die den Stand der Technik weiterbilden. Die genannten Probleme oder Nachteile des Standes der Technik sollen bevorzugt zumindest teilweise vermieden oder reduziert werden.

Die Aufgabe wird hinsichtlich des Verfahrens zur Simulation durch die Merkmale des Patentanspruchs 1 und hinsichtlich der Simulationsvorrichtung durch die Merkmale des Patentanspruchs 9 gelöst. Vorteilhafte Ausgestaltungen der Erfindung sind Gegenstand von abhängigen Ansprüchen.

Erfindungsgemäß wird ein Verfahren gemäß Patentanspruch 1 zur Simulation einer an ein Regelungsgerät anschließbaren peripheren Schaltungsanordnung vorgeschlagen, wobei eine Simulationsvorrichtung mit dem Regelungsgerät elektrisch verbunden ist, und wobei die Simulationsvorrichtung ein erstes Stellmittel aufweist, mit dem ein von einem ersten Lastanschluss des Regelungsgerätes zu einem ersten Stellmittelausgang des ersten Stellmittels weiterleitbarer erster Simulationsstrom beeinflussbar ist, und wobei das erste Stellmittel einen ersten Mehrstufen-Konverter, aufweisend zumindest einen ersten Halbleiterschalter mit einem ersten Steuerungs-Anschluss, einen zweiten Halbleiterschalter mit einem zweiten Steuerungs-Anschluss, einen dritten Halbleiterschalter mit einem dritten Steuerungs-Anschluss, und einen vierten Halbleiterschalter mit einem vierten Steuerungs-Anschluss, umfasst, und wobei die Simulationsvorrichtung des Weiteren ein erstes Halbleiterschaltersteuerungsmittel und eine Recheneinheit umfasst, und die Recheneinheit einen Modellcode ausführt, wobei mittels der Recheneinheit und des Modellcodes ein erstes Schaltersteuersignal zur Weitergabe an das erste Halbleiterschaltersteuerungsmittel berechnet und bereitstellt wird, und wobei das erste Halbleiterschaltersteuerungsmittel zumindest einen ersten Komparator aufweist, und der erste Komparator einen ersten Komparator-Eingang und einen zweiten Komparator-Eingang und einen ersten Komparator-Ausgang umfasst, und wobei aus dem ersten Schaltersteuersignal ein erstes Modulationssignal abgeleitet und an den ersten Komparator-Eingang angelegt wird, und an den zweiten Komparator-Eingang ein erstes Trägersignal eines ersten Trägersignalgenerators angelegt wird, und mittels des ersten Komparators ein Vergleich des ersten Modulationssignals mit dem ersten Trägersignal ausgeführt wird, wobei im Zuge des Vergleichs an dem ersten Komparator-Ausgang eine pulsweitenmodulierte erste Gate-Source-Spannung erzeugt und an den ersten Steuerungs-Anschluss angelegt wird, und mittels der ersten Gate-Source-Spannung der erste Simulationsstrom beeinflusst wird.

Erfindungsgemäß wird des Weiteren eine Simulationsvorrichtung gemäß Patentanspruch 9 zur Simulation einer an ein Regelungsgerät anschließbaren peripheren Schaltungsanordnung vorgeschlagen, wobei die Simulationsvorrichtung mit dem Regelungsgerät elektrisch verbindbar ist, und wobei die Simulationsvorrichtung ein erstes Stellmittel aufweist, mit dem ein von einem ersten Lastanschluss des Regelungsgerätes zu einem ersten Stellmittelausgang des ersten Stellmittels weiterleitbarer erster Simulationsstrom beeinflussbar ist, und wobei das erste Stellmittel einen ersten Mehrstufen-Konverter, aufweisend zumindest einen ersten Halbleiterschalter mit einem ersten Steuerungs-Anschluss, einen zweiten Halbleiterschalter mit einem zweiten Steuerungs-Anschluss, einen dritten Halbleiterschalter mit einem dritten Steuerungs-Anschluss, und einen vierten Halbleiterschalter mit einem vierten Steuerungs-Anschluss, umfasst, wobei die Simulationsvorrichtung des Weiteren ein erstes Halbleiterschaltersteuerungsmittel und eine Recheneinheit umfasst, und die Recheneinheit zur Ausführung eines Modellcodes vorgesehen und eingerichtet ist, wobei vorgesehen ist, dass mittels der Recheneinheit und des Modellcodes ein erstes Schaltersteuersignal zur Weitergabe an das erste Halbleiterschaltersteuerungsmittel berechnet und bereitstellt wird, und wobei das erste Halbleiterschaltersteuerungsmittel zumindest einen ersten Komparator aufweist, und der erste Komparator einen ersten Komparator-Eingang und einen zweiten Komparator-Eingang und einen ersten Komparator-Ausgang umfasst, und der erste Komparator-Eingang eingerichtet ist, um daran ein von dem ersten Schaltersteuersignal abgeleitetes erstes Modulationssignal anzulegen, und der zweite Komparator-Eingang eingerichtet ist, um daran ein erstes Trägersignal eines ersten Trägersignalgenerators anzulegen, und mittels des ersten Komparators ein Vergleich des ersten Modulationssignals mit dem ersten Trägersignal ausführbar ist, wobei im Zuge des Vergleichs an dem ersten Komparator-Ausgang eine pulsweitenmodulierte erste Gate-Source-Spannung erzeugbar ist und wobei vorgesehen ist, dass die erste Gate-Source-Spannung an den ersten Steuerungs-Anschluss angelegt wird, und mittels der ersten Gate-Source-Spannung der erste Simulationsstrom beeinflussbar ist.

Es sei angemerkt, dass im Rahmen der Erfindung unter einer peripheren Schaltungsanordnung prinzipiell eine beliebige - an ein Regelungsgerät anschließbare - elektrische Last zu verstehen ist, beispielsweise ein Elektromotor oder ein anderer elektromechanischer Aktor.

Einer der Vorteile der Erfindung, nämlich eine verbesserte, das heißt eine realitätsnähere, Simulation, werden regelmäßig in Anwendungsfällen deutlich, bei denen die zu simulierende periphere Schaltungsanordnung nicht "nur" ein Ohmscher Widerstand ist, denn die erfindungsgemäße Simulationsvorrichtung dient vorwiegend dem Zweck nichtlineare Strom- bzw. Spannungsverläufe mit wechselnden Stromrichtungen bereitzustellen, um damit beispielsweise einen Strom von einem Regelungsgerät zu einer "echten" - aber während der Simulation nicht an dem Regelungsgerät angeschlossenen - Motorwicklung oder einer anderen komplexen peripheren Schaltungsanordnung zu simulieren. Je realitätsnaher die Simulation des elektrischen Verhaltens der peripheren Schaltungsanordnung ist desto aussagekräftiger sind die Testergebnisse, die in einer Interaktion der Simulationsvorrichtung mit dem angeschlossenen und einem Test unterworfenen Regelungsgerät entstehen. Am Beispiel des ersten Simulationsstromes dargestellt bedeutet dies, je mehr der erste Simulationsstrom übereinstimmt mit einem Strom der im späteren "echten" Betriebsmodus von dem Regelungsgerät zur "echten" peripheren Schaltungsanordnung - also beispielsweise zur "echten" Motorwicklung - fließt, desto besser lassen sich Regler-Eigenschaften des Regelungsgerätes testen und folglich im Anschluss an den Test oder zwischen mehreren Tests optimieren.

Der Modellcode ist im Rahmen der Erfindung ein auf der Recheneinheit ausführbares Computerprogramm, wobei prinzipiell unbeachtlich ist, ob der Modellcode im Zuge einer Ausführung zunächst übersetzt wird, beispielsweise mittels eines Interpreters oder ob der Modellcode bereits in einem Format vorliegt, das ohne weitere Übersetzung von der Recheneinheit ausführbar ist. Die Recheneinheit umfasst bevorzugt einen Recheneinheit-Mikroprozessor oder einen Recheneinheit-Mikrocontroller oder einen bspw. auf einem FPGA integrierten IP-Core. Eine der Aufgaben der Recheneinheit, die der Simulationsvorrichtung zugeordnet ist, besteht darin, mittels des ausführbaren Modellcodes das erste Schaltersteuersignal zu erzeugen, worauf im nachfolgenden Text noch weiter eingegangen wird.

Der erste Lastanschluss des Regelungsgeräts ist eine elektrische Schnittstelle, die von dem Regelungsgerät gebildet ist. Einer elektrischen Last wird, wenn diese an dem ersten Lastanschluss angeschlossen ist, via erstem Lastanschluss ein Strom zugeführt, wobei dieser Strom entweder in Richtung des Regelungsgeräts oder in Richtung der an dem Regelungsgerät angeschlossenen Last fließt, je nachdem welches zeitlich veränderliche elektrische Potentialgefälle sich zwischen dem ersten Lastanschluss und dem ersten Stellmittelausgang der Simulationsvorrichtung ausgebildet hat. Der erste Simulationsstrom ist derjenige elektrische Strom, der entweder von dem ersten Lastanschluss des Regelungsgerätes zu dem ersten Stellmittelausgang der Simulationsvorrichtung oder von dem ersten Stellmittelausgang der Simulationsvorrichtung zu dem ersten Lastanschluss des Regelungsgerätes fließt.

Die elektrische Last, vorliegend auch als periphere Schaltungsanordnung bezeichnet, wird für Testzwecke durch eine simulierte periphere Schaltungsanordnung, nämlich die Simulationsvorrichtung ersetzt.

Das erste Stellmittel umfasst einen ersten Mehrstufen-Konverter, der zumindest einen ersten, einen zweiten, einen dritten, einen vierten Halbleiterschalter zur Beeinflussung des ersten Simulationsstromes aufweist. Es ist bevorzugt, dass während einer ablaufenden Simulation jeder der letztgenannten vier Halbleiterschalter via Steuerungs-Anschluss des jeweiligen Halbleiterschalters mit einem korrespondierenden und von dem ersten Halbleiterschaltersteuerungsmittel ausgehenden Signal beaufschlagt ist, worauf im nachfolgenden Text noch detaillierter eingegangen wird. Der erste Mehrstufen-Konverter weist einen ersten Konverter-Ausgang auf, über den zumindest ein Anteil des ersten Simulationsstromes fließt.

Der erste Stellmittelausgang gemäß der vorliegenden Lehre ist eine Schnittstelle der Simulationsvorrichtung, wobei diese Schnittstelle eine via erstem Induktivitätsbauteil hergestellte Verbindung zu dem ersten Konverter-Ausgang des ersten Mehrstufen-Konverters darstellt. An dem ersten Stellmittelausgang liegt die erste Ausgangsspannung des ersten Stellmittels an, die von dem auf der Recheneinheit ausgeführten Modellcode beeinflusst wird. Wenn eine Verbindung von dem ersten Stellmittelausgang zu dem ersten Lastanschluss des Regelungsgerätes hergestellt ist, fließt über diese Verbindung ein vom Modellcode beeinflusster Simulationsstrom in einer von dem Modellcode beeinflussten Richtung.

Die zumindest vier Halbleiterschalter des ersten Stellmittels, werden jeweils mittels eines korrespondierenden ersten modifizierten Schaltersteuersignals des ersten Halbleiterschaltersteuerungsmittels in einen leitenden oder einen gesperrten Zustand versetzt, wobei für jeden der vier Halbleiterschalter des ersten Stellmittels ein speziell ausgestalteter Zeitverlauf der leitenden und gesperrten Zustände herbeigeführt wird. Mit anderen Worten ausgedrückt, sind die Zeitverläufe der Schaltzustände der vier Halbleiterschalter des ersten Stellmittels unterschiedlich.

Der gemäß der Erfindung vorgesehene erste Mehrstufen-Konverter, der Bestandteil des ersten Stellmittels ist, weist Halbleiterschalter auf, wobei die Halbleiterschalter vorzugsweise

- als Feldeffekttransistoren, häufig abgekürzt als "FETs", beispielsweise sogenannte Leistungs-Feldeffekttransistoren, oder
- als sogenannte Siliciumcarbid-JFET-Bauelemente, abgekürzt SiC-JFETs oder
- als Bipolartransistoren oder
- als sogenannte IGBT-Bauelemente, d.h. Bipolartransitoren mit isolierter Gate-Elektrode (IGBT ist abgeleitet aus dem engl. Begriff "insulated-gate bipolar transistor) ausgestaltet sind.

Der erste Mehrstufen-Konverter ist vorzugsweise eingerichtet, um an dessen ersten Konverter-Ausgang eine Ausgangsspannung bereitzustellen,

- deren Maximalwert kleiner oder gleich dem Wert eines dritten Versorgungspotentials ist, und
- deren Minimalwert größer oder gleich dem Wert eines ersten Versorgungspotentials ist, und die Ausgangsspannung außerdem einen Wert annehmen kann, der einem zweiten Versorgungspotential entspricht, wobei folgende Größenbeziehungen gelten:

das dritte Versorgungspotential ist größer als das zweite Versorgungspotential und das zweite Versorgungspotential ist größer als das erste Versorgungspotential. Das erste Versorgungspotential, das zweite Versorgungspotential und das dritte Versorgungspotential versorgen das erste Stellmittel und damit den ersten Mehrstufen-Konverter.

Da der erste Mehrstufen-Konverter des ersten Stellmittels zumindest vier Halbleiterschalter umfasst, ist vorgesehen, dass mittels einer zeitlich abgestimmter Steuerung der vier Halbleiterschalter des ersten Stellmittels an dem ersten Konverter-Ausgang ein Potential einstellbar ist, welches zwischen dem dritten Versorgungspotential und dem ersten Versorgungspotential liegt.

Zum Zwecke der Bereitstellung einer erforderlichen Spannung am ersten Konverter-Ausgang sind während einer laufenden Simulation der peripheren Schaltungsanordnung die Steuerungsanschlüsse des ersten Stellmittels mit zumindest einem ersten modifizierten Schaltersteuersignal zu beaufschlagen, das auf der Berechnung mittels des Modellcodes beruht.

Während einer laufenden Simulation der peripheren Schaltungsanordnung sind bevorzugt an vier Steuerungsanschlüssen des ersten Stellmittels das erste modifizierte Schaltersteuersignal elektrisch angelegt. Das erste modifizierte Schaltersteuersignal umfasst bevorzugt vier Gate-Source-Spannungen, die bevorzugt unterschiedliche Spannungswerte aufweisen. Anders ausgedrückt ist es bevorzugt, dass jeweils eine Gate-Source-Spannung der vier Gate-Source-Spannungen an jeweils einen der bevorzugt vier Steuerungsanschlüsse des ersten Stellmittels elektrisch angelegt ist.

In einer bevorzugten Ausführungsform der Simulationsvorrichtung ist vorgesehen, dass parallel zu der zyklischen Ausführung des Modellcodes weitere vordefinierte und aus dem Regelungsgerät stammende Daten, von dem Regelungsgerät für die Recheneinheit der Simulationsvorrichtung bereitgestellt werden, und diese Daten vorgesehen sind, um bei der zyklischen Ausführung des Modellcodes berücksichtigt zu werden. Mit anderen Worten ausgedrückt, ist die letztgenannten Ausführungsform der Simulationsvorrichtung eingerichtet, um Daten des Regelungsgerätes als Eingangsvariablen bei den Berechnungen des Modellcodes zu verwenden. Eine geeignete Schnittstelle des Regelungsgerätes zur Bereitstellung der aus dem Regelungsgerät stammenden Daten zwecks Weiterleitung an die Recheneinheit der Simulationsvorrichtung ist auf der Regelungsgerät-Seite eine sogenannte Debug-Schnittstelle, beispielsweise eine standardisierte JTAG- oder Nexus-Schnittstelle.

Eine andere bevorzugte Weiterbildung der erfindungsgemäßen Simulationsvorrichtung weist neben dem ersten Stellmittel ein zweites Stellmittel und ein drittes Stellmittel auf.

In der letztgenannten Weiterbildung der Erfindung ist vorgesehen, dass das zweite Stellmittel als ein zweiter Mehrstufen-Konverter ausgestaltet ist und/oder das dritte Stellmittel als ein dritter Mehrstufen-Konverter ausgestaltet ist. Die Wortverbindung "weitere Mehrstufen-Konverter" im nachfolgenden Text fasst begrifflich zumindest den zweiten Mehrstufen-Konverter und den dritten Mehrstufen-Konverter zusammen, wobei damit jedoch nicht ausgedrückt werden soll, dass eine Simulationsvorrichtung, die zwei oder vier oder mehr als vier Mehrstufen-Konverter aufweist, keine sinnvolle Weiterbildung der Erfindung sein kann.

Die weiteren Mehrstufen-Konverter sind bevorzugt mit dem ersten Versorgungspotential, mit dem zweiten Versorgungspotential und mit dem dritten Versorgungspotential verbunden.

Des Weiteren ist es bevorzugt, dass die weiteren Mehrstufen-Konverter, beispielsweise der zweite Mehrstufen-Konverter des zweiten Stellmittels und der dritte Mehrstufen-Konverter des dritten Stellmittels einen im Wesentlichen gleichen oder identischen Hardware-Aufbau im Vergleich zu dem ersten Mehrstufen-Konverter des ersten Stellmittels aufweisen.

Im Rahmen der vorliegenden Lehre wird vorgeschlagen, bevorzugt den ersten Mehrstufen-Konverter und/oder die weiteren Mehrstufen-Konverter jeweils als Drei-Stufen-Konverter zu realisieren. Ein Drei-Stufen-Konverter zeichnet sich dadurch aus, dass im laufenden Betrieb an dem Drei-Stufen-Konverter drei unterschiedliche Eingangspotentiale bzw. Eingangsspannungen anliegen, wobei mittels einer entsprechenden Ansteuerung der Halbleiterschalter des Drei-Stufen-Konverters ein Ausgangspotential einstellbar ist, das prinzipiell - wenn man von Leitungs- und Übertragungsverlusten absieht - von der kleinsten Eingangsspannung über die mittlere Eingangsspannung bis zur größten Eingangsspannung des jeweiligen Drei-Stufen-Konverters reicht. Auf den Drei-Stufen-Konverter, der eine bevorzugte Ausführungsform des Mehrstufen-Konverters darstellt, wird im Rahmen der Figurenbeschreibung nachfolgend erneut eingegangen.

Prinzipiell ist es nicht nur möglich, den ersten und/oder die weiteren Mehrstufen-Konverter als Drei-Stufen-Konverter, also mit drei unterschiedlichen Versorgungspotentialen, auszugestalten, sondern alternativ ist vorsehbar, dass der oder die Mehrstufen-Konverter als Vier-Stufen-Konverter oder als N-Stufen-Konverter, also mit vier oder N unterschiedlichen Versorgungspotentialen, beispielsweise mit N=4, N=5 oder N=6 oder N>6 ausgestaltet sind.

Das gemäß einer Weiterbildung der Simulationsvorrichtung vorgesehene Induktivitätsbauteil ist bevorzugt als elektrische Spule ausgestaltet. Optional ist vorsehbar, dass die elektrische Spule mit einem Ferritkern oder Eisenkern ausgestattet ist. Des Weiteren ist ein Mittel zur Veränderung des Induktivitätswertes des Induktivitätsbauteiles vorsehbar, indem das Mittel beispielsweise eine Verschiebung eines mit der Spule wechselwirkenden Ferrit- oder Eisen-Kernes bewirkt.

Es sei angemerkt, dass ein induktiver Widerstand des Induktivitätsbauteils während eines Umschaltvorganges eines der vier Halbleitereschalter des ersten Mehrstufen-Konverters beispielsweise eine - nicht vernachlässigbare - den ersten Simulationsstrom begrenzende Wirkung aufweisen kann, wobei vorzugsweise der Modellcode und/oder eine regelungstechnische Einrichtung der Simulationsvorrichtung ausgestaltet ist, um die begrenzende Wirkung zu berücksichtigen und/oder zu kompensieren. Anhand der nachfolgenden Figuren und der Figurenbeschreibung wird weiter verdeutlicht, dass während einer laufenden Simulation, eine Begrenzung oder Vergrößerung des Simulationsstromes nicht zwangsläufig mittels der Simulationsvorrichtung allein verursacht ist. Die Simulationsvorrichtung ist deshalb vorzugsweise eingerichtet, um insbesondere ein Potentialgefälle zwischen einem Potential am ersten Konverter-Ausgang und einem weiteren Potential an dem ersten Stellmittelausgang zu berücksichtigen, was in einer Weiterbildung der Erfindung mittels einer Verarbeitung der Information über die erste Ausgangsspannung des ersten Stellmittels während der zyklischen Abarbeitung des Modellcodes durch die Recheneinheit realisiert ist.

Gemäß der vorliegenden Erfindung umfasst die Simulationsvorrichtung unter anderem eine Recheneinheit zur Ausführung eines Modellcodes. Als Recheneinheit ist prinzipiell ein beliebiger Computer verwendbar, soweit sichergestellt ist, dass der Computer zumindest eine für den jeweiligen Anwendungsfall angepasste Mindest-Rechenleistung und eine angepasste Ausstattung, beispielsweise einen ausreichenden Arbeitsspeicher aufweist, wobei die Rechenleistung und die Ausstattung der Recheneinheit zudem ausreichen muss, um eine zyklische Ausführung des Modellcodes innerhalb einer vordefinierten Zykluszeit sicherzustellen. Bevorzugt ist die Recheneinheit echtzeitfähig, wobei es insbesondere bevorzugt ist, dass die Recheneinheit mit einem sogenannten Echtzeitbetriebssystem ausgestattet ist. Sowohl das Echtzeitbetriebssystem als auch der Modellcode sind besonders bevorzugt derart ausgestaltet, dass während der Ausführung des Modellcodes mittels der Recheneinheit alle notwendigen Kriterien der sogenannten "harten Echtzeit" (engl. Fachbegriff "hard real-time") erfüllt sind. Harte Echtzeit bedeutet in dem beschriebenen Kontext beispielsweise, dass die zyklische Ausführung des Modellcodes garantiert innerhalb eines vordefinierten Zeitinterfalls, nämlich einer vordefinierten maximalen Zykluszeit, erfolgt. In der letztgenannten Ausgestaltung der Recheneinheit, die harter Echtzeitfähigkeit aufweist, führt eine Überschreitung der vordefinierten maximalen Zykluszeit - falls die Überschreitung einmal auftreten sollte - zu einem Systemfehler der Recheneinheit, der beispielsweise einen Abbruch oder einen Neustart der Simulation zur Folge hat.

Es sei angemerkt, dass die Recheneinheit zumindest ein Mittel zur Ausgabe des ersten Schaltersteuersignals und optional zur Ausgabe eines zweiten und/oder dritten Schaltersteuersignals aufweist.

Das erste Schaltersteuersignal wird im laufenden Betrieb der Simulationsvorrichtung von der Recheneinheit zur Weitergabe an ein erstes Halbleiterschaltersteuerungsmittel bereitgestellt. Das erste Halbleiterschaltersteuerungsmittel ist vorgesehen und eingerichtet, um das erste Schaltersteuersignal in zumindest ein erstes modifiziertes Schaltersteuersignal umzuwandeln.

Im laufenden Betrieb der Simulationsvorrichtung wird das erste Schaltersteuersignal in zumindest ein erstes modifiziertes Schaltersteuersignal umgewandelt, d.h. innerhalb des ersten Halbleiterschaltersteuerungsmittels erfolgt eine Signalwandlung von dem zunächst abstrakten ersten Schaltersteuersignal in das erste modifizierte Schaltersteuersignal, das zur direkten Übertragung an die Steuerungsanschlüsse der Halbleiterschalter des ersten Stellmittels vorgesehen ist. Zwar umfasst das erste Schaltersteuersignal bereits eine Information über einen angestrebten Schaltzustand zumindest eines Halbleiterschalters des ersten Stellmittels, jedoch ist das erste Schaltersteuersignal nicht dafür vorgesehen, um direkt an einen oder mehrere Steuerungsanschlüsse der Halbleiterschalter des ersten Stellmittels angelegt zu werden, denn das erste Schaltersteuersignal wird zunächst in ein erstes modifiziertes Schaltersteuersignal, aufweisend entsprechend angepasste Signalpegel zur Steuerung der Halbleiterschalter des ersten Stellmittels, umgewandelt. Anders ausgedrückt bedeutet dies, dass die von dem ausgeführten Modellcode bereitgestellte Information über einen einzustellenden Zustand des ersten Stellmittels in dem ersten Schaltersteuersignal enthalten ist. Das erste Halbleiterschaltersteuerungsmittel ist vorgesehen und eingerichtet, um das erste Schaltersteuersignal in ein erstes modifiziertes Schaltersteuersignal umzuwandeln.

Bevorzugt ist das modifizierte Schaltersteuersignal direkt an die Steuerungs-Anschlüsse des ersten Stellmittels angelegt, um den vom Modellcode jeweils in einem Berechnungszyklus berechneten einzustellenden Schaltzustand des ersten Stellmittels zu realisieren.

Das erste modifizierte Schaltersteuersignal ist an die technischen Kenngrößen der zu steuernden Halbleiterschalter, beispielsweise an deren zulässige bzw. von einem Halbleiterschalter-Hersteller spezifizierte Gate-Source-Spannungsintervalle der Halbleiterschalter, angepasst, wobei das Beispiel der angepassten Gate-Source-Spannungsintervalle insbesondere diejenigen Halbleiterschalter betrifft, die als Feldeffekttransistoren ausgestaltet sind.

Zum Zwecke eines erleichtertem Verständnisses der vorliegenden Lehre werden im weiteren Text häufig Feldeffekttransistoren als Ausführungsformen der Halbleiterschalter des ersten Stellmittels und/oder des zweiten Stellmittels und/oder des dritten Stellmittels genannt, obwohl prinzipiell auch andere Ausführungsformen der Halbleiterschalter, beispielsweise die bereits genannten "IGBT-Bauelemente", verwendbar sind. Ein Fachmann wird, soweit er Kenntnis von der vorliegenden Erfindung hat, ohne Schwierigkeiten geeignete Halbleiterschalter - beispielsweise geeignete FETs - für das bzw. für die Stellmittel der Simulationsvorrichtung unter Berücksichtigung der elektrischen Anforderungen an die Simulationsvorrichtung auswählen.

In den folgenden Textstellen, in denen ein Feldeffekttransistor als Ausführungsbeispiel eines Halbleiterschalters des ersten Stellmittels, des zweiten Stellmittels und/oder des dritten Stellmittels erwähnt ist, wird ein den jeweiligen Feldeffekttransistor des ersten Stellmittels steuerndes Signal, das von dem ersten modifizierten Schaltersteuersignal umfasst ist, als eine "Gate-Source-Spannung" des damit gesteuerten Feldeffekttransistors bezeichnet.

Bevorzugt umfasst das erste modifizierte Schaltersteuersignal vier Gate-Source-Spannungen zur Ansteuerung von bevorzugt vier Steuerungs-Anschlüssen des ersten Stellmittels, wobei jeweils eine Gate-Source-Spannung der vier Gate-Source-Spannungen einem korrespondierenden Steuerungs-Anschluss des ersten Stellmittels zugeordnet ist. In der bevorzugten Ausführungsform des ersten Stellmittels, bei der zumindest vier Halbleiterschalter von dem ersten Stellmittel umfasst sind, es ist bevorzugt, dass jede der vier mittels des Modellcodes gesteuerten Gate-Source-Spannungen mit jeweils einem der vier Halbleiterschalter - in dem Beispiel also mit jeweils einem der vier Feldeffekttransistoren - des ersten Stellmittels verbunden ist.

Es ist bevorzugt vorgesehen, dass per Beaufschlagung der Feldeffekttransistoren, des ersten Mehrstufen-Konverters des ersten Stellmittels mit dem ersten modifizierten Schaltersteuersignal, welches vier Gate-Source-Spannungen aufweist, ein erster dynamisch veränderbarer Simulationsstrom eingestellt wird, der insbesondere von Berechnungsergebnissen des auf der Recheneinheit ausgeführten Modellcodes beeinflusst wird.

Die Erfindung und deren weitere Vorteile werden nachfolgend unter Bezugnahme auf die Figuren näher erläutert. Hierbei sind gleichartige Teile mit identischen Bezeichnungen versehen. Die dargestellten Ausführungsformen der Erfindung sind stark schematisiert, d.h. beispielsweise, dass die vorliegenden zeichnerischen Darstellungen keine Schaltpläne mit maximalem Detailierungsgrad sind. Stattdessen unterstützen die Zeichnungen gerade mittels der Schematisierung das Verständnis des Zusammenspiels zahlreicher Erfindungsmerkmale in Kombination.

Es zeigen:

Figur 1a     eine schematische Ansicht auf eine aus dem Stand der Technik bekannte Schaltungsanordnung zur Ansteuerung eines Drei-Phasen-Elektromotors 110, wobei von insgesamt drei Halbbrücken jeweils eine Halbbrücke mit jeweils einem Phasenanschluss des Elektromotors verbunden ist;

Figur 1b     eine schematische Ansicht auf eine aus dem Stand der Technik bekannte Schaltungsanordnung aufweisend einerseits drei Halbbrücken, wie sie beispielsweise in bekannten Regelungsgeräten enthalten sind, und andererseits eine Elektromotor-Simulationsvorrichtung 120;

Figur 1c     eine Schaltung zur Nachbildung - das heißt zur Simulation - einer elektrischen Last an einem Anschluss einer Testschaltung, wie bereits aus der Druckschrift WO 2010 010022 A1 bekannt;

Figur 2     eine schematische Ansicht auf eine erste Ausführungsform einer erfindungsgemäßen Simulationsvorrichtung Hx, sowie ein mit der Simulationsvorrichtung Hx elektrisch verbundenes Regelungsgerät DUT;

Figur 3     eine schematische Ansicht auf eine zweite Ausführungsform einer erfindungsgemäßen Simulationsvorrichtung Hx, sowie ein mit der Simulationsvorrichtung Hx elektrisch verbundenes Regelungsgerät DUT;

Figur 4     eine bevorzugte und schematisch dargestellte Ausführungsform eines ersten Halbleiterschaltersteuerungsmittels Tc1 sowie deren zugehörige eingehende und ausgehende Signale;

Figur 5     eine bevorzugte und schematisch dargestellte Ausführungsform eines zweiten Halbleiterschaltersteuerungsmittels Tc2 sowie deren zugehörige eingehende und ausgehende Signale;

Figur 6     eine bevorzugte und schematisch dargestellte Ausführungsform eines dritten Halbleiterschaltersteuerungsmittels Tc3 sowie deren zugehörige eingehende und ausgehende Signale;

Figur 7     exemplarisch dargestellte, schematisierte zeitliche Verläufe ausgewählter Signale, Spannungen und deren Wechselbeziehungen insbesondere zu Zeitpunkten, an denen sich ein Zustandswechsel des Regelungsgeräts DUT vollzieht.

Figur 8     exemplarisch dargestellte, schematisierte zeitliche Verläufe ausgewählter Signale, Spannungen und deren Wechselbeziehungen insbesondere zu Zeitpunkten, an denen sich ein Zustandswechsel des Regelungsgeräts DUT vollzieht, wobei sich das Diagramm 8B der Figur 8 auf Ausführungsformen der Erfindung bezieht, bei denen eine Phasenverschiebung zwischen Trägersignalen vorgesehen ist;

Figur 9     eine bevorzugte und schematisch dargestellte Ausführungsform einer Schaltungsanordnung zur magnetischen Koppelung bestimmter Wicklungsströme, wobei die Schaltungsanordnung zur magnetischen Koppelung vorzugsweise als ein Bestandteil einer Weiterbildung der erfindungsgemäßen Simulationsvorrichtung ausgestaltet ist.

Auf die Figuren 1a, 1b und 1c wurde bereits im Rahmen der Beschreibungseinleitung bei der Würdigung des Standes der Technik eingegangen. Aus diesem Grund kann auf weitere Erläuterungen zu den Figuren 1a, 1b, 1c im nachfolgenden Text verzichtet werden.

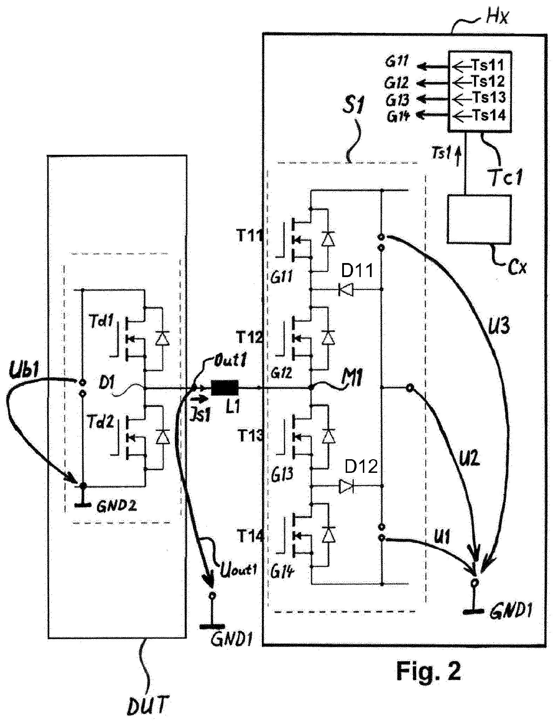

Anhand der in Figur 2 bis Figur 9 dargestellten Ausführungsformen der erfindungsgemäßen Simulationsvorrichtung Hx und deren Bestandteile werden insbesondere das erfindungsgemäße Verfahren, sowie bevorzugte verfahrensmäßige Wirkzusammenhänge der jeweils beteiligten Bestandteile der Simulationsvorrichtung Hx detailliert beschrieben.

Das erfindungsgemäße Verfahren ist zur Simulation einer an ein Regelungsgerät DUT anschließbaren peripheren Schaltungsanordnung vorgesehen. Eine Simulationsvorrichtung Hx ist mit dem Regelungsgerät DUT elektrisch verbunden oder elektrisch verbindbar, und die Simulationsvorrichtung Hx weist ein erstes Stellmittel S1 auf, mit dem ein von einem ersten Lastanschluss D1 des Regelungsgerätes DUT zu einem ersten Stellmittelausgang Out1 des ersten Stellmittels S1 weiterleitbarer erster Simulationsstrom Is1 beeinflussbar ist. Das erste Stellmittel S1 umfasst einen ersten Mehrstufen-Konverter, aufweisend zumindest einen ersten Halbleiterschalter T11 mit einem ersten Steuerungs-Anschluss G11, einen zweiten Halbleiterschalter T12 mit einem zweiten Steuerungs-Anschluss G12, einen dritten Halbleiterschalter T13 mit einem dritten Steuerungs-Anschluss G13, und einen vierten Halbleiterschalter T14 mit einem vierten Steuerungs-Anschluss G14. Die Simulationsvorrichtung Hx umfasst des Weiteren ein erstes Halbleiterschaltersteuerungsmittel Tc1 und eine Recheneinheit Cx. Die Recheneinheit Cx führt einen Modellcode aus, wobei mittels der Recheneinheit Cx und des Modellcodes ein erstes Schaltersteuersignal Ts1 zur Weitergabe an das erste Halbleiterschaltersteuerungsmittel Tc1 berechnet und bereitstellt wird. Das erste Halbleiterschaltersteuerungsmittel Tc1 weist zumindest einen ersten Komparator Co1 auf, und der erste Komparator Co1 umfasst einen ersten Komparator-Eingang E11 und einen zweiten Komparator-Eingang E12 und einen ersten Komparator-Ausgang X1. Aus dem ersten Schaltersteuersignal Ts1 wird ein erstes Modulationssignal A1 abgeleitet und an den ersten Komparator-Eingang E11 angelegt. An den zweiten Komparator-Eingang E12 wird ein erstes Trägersignal F1 eines ersten Trägersignalgenerators Cg1 angelegt, und mittels des ersten Komparators Co1 wird ein Vergleich des ersten Modulationssignals A1 mit dem ersten Trägersignal F1 ausgeführt. Im Zuge des Vergleichs an dem ersten Komparator-Ausgang X1 wird eine pulsweitenmodulierte erste Gate-Source-Spannung Ts11 erzeugt und an den ersten Steuerungs-Anschluss G11 angelegt. Mittels der ersten Gate-Source-Spannung Ts11 wird der erste Simulationsstrom Is1 beeinflusst.

In einer Weiterbildung des erfindungsgemäßen Verfahrens weist das erste Halbleiterschaltersteuerungsmittel Tc1 zumindest einen zweiten Komparator Co2 auf, und der zweite Komparator Co2 umfasst einen dritten Komparator-Eingang E21 und einen vierten Komparator-Eingang E22 und einen zweiten Komparator-Ausgang X2, und aus dem ersten Schaltersteuersignal Ts1 wird ein zweites Modulationssignal A2 abgeleitet und an den dritten Komparator-Eingang E21 angelegt, und an den vierten Komparator-Eingang E22 wird ein zweites Trägersignal F2 eines zweiten Trägersignalgenerators Cg2 angelegt, und mittels des zweiten Komparators Co2 wird ein Vergleich des zweiten Modulationssignals A2 mit dem zweiten Trägersignal F2 ausgeführt, wobei im Zuge des Vergleichs an dem zweiten Komparator-Ausgang X2 eine pulsweitenmodulierte zweite Gate-Source-Spannung Ts12 erzeugt und an den zweiten Steuerungs-Anschluss G12 angelegt wird, und mittels der zweiten Gate-Source-Spannung Ts12 der erste Simulationsstrom Is1 beeinflusst wird.

In einer weiteren Ausgestaltung des Verfahrens weist oder weisen das erste Trägersignal F1 und/oder das zweite Trägersignal F2 eine Dreiecksignalform oder eine Sägezahnsignalform auf.

Bevorzugt ist der erste Trägersignalgenerators Cg1 und/oder der zweite Trägersignalgenerator Cg2 von dem ersten Halbleiterschaltersteuerungsmittel Tc1 umfasst. Besonders bevorzugt ist der erste Trägersignalgenerator Cg1 und/oder der zweite Trägersignalgenerator Cg2 und/oder weitere Trägersignalgeneratoren Cg3 bis Cg12 als Dreiecksignalgeneratoren ausgestaltet.

Bei dem erfindungsgemäßen Verfahren und des erfindungsgemäßen Simulationsvorrichtung ist vorgesehen, dass in einem ersten DUT-Betriebszustand des Regelungsgerätes DUT ein erster Treibertransistor Td1 des Regelungsgerätes DUT durchleitend geschaltet wird, und in einer zweiten DUT-Betriebszustand des Regelungsgerätes DUT ein zweiter Treibertransistor Td2 des Regelungsgerätes DUT durchleitend geschaltet wird, wobei ein Wechsel von dem ersten DUT-Betriebszustand in den zweiten DUT-Betriebszustand und/oder ein Wechsel von dem zweiten DUT-Betriebszustand in den ersten DUT-Betriebszustand mit einem Aussenden eines ersten Invertier-Signals Ts4 einhergeht/einhergehen, und wobei das erste Invertier-Signal Ts4 das erste Trägersignal F1 und/oder das zweite Trägersignal F2 beeinflusst.

In den Ausführungsbeispielen der Erfindung kann definiert sein oder ist definiert, dass sowohl ein Wechsel von dem ersten DUT-Betriebszustand in den zweiten DUT-Betriebszustand als auch ein Wechsel von dem zweiten DUT-Betriebszustand in den ersten DUT-Betriebszustand mit einem Richtungswechsel des ersten Simulationsstromes Is1 einhergeht.

In dem erfindungsgemäßen Verfahren ist es bevorzugt, dass
das Aussenden des ersten Invertier-Signals Ts4 elektronisch ausgelöst wird mittels:

    i. einer Spannungsmessungs-Schaltung, die zur Messung einer ersten Ausgangsspannung Uout1 an dem ersten Stellmittelausgang Out1 eingerichtet ist, oder

ii. einer Strommessungs-Schaltung, die zur Messung des ersten Simulationsstromes Is1 eingerichtet ist, oder

iii. einer allgemeinen Datenschnittstelle des Regelungsgerätes DUT, oder

iv. einer Debug-Schnittstelle des Regelungsgerätes DUT.

Dabei ist es besonders bevorzugt, dass im Zuge einer Identifizierung des ersten Invertier-Signal Ts4 ausgelöst wird, dass der erste Trägersignalgenerator Cg1 das erste Trägersignals F1 bezogen auf eine Zeitachse derart ändert, dass

- in einer ersten Konstellation, bei der zu einem ersten Zeitpunkt einer Identifizierung des ersten Invertier-Signals Ts4 eine fallende Trägersignal-Flanke vorliegt, eine sofortige Umschaltung auf eine steigende Trägersignal-Flanke ausgeführt wird,
- in einer zweiten Konstellation, bei der zu einem zweiten Zeitpunkt einer Identifizierung des ersten Invertier-Signals Ts4 eine steigende Trägersignal-Flanke vorliegt, eine sofortige Umschaltung auf eine fallende Trägersignal-Flanke ausgeführt wird.

Bevorzugt wird nach dem Aussenden des ersten Invertier-Signals Ts4 selbiges der Recheneinheit Cx zugeführt, bspw. um die in dem ersten Invertier-Signal Ts4 enthaltene Information in das erste Schaltersteuersignal Ts1 und/oder in das zweite Schaltersteuersignal Ts2 und/oder in das dritte Schaltersteuersignal Ts3 einzubinden.

In einer weiteren Ausgestaltung des erfindungsgemäßen Verfahrens wird in einem Zeitfenster von mehreren Perioden des ersten Trägersignals F1 realisiert, dass das erste Modulationssignal A1 dem zweiten Modulationssignal A2 gleicht, und innerhalb des Zeitfensters einerseits das erste Trägersignal F1 und das zweite Trägersignal F2 betragsmäßig identische Spannungs-Zeit-Verläufe aufweisen und andererseits sowohl lokale Spannungs-Minima des ersten Trägersignals F1 gleichzeitig mit lokalen Spannungs-Maxima des zweiten Trägersignals F2 auftreten als auch lokale Spannungs-Maxima des ersten Trägersignals F1 gleichzeitig mit den lokalen Spannungs-Minima des zweiten Trägersignals F2 auftreten.

In einer Weiterbildung der letztgenannten Ausgestaltung des erfindungsgemäßen Verfahrens ist das Zeitfenster von mehreren Perioden des ersten Trägersignals F1 derart ausgedehnt, dass während einer Gesamtlaufzeit der Simulation realisiert wird, dass das erste Modulationssignal A1 dem zweiten Modulationssignal A2 gleicht, und während der Gesamtlaufzeit der Simulation einerseits das erste Trägersignal F1 und das zweite Trägersignal F2 betragsmäßig identische Spannungs-Zeit-Verläufe aufweisen und andererseits sowohl lokale Spannungs-Minima des ersten Trägersignals F1 gleichzeitig mit lokalen Spannungs-Maxima des zweiten Trägersignals F2 auftreten als auch lokale Spannungs-Maxima des ersten Trägersignals F1 gleichzeitig mit den lokalen Spannungs-Minima des zweiten Trägersignals F2 auftreten.

In einer anderen bevorzugten Ausgestaltung des erfindungsgemäßen Verfahrens weist die Simulationsvorrichtung Hx des Weiteren auf:

- ein zweites Stellmittel S2 umfassend einen zweiten Mehrstufen-Konverter und einen zweiten Stellmittelausgang Out2,
- ein drittes Stellmittel S3 umfassend einen dritten Mehrstufen-Konverter und einen dritten Stellmittelausgang Out3,
- ein zweites Halbleiterschaltersteuerungsmittel Tc2 umfassend zumindest einen fünften Komparator Co5, wobei der fünfte Komparator Co5 einen neunten Komparator-Eingang E51 und einen zehnten Komparator-Eingang E52 und einen fünften Komparator-Ausgang X5 umfasst, und
- ein drittes Halbleiterschaltersteuerungsmittel Tc3 umfassend zumindest einen neunten Komparator Co9, wobei der neunte Komparator Co9 einen siebzehnten Komparator-Eingang E91 und einen achtzehnten Komparator-Eingang E92 und einen neunten Komparator-Ausgang X9 aufweist,

wobei der zehnte Komparator-Eingang E52 eingerichtet ist, um daran ein fünftes Trägersignal F5 eines fünften Trägersignalgenerators Cg5 anzulegen, und

wobei der achtzehnte Komparator-Eingang E92 eingerichtet ist, um daran ein neuntes Trägersignal F9 eines neunten Trägersignalgenerators Cg9 anzulegen, und

wobei das erste Trägersignal F1, das fünfte Trägersignal F5 und das neunte Trägersignal F9 jeweils eine identische Trägersignalfrequenz aufweisen,

und eine erste zeitliche Differenz von einem Signalmaximum des ersten Trägersignals F1 zu einem zeitlich nachfolgenden Signalmaximum des fünften Trägersignals F5 gleicht einer zweiten zeitlichen Differenz von dem Signalmaximum des fünften Trägersignals F5 zu einem zeitlich nachfolgenden Signalmaximum des neunten Trägersignals F9, und wobei der erste Stellmittelausgang Out1 und der zweite Stellmittelausgang Out2 und der dritte Stellmittelausgang Out3 elektrisch miteinander verbunden sind.

In einer anderen Weiterbildung des Verfahrens wird der Modellcode in festen Zeitintervallen, also zeitlich konstanten Zeitintervallen, einer Anzahl Nx zyklisch mittels der Recheneinheit Cx ausgeführt und es wird oder werden innerhalb jedes der Nx festen Zeitintervalle jeweils

- das erste Schaltsteuersignal Ts1 zur Weiterleitung an das erste Halbleiterschaltersteuerungsmittel Tc1 und/oder
- das zweite Schaltsteuersignal Ts2 zur Weiterleitung an das zweite Halbleiterschaltersteuerungsmittel Tc2 und/oder
- das dritte Schaltsteuersignal Ts3 zur Weiterleitung an das dritte Halbleiterschaltersteuerungsmittel Tc3 berechnet.

Vorteilhaft an der zyklischen Ausführung des Modellcodes und der zyklischen Berechnung des ersten und/oder zweiten und/oder dritten Schaltersteuerungssignal/s/e ist, dass die Simulationsvorrichtung Hx bevorzugt in jedem Zyklus auf eine Strom- und/oder Spannungs-Änderung an zumindest einer Schnittstelle des Regelungsgerätes DUT reagiert.

Die Zykluszeiten, in denen das erste Schaltersteuersignal Ts1, das zweite Schaltersteuersignal Ts2 und/oder das dritte Schaltersteuersignal Ts3 mittels des Modellcodes berechnet wird/werden, betragen bevorzugt wenige Millisekunden oder liegen bevorzugt sogar im Bereich von wenigen Mikrosekunden. Ein Trend im Bereich der eingangs genannten HIL-Simulation besteht seit einigen Jahren darin, den lauffähigen Modellcode nicht mehr nur mittels Mikroprozessoren zu berechnen, sondern zeitkritische Teile des Modellcodes bzw. zeitkritische lauffähige Teilmodelle auf FPGA-Bauelemente oder ähnliche Hardware-Bauelemente mit frei programmierbarer Logik auszulagern, womit für den betreffenden auf dem FPGA ablaufenden Teil des Modellcodes beispielsweise Zykluszeiten von weniger als einer Mikrosekunde realisierbar sind, was beispielsweise für bestimmte - besonders aufwändige - Simulationsmodelle eine zyklische Abarbeitung einer Gesamtheit aller Teilmodelle des Modellcodes in sogenannter "harter Echtzeit" erst ermöglicht.

Gemäß einer anderen Ausführungsform des erfindungsgemäßen Verfahrens wird das erste Schaltersteuersignal Ts1 mittels des Modellcodes in Abhängigkeit

- eines Strommesswertes des ersten Simulationsstromes Is1 und/oder
- eines Spannungsmesswertes der ersten Ausgangsspannung Uout1 berechnet. Ein Vorteil der letztgenannten Ausführungsform ist insbesondere, dass kein Austausch digitaler Daten zwischen dem Regelungsgerät DUT und der Simulationsvorrichtung Hx erfolgen muss, um die periphere Schaltungsanordnung zu simulieren, weil der letztgenannte Strommesswert oder der letztgenannte Spannungsmesswert in dieser Ausführungsform bevorzugt eine für die Berechnungen des Modellcodes ausreichende Information über die Schaltzustände des ersten Treiber-Transistors Td1 und/oder des zweiten Treiber-Transistors Td2 umfasst.

In einer weiteren Ausführungsform des Verfahrens wird oder werden beginnend ab einem N -ten Berechnungszyklus des Modellcodes ein Strommesswert des ersten Simulationsstromes Is1 und/oder ein Spannungsmesswert der ersten Ausgangsspannung Uout1 in dem N -ten Berechnungszyklus gemessen, und in einem (N+1) -ten Berechnungszyklus fließen der Strommesswert und/oder der Spannungsmesswert in die Berechnung des ersten Schaltersteuersignals Ts1 mittels des Modellcodes ein, um eine Abweichung des Strommesswertes des ersten Simulationsstromes Is1 und/oder um eine Abweichung des Spannungsmesswertes der ersten Ausgangsspannung Uout1 von einem korrespondierenden Modellcodekonformen Idealwert zu reduzieren, wobei der (N+1) -te Berechnungszyklus der direkt dem N -ten Berechnungszyklus nachfolgende Berechnungszyklus ist.

Ein weiterer Vorteil, der sich aus der letztgenannten Ausführungsform des Verfahrens ergibt ist der, dass zwischen einer Istwert-Feststellung bezüglich des Simulationsstromes Is1 und/oder bezüglich der ersten Ausgangsspannung Uout1 einerseits und einer entsprechenden Korrekturberechnung mittels des Modellcodes bezüglich des Simulationsstromes Is1 und/oder bezüglich der ersten Ausgangsspannung Uout1 andererseits ein maximaler Zeitversatz von einer Berechnungszyklus-Dauer entsteht, was zu einer Verbesserung der Simulationsergebnisse führt.

Das in dem Ausführungsbeispiel gemäß der Figur 2 schematisch dargestellte erste Stellmittel S1 umfasst zumindest vier Halbleiterschalter, nämlich

einen ersten Halbleiterschalter T11 des ersten Stellmittels S1,

einen zweiten Halbleiterschalter T12 des ersten Stellmittels S1,

einen dritten Halbleiterschalter T13 des ersten Stellmittels S1 und einen vierten Halbleiterschalter T14 des ersten Stellmittels S1.

Die letztgenannten vier Halbleiterschalter T11, T12, T13, T14 sind derart untereinander und mit einem ersten Versorgungspotential U1 bzw. einem zweiten Versorgungspotential U2 bzw. einem dritten Versorgungspotential U3 verschaltet, dass das erste Stellmittel S1 einen ersten Mehrstufen-Konverter aufweist.

Gemäß der erfindungsgemäßen Lehre ist eine Simulationsvorrichtung Hx zur Simulation einer an ein Regelungsgerät DUT anschließbaren peripheren Schaltungsanordnung vorgesehen, wobei die Simulationsvorrichtung Hx mit dem Regelungsgerät DUT elektrisch verbunden oder elektrisch verbindbar ist, und wobei die Simulationsvorrichtung Hx ein erstes Stellmittel S1 aufweist, mit dem ein von einem ersten Lastanschluss D1 des Regelungsgerätes DUT zu einem ersten Stellmittelausgang Out1 des ersten Stellmittels S1 weiterleitbarer erster Simulationsstrom Is1 beeinflussbar ist, und wobei das erste Stellmittel S1 einen ersten Mehrstufen-Konverter, aufweisend zumindest

einen ersten Halbleiterschalter T11 mit einem ersten Steuerungs-Anschluss G11, einen zweiten Halbleiterschalter T12 mit einem zweiten Steuerungs-Anschluss G12, einen dritten Halbleiterschalter T13 mit einem dritten Steuerungs-Anschluss G13, und einen vierten Halbleiterschalter T14 mit einem vierten Steuerungs-Anschluss G14, umfasst, und wobei die Simulationsvorrichtung Hx des Weiteren ein erstes Halbleiterschaltersteuerungsmittel Tc1 und eine Recheneinheit Cx umfasst,

und die Recheneinheit Cx zur Ausführung eines Modellcodes vorgesehen und eingerichtet ist,

wobei vorgesehen ist, dass mittels der Recheneinheit Cx und des Modellcodes ein erstes Schaltersteuersignal Ts1 zur Weitergabe an das erste Halbleiterschaltersteuerungsmittel Tc1 berechnet und bereitgestellt wird, und wobei das erste Halbleiterschaltersteuerungsmittel Tc1 zumindest einen ersten Komparator Co1 aufweist, und der erste Komparator Co1 einen ersten Komparator-Eingang E11 und einen zweiten Komparator-Eingang E12 und einen ersten Komparator-Ausgang X1 umfasst, und

der erste Komparator-Eingang E11 eingerichtet ist, um daran ein von dem ersten Schaltersteuersignal Ts1 abgeleitetes erstes Modulationssignal A1 anzulegen, und der zweite Komparator-Eingang E12 eingerichtet ist, um daran ein erstes Trägersignal F1 eines ersten Trägersignalgenerators Cg1 anzulegen,

und mittels des ersten Komparators Co1 ein Vergleich des ersten Modulationssignals A1 mit dem ersten Trägersignal F1 ausführbar ist, wobei im Zuge des Vergleichs an dem ersten Komparator-Ausgang X1 eine pulsweitenmodulierte erste Gate-Source-Spannung Ts11 erzeugbar ist und wobei vorgesehen ist, dass die erste Gate-Source-Spannung Ts11 an den ersten Steuerungs-Anschluss G11 angelegt wird, und mittels der ersten Gate-Source-Spannung Ts11 der erste Simulationsstrom Is1 beeinflussbar ist.

Bevorzugte Ausführungsformen der Simulationsvorrichtung Hx sind vorgesehen und eingerichtet, um das erfindungsgemäße Verfahren oder eine der beschriebenen Weiterbildungen und Ausführungsformen des erfindungsgemäßen Verfahrens auszuführen.

Besonders bevorzugt sind die zumindest vier Halbleiterschalter des ersten Stellmittels S1 als FETs ausgestaltet. Hierbei ist es bevorzugt, dass diese vier Halbleiterschalter in nachfolgend beschriebener Weise miteinander bzw. mit dem ersten Versorgungspotential U1 oder dem zweiten Versorgungspotential U2 oder dem dritten Versorgungspotential U3 verbunden sind:

Der Drain-Anschluss des ersten Halbleiterschalters T11 ist mit dem dritten Versorgungspotential U3 verbunden; der Source-Anschluss des ersten Halbleiterschalters T11 ist mit dem Drain-Anschluss der zweiten Halbleiterschalters T12 verbunden;
der Source-Anschluss des zweiten Halbleiterschalters T12 und der Drain-Anschluss des dritten Halbleiterschalters T13 und der Konverter-seitige Anschluss des ersten Induktivitätsbauteil L1 sind miteinander verbunden;
der Source-Anschluss des dritten Halbleiterschalters T13 ist mit dem Drain-Anschluss des vierten Halbleiterschalters T14 verbunden.
der Source-Anschluss des vierten Halbleiterschalters T14 ist mit dem ersten Versorgungspotential U1 verbunden.

Die Steuerungsanschlüsse G11, G12, G13, G14 des ersten Stellmittels S1 sind mit korrespondierenden Ausgängen eines ersten Halbleiterschaltersteuerungsmittels Tc1 verbunden.

Das in dem Ausführungsbeispiel gemäß der Figur 2 schematisch dargestellte erste Stellmittel S1 umfasst des Weiteren eine erste Diode D11 und eine zweite Diode D12. Die Kathode der ersten Diode D11 ist mit dem Source-Anschluss des ersten Halbleiterschalters T11 und mit dem Drain-Anschluss des zweiten Halbleiterschalters T12 verbunden. Die Anode der ersten Diode D11 ist an das zweite Versorgungspotential U2 anschließbar oder angeschlossen. Im laufenden Betrieb der Simulationsvorrichtung Hx liegt an der Anode der ersten Diode D11 das zweite Versorgungspotential U2 an. Die Anode der zweiten Diode D12 ist mit dem Source-Anschluss des dritten Halbleiterschalters T13 und mit dem Drain-Anschluss des vierten Halbleiterschalters T14 verbunden. Die Katode der zweiten Diode D12 ist an das zweite Versorgungspotential anschließbar oder angeschlossen. Im laufenden Betrieb der Simulationsvorrichtung Hx liegt an der Katode der zweiten Diode D12 das zweite Versorgungspotential U2 an.

Gemäß der Figur 2 umfasst das erste Stellmittel S1 den ersten Halbleiterschalter T11, den zweiten Halbleiterschalter T12, den dritten Halbleiterschalter T13 und den vierten Halbleiterschalter 14, wobei bevorzugt jeder dieser vier Halbleiterschalter ein sogenannter FET, also ein Feldeffekttransistor, ist. Üblicherweise sind ein sogenannter Bulk-Anschluss und der Source-Anschluss desselben FETs elektrisch verbunden. Jeweils eine in jedem der FETs inhärent vorhandene sogenannte "Body-Diode", die auch als "Inversdiode" bezeichnet wird, ist zeichnerisch dargestellt jedoch ohne ein Bezugzeichen. Wie in Figur 2 dargestellt, ist in jedem dieser vier Halbleiterschalter T11, T12, T13, T14 jeweils eine Katode einer zugehörigen Body-Diode mit einem zugehörigen Drain-Anschluss elektrisch verbunden und jeweils eine Anode einer zugehörigen Body-Diode mit einem zugehörigen Source-Anschluss verbunden. Weil für die Erfindung die Body-Dioden nicht wesentlich sind, sollen diese nicht noch detaillierter beschrieben werden.

Das erste Versorgungspotential U1, das zweite Versorgungspotential U2 das dritte Versorgungspotential U3 und eine erste Ausgangsspannung Uout1 sind jeweils bezogen auf ein erstes Referenzpotential GND1.

Gemäß einer weiteren bevorzugten Ausführungsform ist das zweite Versorgungspotential U2 gleich dem ersten Referenzpotential GND1, wobei das dritte Versorgungspotential U3 einen positiven Spannungswert und das erste Versorgungspotential einen negativen Spannungswert aufweist.

Im Zuge einer Signalwandlung des ersten Schaltersteuersignals Ts1 mittels des ersten Halbleiterschaltersteuerungsmittels Tc1 entsteht das erste modifizierte Schaltersteuersignal Ts11, Ts12, Ts13, Ts14.

Gemäß der in Figur 2 dargestellten Ausführungsform der Simulationsvorrichtung Hx mit vier als Feldeffekttransistoren ausgestalteten Halbleiterschaltern T11, T12, T13, T14 ist es bevorzugt vorgesehen, dass das erste modifizierte Schaltersteuersignal zumindest vier Gate-Source-Spannungen aufweist, die zur Beaufschlagung von bevorzugt vier Steuerungs-Anschlüssen G11, G12, G13, G14 des ersten Stellmittels vorgesehen sind.

Jede der letztgenannten vier Gate-Source-Spannungen wird mit dem ersten Halbleiterschaltersteuerungsmittel Tc1 in Abhängigkeit von dem ersten Schaltersteuersignal Ts1 bevorzugt derart eingestellt, dass ein gewünschtes elektrisches Potential an dem ersten Konverter-Ausgang M1 entsteht. Ein durch das eingestellte elektrische Potential am ersten Konverter-Ausgang M1 erzeugtes Potentialgefälle zwischen dem ersten Lastanschluss D1 des Regelungsgerätes DUT und dem ersten Konverter-Ausgang M1 des ersten Stellmittels S1 führt zwangsläufig zu einem ersten Simulationsstrom Is1 entlang des Potentialgefälles.

Im Einzelnen gehören zu den letztgenannten vier Gate-Source-Spannungen:

- eine den ersten Halbleiterschalter T11 steuernde erste Gate-Source-Spannung Ts11 des ersten modifizierten Schaltersteuersignals;
- eine den zweiten Halbleiterschalter T12 steuernde zweite Gate-Source-Spannung Ts12 des ersten modifizierten Schaltersteuersignals;
- eine den dritten Halbleiterschalter T13 steuernde dritte Gate-Source-Spannung Ts13 des ersten modifizierten Schaltersteuersignals;
- eine den vierten Halbleiterschalter T14 steuernde vierte Gate-Source-Spannung Ts14 des ersten modifizierten Schaltersteuersignals.

Beispielsweise wird abhängig von einem Berechnungsergebnis des zyklisch abgearbeiteten Modellcodes zyklisch ein bevorzugt digital kodiertes erstes Schaltersteuersignal Ts1 erzeugt und nachfolgend daraus ein entsprechendes zyklisch veränderliches erstes modifiziertes Schaltersteuersignal generiert, welches zugehörige zyklisch veränderliche vier Gate-Source-Spannungen des ersten modifizierten Schaltersteuersignals Ts11, Ts12, Ts13, Ts14 aufweist. Mittels der vier Gate-Source-Spannungen des ersten modifizierten Schaltersteuersignals Ts11, Ts12, Ts13, Ts14 werden beispielsweise einer oder werden beispielsweise mehrere der Halbleiterschalter T11, T12, T13, T14 des ersten Stellmittels für eine via Modellcode berechnete Zeit von einem sperrenden Zustand in einen leitenden Zustand oder umgekehrt versetzt, um damit den ersten Simulationsstrom Is1 basierend auf dem Berechnungsergebnis des Modellcodes einzustellen.

Es ist bevorzugt, dass die Recheneinheit Cx einen (nicht zeichnerisch dargestellten) Eingang zum Einlesen eines Messwertes der ersten Ausgangsspannung Uout1 und/oder eines Messwertes des ersten Simulationsstromes Is1 aufweist. Falls die Recheneinheit einen entsprechenden Eingang zum Einlesen der gemessenen ersten Ausgangsspannung Uout1 oder zum Einlesen des gemessenen ersten Simulationsstromes Is1 aufweist, ist es bevorzugt vorgesehen, dass von der Recheneinheit Cx mittels des Modellcodes unter Berücksichtigung der gemessenen ersten Ausgangsspannung Uout1 oder unter Berücksichtigung des gemessenen ersten Simulationsstromes Is1 eine von der ersten Ausgangsspannung Uout1 abhängige oder eine von dem ersten Simulationsstrom Is1 abhängige Veränderung an dem ersten Schaltersteuersignal Ts1 bewirkt wird.

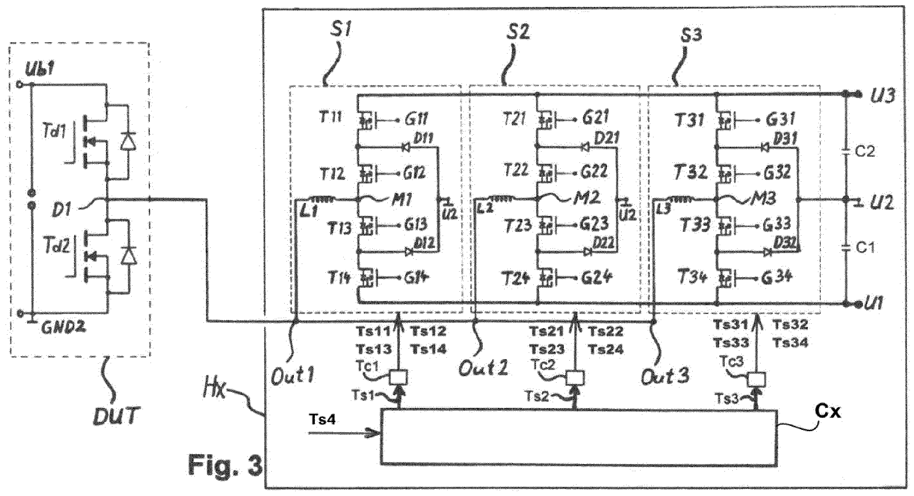

Das gemäß der Figur 3 offenbarte Ausführungsbeispiel der erfindungsgemäßen Simulationsvorrichtung Hx zeigt neben dem ersten Stellmittel S1 ein zweites Stellmittel S2 und ein drittes Stellmittel S3. Die Simulationsvorrichtung Hx aus der Figur 3 weist somit insgesamt drei Stellmittel S1, S2, S3 auf, welche hinsichtlich ihres Hardware-mäßigen Aufbaues im Wesentlichen identisch sind.

Bevorzugt sind die dargestellten Halbleiterschalter des ersten Stellmittels S1, des zweiten Stellmittels S2 und des dritten Stellmittels S3 als Feldeffekttransistoren, abgekürzt FETs, ausgestaltet.

Des Weiteren ist es bevorzugt, die in Figur 3 dargestellten drei Stellmittel S1, S2, S3 der Simulationsvorrichtung Hx mit dem ersten Versorgungspotential U1, dem zweiten Versorgungspotential U2 und dem dritten Versorgungspotential U3 zu versorgen.

Das dritte Versorgungspotential U3 ist, in dem Ausführungsbeispiel gemäß der Figur 3 verbunden mit den Drain-Anschlüssen

- des ersten Halbleiterschalters T11 des ersten Stellmittels S1,

- des ersten Halbleiterschalters T21 des zweiten Stellmittels S2,
- des ersten Halbleiterschalters T31 des dritten Stellmittels S3.

Das zweite Versorgungspotential U2 ist in dem Ausführungsbeispiel der Figur 3 via Diode/n verbunden

(A) in dem Ausführungsbeispiel der Figur 3 mit den Source-Anschlüssen

- des ersten Halbleiterschalters T11 des ersten Stellmittels S1 via Diode D11,
- des ersten Halbleiterschalters T21 des zweiten Stellmittels S2 via Diode D21,
- des ersten Halbleiterschalters T31 des dritten Stellmittels S3 via Diode D31,

wobei die Anoden der Dioden D11, D21 und D31 mit dem zweiten Versorgungspotential U2 verbunden sind,

- des dritten Halbleiterschalters T13 des ersten Stellmittels S1 via Diode D12,
- des dritten Halbleiterschalters T23 des zweiten Stellmittels S2 via Diode D22,
- des dritten Halbleiterschalters T33 des dritten Stellmittels S3 via Diode D32,

wobei die Katoden der Dioden D12, D22 und D32 mit dem zweiten Versorgungspotential U2 verbunden sind. Das zweite Versorgungspotential U2 ist in dem Ausführungsbeispiel der Figur 3 via Diode/n verbunden
(B) mit den Drain-Anschlüssen

- des zweiten Halbleiterschalters T12 des ersten Stellmittels S1 via Diode D11,
- des zweiten Halbleiterschalters T22 des zweiten Stellmittels S2 via Diode D21,
- des zweiten Halbleiterschalters T32 des dritten Stellmittels S3 via Diode D31,
- des vierten Halbleiterschalters T14 des ersten Stellmittels S1 via Diode D12,
- des vierten Halbleiterschalters T24 des zweiten Stellmittels S2 via Diode D22,
- des vierten Halbleiterschalters T34 des dritten Stellmittels S3 via Diode D32.

Das erste Versorgungspotential U1 ist verbunden mit den Source-Anschlüssen

- des vierten Halbleiterschalters T14 des ersten Stellmittels S1,
- des vierten Halbleiterschalters T24 des zweiten Stellmittels S2,
- des vierten Halbleiterschalters T34 des dritten Stellmittels S3.

Der dem ersten Stellmittel S1 zugehörige erste Konverter-Ausgang M1, der elektrisch mit einem Konverter-seitigen Anschluss eines ersten Induktivitätsbauteil L1 elektrisch verbunden ist, bildet in den Ausführungsbeispielen gemäß der Figuren 2 und 3 außerdem einen elektrischen Verbindungspunkt mit dem Source-Anschluss des zweiten Halbleiterschalters T12 des ersten Stellmittels S1 und dem Drain-Anschluss des dritten Halbleiterschalters T13 des ersten Stellmittels S1.

Ein dem zweiten Stellmittel S2 zugehöriger zweiter Konverter-Ausgang M2, der elektrisch mit einem Konverter-seitigen Anschluss eines zweiten Induktivitätsbauteil L2 elektrisch verbunden ist, bildet in dem Ausführungsbeispiel gemäß der Figur 3 einen elektrischen Verbindungspunkt mit dem Source-Anschluss des zweiten Halbleiterschalters T22 des zweiten Stellmittels S2 und dem Drain-Anschluss des dritten Halbleiterschalters T23 des zweiten Stellmittels S2.

Ein dem dritten Stellmittel S3 zugehöriger dritter Konverter-Ausgang M3, der elektrisch mit einem Konverter-seitigen Anschluss eines dritten Induktivitätsbauteil L3 elektrisch verbunden ist, bildet in dem Ausführungsbeispiel gemäß der Figur 3 einen elektrischen Verbindungspunkt mit dem Source-Anschluss des zweiten Halbleiterschalters T32 des dritten Stellmittels S3 und dem Drain-Anschluss des dritten Halbleiterschalters T33 des dritten Stellmittels S3.

Von der Recheneinheit Cx der Ausführungsform der Simulationsvorrichtung Hx gemäß der Figur 3 werden mittels des auf der Recheneinheit Cx zyklisch ausgeführten Modellcodes in jedem Zyklus der Modellcode-Ausführung das erste Schaltersteuersignal Ts1, das zweite Schaltersteuersignal Ts2 und das dritte Schaltersteuersignal Ts3 bereitgestellt.

Wie in der Ausführungsform gemäß Figur 2 wird auch in der Ausführungsform gemäß Figur 3 das erste Schaltersteuersignal Ts1 von dem ersten Halbleiterschaltersteuerungsmittel Tc1 in das erste modifizierte Schaltersteuersignal Ts11, Ts12, Ts13, Ts14 umgewandelt.

In ähnlicher Weise ist in der Figur 3 dargestellt, dass - bezüglich einer Ausprägung eines Halbleiterschalters - unspezifische Schaltersteuersignale, nämlich das erste Schaltersteuersignal Ts1, das zweite Schaltersteuersignal Ts2 und das dritte Schaltersteuersignal Ts3 umgewandelt werden in Halbleiterschalter-spezifische, also modifizierte Schaltersteuersignale, beispielsweise Gate-Source-Spannungen für FETs, die als bevorzugte Halbleiterschalter des ersten Stellmittels S1, des zweiten Stellmittels S2 und/oder des dritten Stellmittels S3 vorgeschlagen werden.

In einer Ausführungsform der Erfindung gemäß der Figur 3 sind der erste Mehrstufen-Konverter des ersten Stellmittels S1 und der zweite Mehrstufen-Konverter des zweiten Stellmittels S2 und der dritte Mehrstufen-Konverter des dritten Stellmittels S3 mittels FETs aufgebaut, und folglich sind die Steuerungsanschlüsse des ersten Stellmittels S1, des zweiten Stellmittels S2 und des dritten Stellmittels S3 als Gate-Anschlüsse der FETs ausgestaltet.

Im Rahmen der vorliegenden Figurenbeschreibung wird insbesondere anhand von in den Figuren 2 und 3 dargestellten Ausführungsformen der erfindungsgemäßen Simulationsvorrichtung Hx aufgezeigt, dass

- nach einer Umwandlung des ersten Schaltersteuersignals Ts1 per erstem Halbleiterschaltersteuerungsmittels Tc1 in das erste modifizierte Schaltersteuersignal Ts11, Ts12, Ts13, Ts14;
- bevorzugt nach einer Umwandlung eines zweiten Schaltersteuersignals Ts2 per zweitem Halbleiterschaltersteuerungsmittels Tc2 in ein zweites modifiziertes Schaltersteuersignal Ts21, Ts22, Ts23, Ts24;
- bevorzugt nach einer Umwandlung eines dritten Schaltersteuersignals Ts3 per drittem Halbleiterschaltersteuerungsmittels Tc3 in ein drittes modifiziertes Schaltersteuersignal Ts31, Ts32, Ts33, Ts34

eine Beaufschlagung des ersten Stellmittels S1 mit dem ersten modifizierten Schaltersteuersignal Ts11, Ts12, Ts13, Ts14;

bevorzugt eine Beaufschlagung des zweiten Stellmittels S2 mit dem zweiten modifizierten Schaltersteuersignal Ts21, Ts22, Ts23, Ts24; bevorzugt eine Beaufschlagung des dritten Stellmittels S3 mit dem dritten modifizierten Schaltersteuersignal Ts31, Ts32, Ts33, Ts34

erfolgt bzw. erfolgen.

Sind beispielsweise die Halbleiterschalter des ersten Stellmittels S1 als FETs ausgestaltet, wie in Figur 2 und in Figur 3 schematisch dargestellt, dann sind bevorzugt Gate-Source-Spannungen des ersten Stellmittels S1 folgendermaßen angeordnet:

Ein erster Steuerungs-Anschluss G11 wird beaufschlagt mit einer korrespondierenden ersten Gate-Source-Spannung Ts11,

ein zweiter Steuerungs-Anschluss G12 wird beaufschlagt mit einer korrespondierenden zweiten Gate-Source-Spannung Ts12,

ein dritter Steuerungs-Anschluss G13 wird beaufschlagt mit einer korrespondierenden dritten Gate-Source-Spannung Ts13,

ein vierter Steuerungs-Anschluss G14 wird beaufschlagt mit einer korrespondierenden vierten Gate-Source-Spannung Ts14,

wobei die letztgenannten vier Gate-Source-Spannungen bevorzugt von dem ersten modifizierten Schaltersteuersignal Ts11, Ts12, Ts13, Ts14 umfasst sind.

In der Ausführungsform gemäß der Figur 3 wird das zweite Schaltersteuersignal Ts2 von dem zweiten Halbleiterschaltersteuerungsmittel Tc2 in ein zweites modifiziertes Schaltersteuersignal Ts21, Ts22, Ts23, Ts24 umgewandelt, welches für jeden der vier dargestellten Halbleiterschalter T21, T22, T23, T24 des zweiten Stellmittels S2 jeweils eine Halbleiterschalter-spezifische Gate-Source-Spannung aufweist.

Sind beispielsweise die Halbleiterschalter des zweiten Stellmittels S2 als FETs ausgestaltet, wie in Figur 3 schematisch dargestellt, dann sind bevorzugt Gate-Source-Spannungen des zweiten Stellmittels S2 folgendermaßen angeordnet:

Ein fünfter Steuerungs-Anschluss G21 wird beaufschlagt mit einer korrespondierenden fünften Gate-Source-Spannung Ts21,

ein sechster Steuerungs-Anschluss G22 wird beaufschlagt mit einer korrespondierenden sechsten Gate-Source-Spannung Ts22,

ein siebenter Steuerungs-Anschluss G23 wird beaufschlagt mit einer korrespondierenden siebenten Gate-Source-Spannung Ts23,

ein achter Steuerungs-Anschluss G24 wird beaufschlagt mit einer korrespondierenden achten Gate-Source-Spannung Ts24,

wobei die letztgenannten vier Gate-Source-Spannungen bevorzugt von dem zweiten modifizierten Schaltersteuersignal Ts21, Ts22, Ts23, Ts24 umfasst sind.

In der Ausführungsform gemäß der Figur 3 wird das dritte Schaltersteuersignal Ts3 von dem dritten Halbleiterschaltersteuerungsmittel Tc3 in ein drittes modifiziertes Schaltersteuersignal Ts31, Ts32, Ts33, Ts34 umgewandelt, welches für jeden der vier dargestellten Halbleiterschalter T31, T32, T33, T34 des dritten Stellmittels S3 jeweils eine Halbleiterschalter-spezifisches Gate-Source-Spannung aufweist.

Sind beispielsweise die Halbleiterschalter des dritten Stellmittels S3 als FETs ausgestaltet, wie in Figur 3 schematisch dargestellt, dann sind bevorzugt Gate-Source-Spannungen des dritten Stellmittels S3 folgendermaßen angeordnet:

Ein neunter Steuerungs-Anschluss G31 wird beaufschlagt mit einer korrespondierenden neunte Gate-Source-Spannung Ts31,

ein zehnter Steuerungs-Anschluss G32 wird beaufschlagt mit einer korrespondierenden zehnten Gate-Source-Spannung Ts32,

ein elfter Steuerungs-Anschluss G33 wird beaufschlagt mit einer korrespondierenden elften Gate-Source-Spannung Ts33,

ein zwölfter Steuerungs-Anschluss G34 wird beaufschlagt mit einer korrespondierenden zwölften Gate-Source-Spannung Ts34,

wobei die letztgenannten vier Gate-Source-Spannungen bevorzugt von dem dritten modifizierten Schaltersteuersignal Ts31, Ts32, Ts33, Ts34 umfasst sind.

In einem bevorzugten Ausführungsbeispiel der Simulationsvorrichtung Hx gemäß der Figur 3 ist es bevorzugt, dass

- der erste Stellmittelausgang Out1, der von dem Regelungsgerät-seitigen Anschluss des ersten Induktivitätsbauteils L1 gebildet ist, und
- der zweite Stellmittelausgang Out2, der von dem Regelungsgerät-seitigen Anschluss des zweiten Induktivitätsbauteils L2 gebildet ist, und
- der dritte Stellmittelausgang Out3, der von dem Regelungsgerät-seitigen Anschluss des zweiten Induktivitätsbauteils L2 gebildet ist.

Des Weiteren ist es in dem Ausführungsbeispiel gemäß der Figur 3 bevorzugt, dass der erste Stellmittelausgang Out1 und der zweite Stellmittelausgang Out2 und der dritten Stellmittelausgang Out3 mit einem elektrischen Verbindungsleiter elektrisch miteinander verbunden sind, und der elektrischer Verbindungsleiter vorgesehen und eingerichtet ist, um mit dem ersten Lastanschluss D1 des Regelungsgerätes DUT verbunden zu werden.

Der sich aus der Schaltungsanordnung gemäß Figur 3 ergebende weitere Vorteil besteht darin, dass die via ersten Lastanschluss D1 fließenden Ströme mittels der Simulationsvorrichtung Hx besonders präzise nachgebildet werden.

In dem Ausführungsbeispiel gemäß der Figur 3 sind bevorzugt zur Glättung des ersten Versorgungspotentials U1 und des dritten Versorgungspotentials U3 ein erster Kondensator C1 und ein zweiter Kondensator C2 an die Anschlüsse der drei letztgenannten Versorgungspotentiale U1, U2, U3 angeschlossen und zwar folgendermaßen:

Eine erste Elektrode des ersten Kondensators C1 ist mit dem ersten Versorgungspotential U1 verbunden und eine zweite Elektrode des ersten Kondensators C1 ist mit dem zweiten Versorgungspotential U2 verbunden, und eine erste Elektrode des zweiten Kondensators C2 ist mit dem zweiten Versorgungspotential U2 verbunden und eine zweite Elektrode des zweiten Kondensators C2 ist mit dem dritten Versorgungspotential U3 verbunden.

In einer bevorzugten Ausführungsform der erfindungsgemäßen Simulationsvorrichtung Hx ist vorgesehen, dass der erste Mehrstufen-Konverter zumindest einen ersten, einen zweiten, einen dritten, einen vierten Halbleiterschalter T11, T12, T13, T14 aufweist, wobei der ersten, der zweite, der dritte, der vierte Halbleiterschalter T11, T12, T13, T14 jeweils zumindest einen Steuerungs-Anschluss G11, G12, G13, G14 umfasst, und wobei an dem mit dem ersten Mehrstufen-Konverter verbundenen ersten Stellmittelausgang Out1 eine erste, von dem Modellcode beeinflusste, Ausgangsspannung Uout1 bereitstellbar ist.

Vorteilhaft an der letztgenannten Ausführungsform ist, dass mittels des ersten Mehrstufen-Konverters, dessen vier Halbleiterschalter T11, T12, T13, T14 mit dem ersten modifizierten Schaltersteuersignal Ts11, Ts12, Ts13, Ts14 beaufschlagt werden, kostengünstig realisierbar sind und außerdem hochdynamisch veränderliche, von dem Modellcode berechnete Stromänderungen des ersten Simulationsstromes Is1 bereitstellbar sind.

Gemäß einer anderen Weiterbildung der erfindungsgemäßen Simulationsvorrichtung Hx weist diese des Weiteren ein zweites Stellmittel S2 und ein drittes Stellmittel S3 auf, und wobei das zweite Stellmittel S2 als ein zweiter Mehrstufen-Konverter ausgestaltet ist und/oder wobei das dritte Stellmittel S3 als ein dritter Mehrstufen-Konverter ausgestaltet ist.

Das zweite Stellmittel S2 und das dritte Stellmittel S3 stehen in der letztgenannten Weiterbildung der Simulationsvorrichtung Hx vorteilhafterweise neben dem ersten Stellmittel S1 dafür bereit, um mittels einer elektrischen Verbindung des ersten Stellmittelausgangs Out1, des zweiten Stellmittelausgangs Out2 und des dritten Stellmittelausgangs Out3 eine Addition

Ausgangsstrom des ersten Stellmittels S1 plus
Ausgangsstrom des zweiten Stellmittels S2 plus
Ausgangsstrom des dritten Stellmittels S3

zu realisieren, wobei der sich aus der Addition ergebende Summenstrom einem ersten Lastanschluss D1 des Regelungsgerätes DUT zuführbar ist, wie dies beispielsweise mittels einer bevorzugten Simulationsvorrichtung Hx gemäß der Figur 3 vorgesehen ist. Dieser Summenstrom ist in der Regel dynamischer änderbar, als ein erster Simulationsstrom Is1, der beispielsweise gemäß der Figur 2 von einem einzigen ersten Stellmittel S1, also ohne die Addition mit einem weiteren Ausgangsstrom aus einem weiteren Stellmittel, einem ersten Lastanschluss D1 zugeführt wird.

Je dynamischer ein dem ersten Lastanschluss D1 des Regelungsgeräts DUT zuführbarer Simulationsstrom Is1 mittels der Simulationsvorrichtung Hx änderbar ist, desto realitätsnaher können Ströme, die in einer späteren "echten" Verwendung des Regelungsgerätes DUT durch dessen ersten Lastanschluss D1 fließen werden, von der Simulationsvorrichtung Hx für Testzwecke nachgebildet werden.

In einer bevorzugten Ausführungsform der erfindungsgemäßen Simulationsvorrichtung Hx ist oder sind der erste Mehrstufen-Konverter und/oder der zweite Mehrstufen-Konverter und/oder der dritte Mehrstufen-Konverter als Drei-Stufen-Konverter ausgestaltet.

Überraschenderweise stellt sich eine besonders vorteilhafte Kosten-Nutzen-Relation für eine Simulationsvorrichtung Hx ein, wenn zumindest der zweite Mehrstufen-Konverter, der von dem zweiten Stellmittel S2 umfasst ist, und optional zusätzlich der dritte Mehrstufen-Konverter, der von dem dritten Stellmittel S3 umfasst ist, als Drei-Stufen-Konverter ausgestaltet sind. In die Bewertung des Nutzens fließt hierbei insbesondere die mittels der Drei-Stufen-Konverter erreichbare hohe Dynamik des zuletzt genannten Summenstroms ein.

Besonders bevorzugt ist eine Ausführungsform der Simulationsvorrichtung Hx, bei der das zweite Stellmittel S2 als ein zweiter Drei-Stufen-Konverter, aufweisend eine zweite Gruppe von zumindest vier Halbleiterschaltern T21, T22, T23, T24 und einen zweiten Stellmittelausgang Out2, ausgestaltet ist, und wobei das dritte Stellmittel S3 als ein dritter Drei-Stufen-Konverter, aufweisend eine dritte Gruppe von zumindest vier Halbleiterschaltern T31, T32, T33, T34 und einen dritten Stellmittelausgang Out3, ausgestaltet ist, und der erste Stellmittelausgang Out1 und der zweite Stellmittelausgang Out2 und der dritte Stellmittelausgang Out3 elektrisch miteinander verbunden sind.

In einer anderen Ausgestaltung der Simulationsvorrichtung Hx ist während einer zyklischen Ausführung des Modellcodes auf der Recheneinheit Cx von dem Modellcode in vordefinierten Zeitabständen vorgesehen, eine von dem Regelungsgerät DUT bereitgestellte Zustands-Botschaft, enthaltend eine Information, die eine bevorstehende oder eine vollzogene Zustandsänderung eines ersten Treiber-Transistors Td1 des Regelungsgerätes DUT oder eine bevorstehende oder eine vollzogene Zustandsänderung eines zweiten Treiber-Transistors Td2 des Regelungsgerätes DUT widerspiegelt, zur Beeinflussung zumindest des ersten Stellmittels S1 zu verarbeiten.

Diese letztgenannte Weiterbildung der Simulationsvorrichtung Hx eröffnet vorteilhafterweise eine Option, entweder frühzeitiger oder basierend auf einer vergrößerten Datenbasis zumindest ein erstes Stellmittel S1 zu beeinflussen.

In einer anderen Ausgestaltung der letztgenannten Weiterbildung der Simulationsvorrichtung Hx ist eine Erzeugung der Zustands-Botschaft jeweils zu einem Messungszeitpunkt einer Messung der ersten Ausgangsspannung Uout1 vorgesehen, und/oder die Zustands-Botschaft ist zu dem Messungszeitpunkt der zugehörigen Messung der ersten Ausgangsspannung Uout1 in einen Kausalzusammenhang mit einem Messwert der Messung der ersten Ausgangsspannung Uout1 gestellt.

Zusätzlich ist in einer weiteren Ausführungsform der Simulationsvorrichtung Hx vorsehbar, dass in einer der beiden letztgenannten Ausgestaltungen der Simulationsvorrichtung Hx die Zustands-Botschaft in vordefinierten zeitlichen Abständen von einem dem Regelungsgerät DUT zugehörigen Regelungsgerät-Mikroprozessor (zeichnerisch nicht dargestellt) mittels eines auf dem Regelungsgerät-Mikroprozessor ausführbaren Regelungs-Codes bereitstellbar ist und/oder bereitgestellt wird.

Die letztgenannte Ausführungsform ermöglicht eine besonders frühzeitige Schaltzustands-Anpassung der Simulationsvorrichtung Hx an einen veränderlichen ersten Simulationsstrom Is1, weil die Information über die Zustandsänderungen des ersten Treiber-Transistors Td1 und des zweiten Treiber-Transistors Td2 des Regelungsgerätes DUT in einem zu dem Regelungsgerät zugehörigen Regelungsgerät-Mikroprozessor üblicherweise zuerst vorliegen, denn der Regelungs-Code wird mittels des Regelungsgerät-Mikroprozessors in dem Regelungsgerät DUT ausgeführt. In Abhängigkeit insbesondere der Berechnungsergebnisse des ausgeführten Regelungs-Codes erfolgt bevorzugt die Steuerung des ersten Treiber-Transistors Td1 und des zweiten Treiber-Transistors Td2.

Bevorzugt wird die von dem Regelungsgerät DUT zu der Simulationsvorrichtung Hx übertragene Zustands-Botschaft in der Recheneinheit Cx der Simulationsvorrichtung Hx weiterverarbeitet, um auf Schaltzustände der dem ersten Stellmittel S1 zugeordneten Halbleiterschalter T11, T12, T13, T14 einen steuernden Einfluss auszuüben.

In einer weiteren Ausgestaltung der erfindungsgemäßen Simulationsvorrichtung Hx umfasst das erste Stellmittel S1 zumindest

- einen ersten Versorgungspotentialanschluss aufweisend ein erstes Versorgungspotential U1 und
- einen zweiten Versorgungspotentialanschluss aufweisend ein zweites Versorgungspotential U2 und
- einen dritten Versorgungspotentialanschluss aufweisend ein drittes Versorgungspotential U3,

wobei das dritte Versorgungspotential U3 größer ist als das zweite Versorgungspotential U2, das größer ist als das erste Versorgungspotential U1, wobei mittels einer Beaufschlagung der Steuerungs-Anschlüsse G11, G12, G13, G14 des ersten Stellmittels S1 unter Verwendung des ersten Schaltersteuersignals Ts1 die erste Ausgangsspannung Uout1 zwischen dem dritten Versorgungspotential U3 und dem ersten Versorgungspotential U1 einstellbar ist, und wobei die erste Ausgangsspannung Uout1 auf ein erstes Referenzpotential GND1 bezogen ist.

Gemäß einer zusätzlichen Ausführungsform der erfindungsgemäßen Simulationsvorrichtung Hx ist eine Zusatz-Signalverbindung (nicht zeichnerisch dargestellt) von der Recheneinheit Cx der Simulationsvorrichtung Hx zu einem von dem Regelungsgerät DUT umfassten Regelungsgerät-Mikroprozessor herstellbar oder hergestellt, um in Abhängigkeit einer via Zusatz-Signalverbindung von dem Regelungsgerät-Mikroprozessor zu der Recheneinheit Cx übertragene Information das erste und/oder das zweite und/oder das dritte Schaltersteuersignal Ts1, Ts2, Ts3 zu beeinflussen. Die Zusatz-Signalverbindung entlastet hinsichtlich einer verfügbaren Bandbreite einer optional vorgesehenen weiteren Signalverbindung, die für den Zweck eines Datenaustauschs zwischen dem Regelungsgerät DUT und der Simulationsvorrichtung Hx vorsehbar oder vorgesehen ist. Sowohl die Zusatz-Signalverbindung als auch die weitere Signalverbindung sind optional als bidirektionale Datenverbindung ausgestaltet. Als verbindende Medien können sowohl die Zusatz-Signalverbindung als auch die weitere Signalverbindung elektrische Verbindungleiter, Lichtleitkabel und/oder eine Funkverbindung bspw. WLAN aufweisen.

Soweit das erste Stellmittel S1 zumindest einen ersten Versorgungspotentialanschluss aufweisend ein erstes Versorgungspotential U1 und einen zweiten Versorgungspotentialanschluss aufweisend ein zweites Versorgungspotential U2 und einen dritten Versorgungspotentialanschluss aufweisend ein drittes Versorgungspotential U3 umfasst, ist in einer besonders bevorzugten Ausführungsform der Simulationsvorrichtung Hx vorgesehen, dass innerhalb des ersten Stellmittels S1 unter Bezugnahme auf ein erstes Referenzpotential GND1 das dritte Versorgungspotential U3 einen positiven Spannungswert aufweist, und das erste Versorgungspotential U1 einen negativen Spannungswert aufweist, und zudem folgende Größenbeziehungen gelten:

- das zweite Versorgungspotential U2 ist identisch zu dem ersten Referenzpotential GND1, also U2 = GND1 ;
- das zweite Versorgungspotential U2 weist betragsmäßig einen identischen Potentialabstand sowohl zu dem dritten Versorgungspotential U3 als auch zu dem ersten Versorgungspotential U1 auf, also

$$| \, U3 - U2 \, | = | \, U2 - U1 \, | \, ;$$

- das zweite Referenzpotential GND2 ist größer als das erste Versorgungspotential U1 und kleiner als das zweite Versorgungspotential U2, also U1 < GND2 < U2 ;
- ein viertes Versorgungspotential Ub1 ist größer als das zweite Versorgungspotential U2 und kleiner als das dritte Versorgungspotential U3, also U2 < Ub1 < U3 ;
- die Differenz, gebildet aus dem vierten Versorgungspotential Ub1 als Minuend und dem zweiten Versorgungspotential U2 als Subtrahend, ist identisch zu der Differenz, gebildet aus dem zweiten Versorgungspotential U2 als Minuend und dem zweiten Referenzpotential GND2 als Subtrahend, also

$$Ub1 - U2 = U2 - GND2 \, .$$

Die letztgenannte Ausführungsform kann vorteilhafterweise für eine besonders große Anzahl von praktisch relevanten Simulationsszenarien verwendet werden. Überraschenderweise zeigt es sich zudem, dass aufgrund der in der letztgenannten Ausführungsform und durch die in den Gleichungen

$$| \, U3 - U2 \, | = | \, U2 - U1 \, | \quad und \quad | \, Ub1 - U2 \, | = | \, U2 - GND2 \, |$$

beschriebene Symmetrie ein weniger komplex aufgebauter Modellcode erforderlich ist, um die periphere Schaltungsanordnung mittels der Simulationsvorrichtung Hx zu simulieren, als es ohne die mit der letztgenannten Gleichung beschriebene Symmetrie der Fall wäre.

Zur Bereitstellung des vierten Versorgungspotentials Ub1 kann beispielsweise ein elektro-chemischer Energiespeicher, bevorzugt ein Akkumulator, vorgesehen sein.

Vorteilhaft an dem erfindungsgemäßen Verfahren ist insbesondere, dass der erste Mehrstufen-Konverter des ersten Stellmittels S1 mittels des ersten Halbleiterschaltersteuerungsmittels Tc1 mit besonders kurzer Verzögerung den ersten Simulationsstrom Is1 beeinflusst, sobald eine entsprechende Anforderung zur Änderung des ersten Simulationsstromes Is1 mittels des Modellcodes auf der Recheneinheit Cx berechnet wurde, und daraufhin ein entsprechendes erstes Schaltersteuersignal Ts1 von der Recheneinheit Cx an das erste Halbleiterschaltersteuerungsmittel Tc1 ausgegeben ist.

Eine angestrebte Änderung des ersten Simulationsstromes Is1 mit einer möglichst geringen Verzögerung mittels der Simulationsvorrichtung Hx zu realisieren ist deshalb vorteilhaft, weil damit das Verhalten von zahlreichen peripheren Schaltungsanordnungen, die beispielsweise induktive Lasten umfassen können, in ausreichend präziser Weise nachbildbar sind. Vorteilhaft ist außerdem, dass das erfindungsgemäße Verfahren mittels einer vergleichsweise kostengünstig realisierbaren Simulationsvorrichtung Hx und einem vergleichsweise unkompliziert gestalteten - und damit kostengünstigen - Modellcode ausführbar ist.

In einer bevorzugten Weiterbildung der erfindungsgemäßen Simulationsvorrichtung Hx ist die Simulationsvorrichtung Hx vorgesehen und eingerichtet, um das erfindungsgemäße Verfahren zur Simulation einer an ein Regelungsgerät DUT anschließbaren peripheren Schaltungsanordnung auszuführen oder um eine der beschriebenen Weiterbildungen bzw. eine der beschriebenen Ausgestaltungen des erfindungsgemäßen Verfahrens auszuführen.

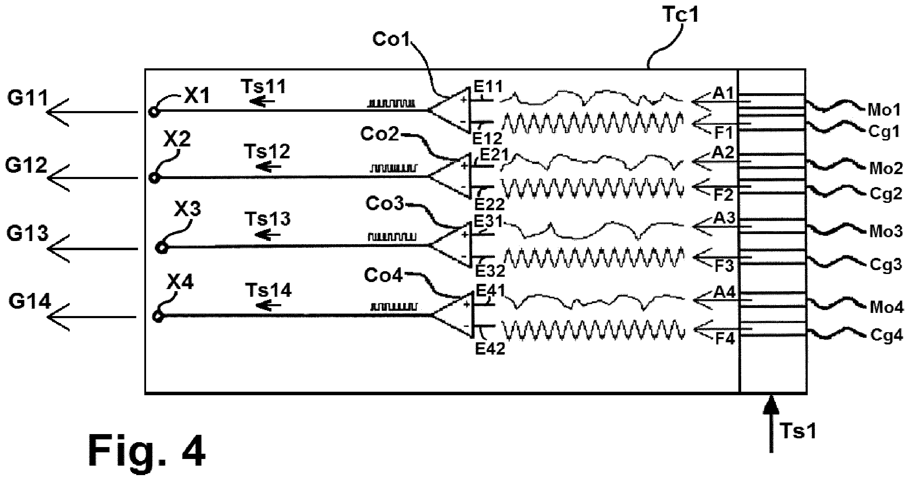

Die Figur 4 zeigt in schematischer Darstellung eine bevorzugte Ausführungsform eines ersten Halbleiterschaltersteuerungsmittels Tc1 sowie deren zugehörige eingehende und ausgehende Signale. Das von der Recheneinheit Cx ausgehende und als Eingangssignal für das erste Halbleiterschaltersteuerungsmittel Tc1 dienende erste Schaltersteuersignal Ts1 wird bevorzugt innerhalb des ersten Halbleiterschaltersteuerungsmittels Tc1 in Modulationssignale umgewandelt, und bevorzugt werden:

- von einem ersten Modulationssignal-Ausgang Mo1 ein erstes Modulationssignal A1 an einen ersten Komparator-Eingang E11 eines ersten Komparators Co1 übertragen;
- von einem zweiten Modulationssignal-Ausgang Mo2 ein zweites Modulationssignal A2 an einen dritten Komparator-Eingang E21 eines zweiten Komparators Co2 übertragen;
- von einem dritten Modulationssignal-Ausgang Mo3 ein drittes Modulationssignal A3 an einen fünften Komparator-Eingang E31 eines dritten Komparators Co3 übertragen;
- von einem vierten Modulationssignal-Ausgang Mo4 ein viertes Modulationssignal A4 an einen siebenten Komparator-Eingang E41 eines vierten Komparator Co4 übertragen.

Bevorzugt sind das erste Modulationssignal A1, das zweite Modulationssignal A2, das dritte Modulationssignal A3 und das vierte Modulationssignal A4 als analoge Signale ausgestaltet.

In einer Weiterbildung der Erfindung

- wird an einen zweiten Komparator-Eingang E12 des ersten Komparators Co1 ein erstes Trägersignal F1 angelegt, das von einem ersten Trägersignalgenerator Cg1 bereitgestellt wird;
- wird an einen vierten Komparator-Eingang E22 des zweiten Komparators Co2 ein zweites Trägersignal F2 angelegt, das von einem zweiten Trägersignalgenerator Cg2 bereitgestellt wird;
- wird an einen sechsten Komparator-Eingang E32 des dritten Komparators Co3 ein drittes Trägersignal F3 angelegt, das von einem dritten Trägersignalgenerator Cg3 bereitgestellt wird;
- wird an einen achten Komparator-Eingang E42 des vierten Komparators Co4 ein viertes Trägersignal F4 angelegt, das von einem vierten Trägersignalgenerator Cg4 bereitgestellt wird.

Zudem umfasst die Weiterbildung der Erfindung bevorzugt

- einen zu dem ersten Komparator Co1 gehörigen ersten Komparator-Ausgang X1, der zur Ausgabe der ersten Gate-Source-Spannung Ts11 eingerichtet ist;
- einen zu dem zweiten Komparator Co2 gehörigen zweiten Komparator-Ausgang X2, der zur Ausgabe der zweiten Gate-Source-Spannung Ts12 eingerichtet ist;
- einen zu dem dritten Komparator Co3 gehörigen dritten Komparator-Ausgang X3, der zur Ausgabe der dritten Gate-Source-Spannung Ts13 eingerichtet ist;
- einen zu dem vierten Komparator Co2 gehörigen vierten Komparator-Ausgang X4, der zur Ausgabe der vierten Gate-Source-Spannung Ts14 eingerichtet ist.

In einer weiteren bevorzugten Ausführungsform der Erfindung sind während der gesamten Ausführungszeit des erfindungsgemäßen Verfahrens oder zumindest während der Dauer einer Mehrzahl von Perioden des ersten Trägersignals F1 einerseits das erste Trägersignal F1 und das dritte Trägersignal F3 deckungsgleich und andererseits das zweite Trägersignal F2 und das vierte Trägersignal F4 deckungsgleich.

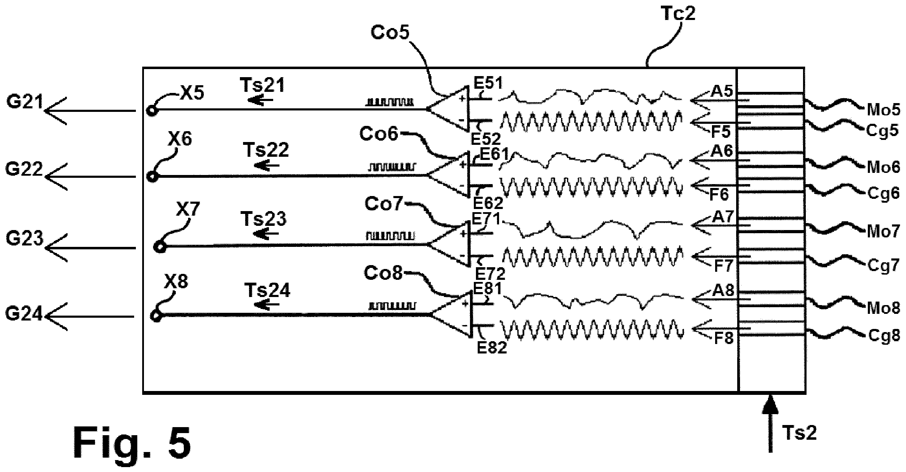

Die Figur 5 zeigt in schematischer Darstellung eine bevorzugte Ausführungsform eines zweiten Halbleiterschaltersteuerungsmittels Tc2 sowie deren zugehörige eingehende und ausgehende Signale.

Das von der Recheneinheit Cx ausgehende und als Eingangssignal für das zweite Halbleiterschaltersteuerungsmittel Tc2 dienende zweite Schaltersteuersignal Ts2 wird bevorzugt innerhalb des zweiten Halbleiterschaltersteuerungsmittels Tc2 in Modulationssignale umgewandelt, und bevorzugt werden:

- von einem fünften Modulationssignal-Ausgang Mo5 ein fünftes Modulationssignal A5 an einen neunten Komparator-Eingang E51 eines fünften Komparators Co5 übertragen;
- von einem sechsten Modulationssignal-Ausgang Mo6 ein sechstes Modulationssignal A6 an einen elften Komparator-Eingang E61 eines sechsten Komparators Co6 übertragen;
- von einem siebten Modulationssignal-Ausgang Mo7 ein siebtes Modulationssignal A7 an einen dreizehnten Komparator-Eingang E71 eines siebten Komparators Co7 übertragen;
- von einem achten Modulationssignal-Ausgang Mo8 ein achtes Modulationssignal A8 an einen fünfzehnten Komparator-Eingang E81 eines achten Komparators Co8 übertragen.

Bevorzugt sind das fünfte Modulationssignal A5, das sechste Modulationssignal A6, das siebte Modulationssignal A7 und das achte Modulationssignal A8 als analoge Signale ausgestaltet.

In einer Weiterbildung der Erfindung

- wird an einen zehnten Komparator-Eingang E52 des fünften Komparators Co5 ein fünftes Trägersignal F5 angelegt, das von einem fünften Trägersignalgenerator Cg5 bereitgestellt wird;
- wird an einen zwölften Komparator-Eingang E62 des sechsten Komparators Co6 ein sechstes Trägersignal F6 angelegt, das von einem sechsten Trägersignalgenerator Cg6 bereitgestellt wird;
- wird an einen vierzehnten Komparator-Eingang E72 des siebten Komparators Co7 ein siebtes Trägersignal F7 angelegt, das von einem siebten Trägersignalgenerator Cg7 bereitgestellt wird;
- wird an einen sechzehnten Komparator-Eingang E82 des achten Komparators Co8 ein achtes Trägersignal F8 angelegt, das von einem achten Trägersignalgenerator Cg8 bereitgestellt wird.

Zudem umfasst die Weiterbildung der Erfindung bevorzugt

- einen zu dem fünften Komparator Co5 gehörigen fünften Komparator-Ausgang X5, der zur Ausgabe der fünften Gate-Source-Spannung Ts21 eingerichtet ist;
- einen zu dem sechsten Komparator Co6 gehörigen sechsten Komparator-Ausgang X6, der zur Ausgabe der sechsten Gate-Source-Spannung Ts22 eingerichtet ist;
- einen zu dem siebten Komparator Co7 gehörigen siebten Komparator-Ausgang X7, der zur Ausgabe der siebten Gate-Source-Spannung Ts23 eingerichtet ist;
- einen zu dem achten Komparator Co8 gehörigen achten Komparator-Ausgang X8, der zur Ausgabe der achten Gate-Source-Spannung Ts24 eingerichtet ist.

In einer weiteren bevorzugten Ausführungsform der Erfindung sind während der gesamten Ausführungszeit des erfindungsgemäßen Verfahrens oder zumindest während der Dauer einer Mehrzahl von Perioden des fünften Trägersignals F5 einerseits das fünfte Trägersignal F5 und das siebte Trägersignal F7 deckungsgleich und andererseits das sechste Trägersignal F6 und das achte Trägersignal F8 deckungsgleich.

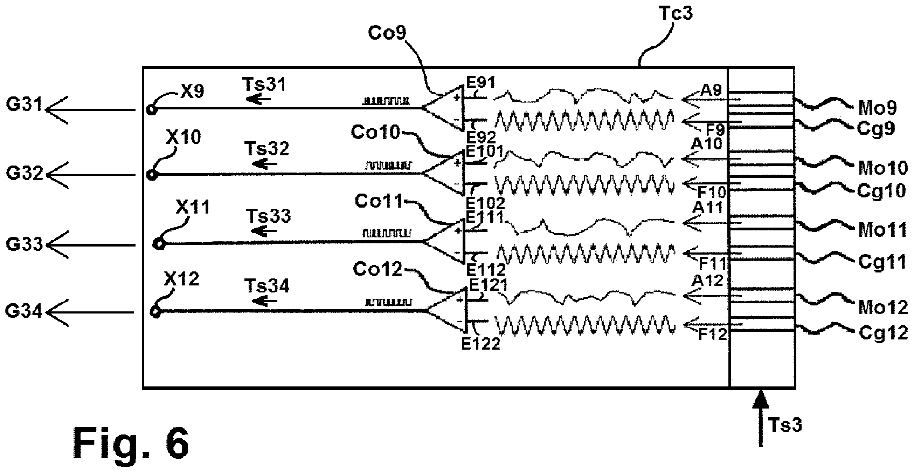

Die Figur 6 zeigt in schematischer Darstellung eine bevorzugte Ausführungsform eines dritten Halbleiterschaltersteuerungsmittels Tc3 sowie deren zugehörige eingehende und ausgehende Signale. Das von der Recheneinheit Cx ausgehende und als Eingangssignal für das dritte Halbleiterschaltersteuerungsmittel Tc3 dienende dritte Schaltersteuersignal Ts3 wird bevorzugt innerhalb des dritten Halbleiterschaltersteuerungsmittels Tc3 in Modulationssignale umgewandelt, und bevorzugt werden:

- von einem neunten Modulationssignal-Ausgang Mo9 ein neuntes Modulationssignal A9 an einen siebzehnten Komparator-Eingang E91 eines neunten Komparators Co9 übertragen;
- von einem zehnten Modulationssignal-Ausgang Mo10 ein zehntes Modulationssignal A10 an einen neunzehnten Komparator-Eingang E101 eines zehnten Komparators Co10 übertragen;
- von einem elften Modulationssignal-Ausgang Mo11 ein elftes Modulationssignal A11 an einen einundzwanzigsten Komparator-Eingang E111 eines elften Komparators Co11 übertragen;
- von einem zwölften Modulationssignal-Ausgang Mo12 ein zwölftes Modulationssignal A12 an einen dreiundzwanzigsten Komparator-Eingang E121 eines zwölften Komparators Co12 übertragen.

Bevorzugt sind das neunte Modulationssignal A9, das zehnte Modulationssignal A10, das elfte Modulationssignal A11 und das zwölfte Modulationssignal A12 als analoge Signale ausgestaltet.

In einer Weiterbildung der Erfindung

- wird an einen achtzehnten Komparator-Eingang E92 des neunten Komparators Co9 ein neuntes Trägersignal F9 angelegt, das von einem neunten Trägersignalgenerator Cg9 bereitgestellt wird;
- wird an einen zwanzigster Komparator-Eingang E102 des zehnten Komparators Co10 ein zehntes Trägersignal F10 angelegt, das von einem zehnten Trägersignalgenerator Cg10 bereitgestellt wird;
- wird an einen zweiundzwanzigster Komparator-Eingang E112 des elften Komparators Co11 ein elftes Trägersignal F11 angelegt, das von einem elften Trägersignalgenerator Cg11 bereitgestellt wird;
- wird an einen vierundzwanzigsten Komparator-Eingang E122 des zwölften Komparators Co12 ein zwölftes Trägersignal F12 angelegt, das von einem zwölften Trägersignalgenerator Cg12 bereitgestellt wird.

Zudem umfasst die Weiterbildung der Erfindung bevorzugt

- einen zu dem neunten Komparator Co9 gehörigen neunter Komparator-Ausgang X9, der zur Ausgabe der neunten Gate-Source-Spannung Ts31 eingerichtet ist;
- einen zu dem zehnten Komparator Co10 gehörigen zehnter Komparator-Ausgang X10, der zur Ausgabe der zehnten Gate-Source-Spannung Ts32 eingerichtet ist;
- einen zu dem elften Komparator Co11 gehörigen elfter Komparator-Ausgang X11, der zur Ausgabe der elften Gate-Source-Spannung Ts33 eingerichtet ist;
- einen zu dem zwölften Komparator Co12 gehörigen zwölfter Komparator-Ausgang X12, der zur Ausgabe der zwölften Gate-Source-Spannung Ts34 eingerichtet ist.

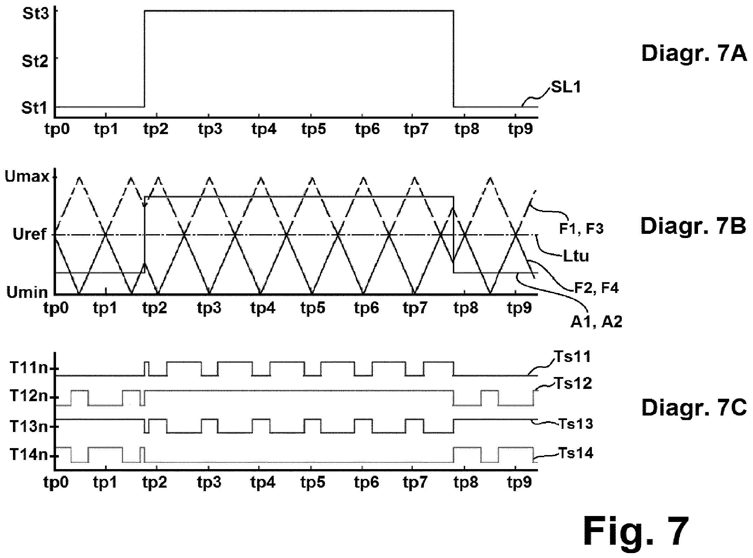

In einer weiteren bevorzugten Ausführungsform der Erfindung sind während der gesamten Ausführungzeit des erfindungsgemäßen Verfahrens oder zumindest während der Dauer einer Mehrzahl von Perioden des neunten Trägersignals F9 einerseits das neunte Trägersignal F9 und das elfte Trägersignal F11 deckungsgleich und andererseits das zehnte Trägersignal F10 und das zwölfte Trägersignal F12 deckungsgleich.
Die Wechselwirkungen zwischen Trägersignalen und Modulationssignalen lassen sich anhand der in Figur 7 dargestellten drei schematischen Diagrammen 7A bis 7C, die exemplarische zeitliche Signalverläufe zeigen, sehr anschaulich erläutern. Die Darstellung der Zeitfunktionen in den Diagrammen 7A, 7B und 7C zeigen identische Abszissenachsen mit äquidistanten Zeitschritten beginnend mit dem Zeitpunkt tp0 und endend bei dem Zeitpunkt tp9.

In dem Diagramm 7A der Figur 7 sind anhand eines Beispiels zwei Zustandswechsel eines Regelungsgerätes DUT dargestellt, nämlich anhand einer Zustandskurve SL1. Zwischen dem Zeitpunkt tp1 und dem Zeitpunkt tp2 vollzieht das Regelungsgerät DUT einen ersten Zustandswechsel von einem ersten Zustand St1 in einen dritten Zustand St3. Nachfolgend zwischen dem Zeitpunkt tp7 und dem Zeitpunkt tp8 vollzieht das Regelungsgerät DUT einen zweiten Zustandswechsel, nämlich von dem dritten Zustand St3 in den ersten Zustand St1.
Ein Zustandswechsel des Regelungsgerätes DUT liegt zum Beispiel zu Zeitpunkten vor, bei denen von dem Regelungsgerät DUT ein Stromrichtungswechsel des ersten Simulationsstromes Is1 hervorgerufen wird. Da in dem letztgenannten Beispiel der erste Zustand St1 eine erste Stromrichtung des ersten Simulationsstromes Is1 anzeigt und der dritte Zustand St3 eine der ersten Stromrichtung entgegengesetzte Stromrichtung des ersten Simulationsstromes Is1 anzeigt, stellt das Diagramm 7A insbesondere dar, dass seitens des Regelungsgerätes DUT zwischen dem Zeitpunkt tp1 und dem Zeitpunkt tp2 ein erster Stromrichtungswechsel des ersten Simulationsstromes Is1 veranlasst wird, und des Weiteren zwischen dem Zeitpunkt tp7 und dem Zeitpunkt tp8 ein zweiter Stromrichtungswechsel des ersten Simulationsstromes Is1 veranlasst wird. Ein zweiter Zustand St2 des Regelungsgerätes DUT, der beispielsweise eine Unterbrechung des ersten Simulationsstroms Is1 widerspiegeln kann, wird in dem Diagramms 7A kurzzeitig im Zuge eines Zustandswechsels von St1 nach St3 bzw. von St3 nach St1 durchlaufen. Der als Rechteckkurve dargestellte Verlauf der beiden Zustandswechsel stellt dabei eine idealisierte Näherung dar, d.h. bei entsprechender hoher Auflösung der Zeitachse ist in der Praxis die Zustandskurve SL1 keine Rechteckkurve, sondern steigende und fallende Flanken der Zustandskurve SL1 weisen eine endliche positive oder negative Steigung auf.

In dem Diagramm 7B der Figur 7 ist eine Zeitachse, die identisch zu der Zeitachse aus Diagramm 7A ist, als eine Abszissenachse dargestellt. Bezug nehmend auf das Diagramm 7A wird in Diagramm 7B dargestellt, dass die bereits beschriebenen Zustandswechsel des Regelungsgerätes DUT zu Änderungen des ersten Modulationssignals A1 und des zweiten Modulationssignals A2 führen.

Das Diagramm 7B der Figur 7 zeigt insbesondere bevorzugte Ausgestaltungen des ersten Trägersignals F1 und des zweiten Trägersignals F2, nämlich sogenannte Dreieckssignale. Das mit gestrichelter Dreiecksignallinie dargestellte erste Trägersignal F1 und das mit durchgezogener Dreieckssignallinie dargestellte zweite Trägersignal F2 sind vorzugsweise an einer Zeitachse Ltu gespiegelt. Die Zeitachse Ltu in dem Diagramm 7B ist als Abszissenachse mit einer Punkt-Strich-Linie gezeichnet.

Die Zeitachse Ltu, schneidet im Diagramm 7B die Ordinatenachse bei einer Bezugsspannung Uref. Auf der Ordinatenachse des Diagramms 7B sind einerseits eine Maximalspannung Umax, die größer als die Bezugsspannung Uref ist, und andererseits eine Minimalspannung Umin, die kleiner als die Bezugsspannung Uref ist, eingezeichnet. Somit gilt: Umax > Uref > Umin .

Wird, wie in dem in 7B dargestellten Ausführungsbeispiel, der Bezugsspannung Uref ein Spannungswert von N Volt zugewiesen, dann stellt die Zeitachse Ltu eine Spannungsgrenze auf einem N-Volt-Spannungsniveau dar. Falls, wie bevorzugt, N = Null ist, dann trennt die Zeitachse Ltu einen negativen Spannungsbereich und einen positiven Spannungsbereich voneinander, d.h. in einem Beispiel mit der Bezugsspannung Uref = 0 Volt gilt, dass das erste Trägersignal F1 dem positiven Spannungsbereich und das zweite Trägersignal F2 dem negativen Spannungsbereich zugeordnet sind.

Bevorzugt ist, dass die zeitabhängigen ersten Augenblicks-Spannungsswerte des ersten Trägersignals F1 zwischen der Bezugsspannung Uref und der Maximalspannung Umax schwingen, wobei gilt: Uref ≤ erste Augenblicks-Spannungswerte ≤ Umax.

Des Weiteren ist bevorzugt, dass die zeitabhängigen zweiten Augenblicks-Spannungswerte des zweiten Trägersignals F2 zwischen der Bezugsspannung Uref und der Minimalspannung Umin schwingen, wobei gilt: Umin ≤ zweite Augenblicks-Spannungswerte ≤ Uref.

Weil in einer bevorzugten Ausgestaltung der Erfindung das erste Modulationssignal A1 dem zweiten Modulationssignals A2 gleicht, sind die entsprechenden Kurven A1, A2 in dem Diagramm 7B der Figur 7 einander überdeckend dargestellt.

Zum Zwecke einer weiteren Vereinfachung der Darstellung sind in dem Ausführungsbeispiel gemäß der Skizze in dem Diagramm 7B sowohl das erste Modulationssignal A1 als auch das zweite Modulationssignal A2 als eine Rechteckkurve ausgestaltet, womit folgende Signalwechselwirkungen des Ausführungsbeispiels leicht beschrieben werden können.

Es wurde bereits beschrieben, dass das erste Modulationssignal A1 an den ersten Komparator-Eingang E11 angelegt wird, und an den zweiten Komparator-Eingang E12 das erste Trägersignal F1 angelegt wird, und mittels des ersten Komparators Co1 ein Vergleich des ersten Modulationssignals A1 mit dem ersten Trägersignal F1 ausgeführt wird, wobei im Zuge des Vergleichs an dem ersten Komparator-Ausgang X1 eine pulsweitenmodulierte erste Gate-Source-Spannung Ts11 erzeugt und an den ersten Steuerungs-Anschluss G11 angelegt wird.

Gemäß des dargestellten Ausführungsbeispiels wird - ähnlich wie oben beschrieben - das zweite Modulationssignal A2 an den zweiten Komparator-Eingang E21 angelegt, und an den vierten Komparator-Eingang E22 wird das zweite Trägersignal F2 angelegt, und mittels des zweiten Komparators Co2 wird ein Vergleich des zweiten Modulationssignals A2 mit dem zweiten Trägersignal F2 ausgeführt, wobei im Zuge des Vergleichs an dem zweiten Komparator-Ausgang X2 eine pulsweitenmodulierte zweite Gate-Source-Spannung Ts12 erzeugt und an den zweiten Steuerungs-Anschluss G12 angelegt wird.

Bevorzugt werden ggf. vorgesehene weiteren Komparatoren, insbesondere der dritte Komparator Co3 und der vierte Komparator Co4 in vergleichbarer Weise wie der erste Komparator Co1 und der zweite Komparator Co2 betrieben. Prinzipiell ist es vorsehbar, dass jedem der genannten Komparatoren an den entsprechenden Eingängen ein jeweils angepasstes Modulationssignal und ein jeweils angepasstes Trägersignal zugeordnet wird, wobei optional vorsehbar ist, dass jedes Modulationssignal und jedes Trägersignal jeweils einen unterschiedlichen und mittels des Modellcodes definierbaren bzw. definierten Signalverlauf aufweist.

Jedoch ist es gemäß einer bevorzugten Ausführungsform der Erfindung vorgesehen, dass vordefinierte Eingänge verschiedener Komparatoren des ersten Halbleiterschaltersteuerungsmittels Tc1 mit identischen Modulationssignalen und/oder mit identischen Trägersignalen beaufschlagt werden.

So ist in einer weiteren Ausgestaltung der Erfindung vorgesehen, dass zur Beaufschlagung des ersten Halbleiterschaltersteuerungsmittels Tc1 einerseits das erste Modulationssignal A1, das zweite Modulationssignal A2, das dritte Modulationssignal A3 und das vierte Modulationssignal A4 identisch sind, und andererseits das erste Trägersignal F1 mit dem dritten Trägersignal F3 übereinstimmt sowie das zweite Trägersignal F2 mit dem vierten Trägersignal F4 übereinstimmt. Mathematisch ausgedrückt gelten bevorzugt innerhalb eines Zeitraums von mehreren Perioden des ersten Trägersignals F1 für die letztgenannte Ausgestaltung der Erfindung folgende Gleichungen:

$$A1 = A2 = A3 = A4$$

$$F1 = F3$$

$$F2 = F4$$

In der letztgenannten - und in der Figur 7 illustrierten - Ausgestaltung der Erfindung bildet bevorzugt die auf dem Potential der Bezugsspannung Uref verlaufende Zeitachse Ltu eine Spiegelungsachse, siehe hierzu Diagramm 7B. Dabei schwingen zwischen der Zeitachse Ltu und der Maximalspannung Umax das erste Trägersignal F1 und das dritte Trägersignal F3, wobei F1 = F3 gilt, und es schwingen zwischen der Zeitachse Ltu und der Minimalspannung Umin das zweite Trägersignal F2 und das vierte Trägersignal F4, wobei F2 = F4 gilt.
Eine Spiegelung des ersten Trägersignal F1 und des dritten Trägersignals F3 an der durch die Zeitachse Ltu gebildeten Spiegelungsachse ergibt somit unterhalb der dargestellten Zeitachse Ltu ein Spiegelbild der beiden letztgenannten Trägersignale F1, F3, nämlich in Gestalt des zweiten Trägersignals F2 und des vierten Trägersignals F4.

In dem gemäß Diagramm 7B dargestellten Ausführungsbeispiel wird im Wesentlichen zeitgleich zu dem im Diagramm 7A dargestellten ersten Stromrichtungswechsel, also zeitgleich zu einem ersten Zustands-Übergang von dem ersten Zustand St1 zu dem dritten Zustand St3 des Regelungsgerätes DUT, ein erster antizyklischer Steigungs-Vorzeichen-Wechsel sowohl des ersten Trägersignals F1 als auch des zweiten Trägersignals F2 vollzogen. Die Bezeichnung "antizyklischer Steigungs-Vorzeichen-Wechsel" wird nachfolgend bezogen auf die Figur 7 erklärt.
Ohne einen Zustandswechsel des Regelungsgerätes DUT (bspw. ohne eine steigende/fallende Flanke der Zustandskurve SL1 im Diagramm 7A) liegt ein periodisch wiederkehrender "Normalzyklus" des ersten Trägersignals F1 vor, wobei das erste Trägersignal F1 zyklisch zwischen der Maximalspannung Umax und der Bezugsspannung Uref schwingt und die Steigung des ersten Trägersignals F1 beim Erreichen der Maximalspannung Umax und beim Erreichen der Bezugsspannung Uref jeweils einen Vorzeichenwechsel vollzieht.

Zum Zeitpunkt eines Zustandswechsels des Regelungsgerätes DUT, also - wie in Figur 7 dargestellt - zum Zeitpunkt einer steigenden und einer fallenden Flanke der Zustandskurve SL1, wird in dem Ausführungsbeispiel des Diagramms 7B der "Normalzyklus" des ersten Trägersignals F1 derart unterbrochen, dass im Wesentlichen zeitgleich zu dem jeweiligen Zustandswechsel (steigende/fallende Flanke der Zustandskurve SL1) ein Vorzeichen-Wechsel der Steigung des ersten Trägersignals F1 vorgenommen wird, wobei bevorzugt der Vorzeichen-Wechsel mittels des ersten Trägersignalgenerators Cg1 vollzogen wird, wobei dafür besonders bevorzugt dem ersten Trägersignalgenerator Cg1, beispielsweise mittels der Recheneinheit Cx, ein entsprechendes Trigger-Signal zum Auslösen des Vorzeichenwechsels der Steigung des ersten Trägersignals F1 zugeführt wird.

In ähnlicher Weise wird in dem dargestellten Ausführungsbeispiel das zweite Trägersignal F2 beeinflusst: Zum Zeitpunkt eines Zustandswechsels des Regelungsgerätes DUT, also - wie in Figur 7 dargestellt - zum Zeitpunkt einer steigenden und einer fallenden Flanke der Zustandskurve SL1, wird in dem Ausführungsbeispiel des Diagramms 7B der "Normalzyklus" des zweiten Trägersignals F2 derart unterbrochen, dass im Wesentlichen zeitgleich zu dem jeweiligen Zustandswechsel (steigende/fallende Flanke der Zustandskurve SL1) ein Vorzeichen-Wechsel der Steigung des zweiten Trägersignals F2 vorgenommen wird, wobei bevorzugt der Vorzeichen-Wechsel mittels des zweiten Trägersignalgenerators Cg2 vollzogen wird, wobei dafür besonders bevorzugt dem zweiten Trägersignalgenerator Cg2, beispielsweise mittels der Recheneinheit Cx, ein entsprechendes Trigger-Signal zum Auslösen des Vorzeichenwechsels der Steigung des zweiten Trägersignals F2 zugeführt wird.

Bevorzugt wird mit dem dritten Trägersignal F3 ähnlich oder identisch zu der letztgenannten Beeinflussung des ersten Trägersignals F1 verfahren und es wird mit dem vierten Trägersignal F4 ähnlich oder identisch zu der letztgenannten Beeinflussung des zweiten Trägersignals F2 verfahren.

Einer der Vorteile der, von einem Zustandswechsel des Regelungsgerätes DUT - beispielsweise von einem Stromrichtungswechsel des ersten Simulationsstromes Is1 - auslösbaren bzw. ausgelösten (und in den vorangestellten zwei Absätzen beschriebenen)

- Vorzeichen-Wechsels der Steigung des ersten Trägersignals F1 und
- Vorzeichen-Wechsels der Steigung des zweiten Trägersignals F2 und vorzugsweise
- Vorzeichen-Wechsels der Steigung des dritten Trägersignals F3 und
- Vorzeichen-Wechsels der Steigung des vierten Trägersignals F4

ist darin zu sehen, dass sich der entsprechende Betrag des ersten Simulationsstromes Is1 zeitnah nach dem Zustandswechsel nicht sprunghafter als im "Normalzyklus" ändert (der Normalzyklus liegt in den Trägersignalzyklen vor, in denen kein Zustandswechsel des Regelungsgerätes DUT vorkommt), das heißt, dass vorteilhafterweise transiente Ausgleichsvorgänge bei der Steuerung des ersten Simulationsstromes Is1 vermieden oder zumindest verringert werden im Vergleich zu einer Verwendung von Trägersignalen, die ohne die oben beschriebenen Vorzeichen-Wechsel ausgestaltet sind.

Es sei angemerkt, dass ausgehend von dem in Diagramm 7B dargestellten Ausführungsbeispiel der Erfindung, bei dem das erste Modulationssignal A1 und das zweite Modulationssignal A2 einerseits deckungsgleich und andererseits als Rechtecksignale ausgestaltet sind, nicht geschlossen werden darf, dass die für die Erfindung verwendbaren Modulationssignale stets als einander überdeckende Rechtecksignale auszugestalten sind. Stattdessen ist es in weiteren Ausführungsbeispielen vorgesehen, ein oder mehrere oder alle Modulationssignal/e mittels des Modellcodes individuell anzupassen und somit entsprechend angepasste analoge oder digitale Modulationssignale für die Komparatoren der/des Halbleiterschaltersteuerungsmittel/s Tc1, Tc2, Tc3 bereitzustellen.

Aufbauend auf die vorliegende Beschreibung zu den Diagrammen 7A und 7B werden nachfolgend anhand des Diagramms 7C weitere Ausführungsformen der Erfindung beschrieben.
In einer Ausführungsform der Erfindung werden Ergebnisse der Vergleiche

- des ersten Modulationssignals A1 mit dem ersten Trägersignal F1 via erstem Komparator Co1,
- des zweiten Modulationssignals A2 mit dem zweiten Trägersignal F2 via zweitem Komparator Co2,
- des dritten Modulationssignals A3 mit dem dritten Trägersignal F3 via drittem Komparator Co3, und
- des vierten Modulationssignals A4 mit dem vierten Trägersignal F4 via viertem Komparator Co4

zur Bereitstellung der ersten Gate-Source-Spannung Ts11, der zweiten Gate-Source-Spannung Ts12, der dritten Gate-Source-Spannung Ts13 und der vierten Gate-Source-Spannung Ts14 verwendet.

Jeder der genannten Gate-Source-Spannungen Ts11, Ts12, Ts13, Ts14 ist ein vordefinierter Wertebereich zugeordnet, der bevorzugt von einer Ausgestaltung einer jeweiligen (nicht zeichnerisch dargestellten) Komparator-Spannungsversorgung beeinflusst wird.
Die erste Gate-Source-Spannung Ts11 liegt je nach Ansteuerung des ersten Komparators Co1 entweder über oder unter einer, der ersten Gate-Source-Spannung zugeordneten, vordefinierten ersten Mittelpunktspannung T11n.
Die zweite Gate-Source-Spannung Ts12 liegt je nach Ansteuerung des zweiten Komparators Co2 entweder über oder unter einer der ersten Gate-Source-Spannung zugeordneten vordefinierten zweiten Mittelpunktspannung T12n.
Die dritte Gate-Source-Spannung Ts13 liegt je nach Ansteuerung des dritten Komparators Co3 entweder über oder unter einer der dritten Gate-Source-Spannung zugeordneten vordefinierten dritten Mittelpunktspannung T13n.
Die vierte Gate-Source-Spannung Ts14 liegt je nach Ansteuerung des vierten Komparators Co4 entweder über oder unter einer der ersten Gate-Source-Spannung zugeordneten vordefinierten vierten Mittelpunktspannung T14n.
Die Ordinatenachse des Diagramms 7C ist nicht derart zu verstehen, dass die erste, zweite, dritte, vierte Mittelpunktspannung T11n, T12n, T13n, T14n jeweils unterschiedliche Beträge aufweisen. Prinzipiell sind aber Ausführungsbeispiele realisierbar, bei denen die genannten vier Mittelpunktspannungen T11n, T12n, T13n, T14n voneinander abweichen. In einer bevorzugten Weiterbildung der Erfindung ist vorgesehen, dass die vier Mittelpunktspannungen T11n, T12n, T13n, T14n identisch sind, und damit in der letztgenannten Weiterbildung gilt: T11n = T12n = T13n = T14n.

In einer Zusammenschau der Figuren 2, 3, 4 und 7 wird noch deutlicher, wie zu jedem Zeitpunkt zwischen tp0 bis tp9, die zeitlich veränderlichen Gate-Spannungen Ts11, Ts12, Ts13, Ts14 an die jeweils zugeordneten Halbleiterschalten T11, T12, T13, T14 zwecks Betrags- oder Richtungs-Änderung des ersten Simulationsstromes Is1 angelegt werden.
Hierbei ist in Abhängigkeit von der Ausgestaltung der Halbleiterschalten T11, T12, T13, T14, also beispielsweise, ob einerseits diese sogenannte Verarmungs-Feldeffekttransistoren (z.B. Depletion-MOSFETs) oder sogenannte Anreicherungs-Feldeffekttransistoren (z.B. Enhancement-MOSFETs) sind, oder ob andererseits die Halbleiterschalter sogenannte p-Kanal-Feldeffekttransistoren oder n-Kanal-Feldeffekttransistoren sind, vorbestimmt, ob ein über der jeweiligen Mittelpunktspannung T11n, T12n, T13n, T14n liegender Pegel der jeweils zugeordneten Gate-Spannung Ts11, Ts12, Ts13, Ts14 einen entsprechenden Halbleiterschalter T11, T12, T13, T14 entweder öffnet oder schließt.

Bevorzugt ist es vorgesehen, dass der erste, zweite, dritte und vierte Halbleiterschalter T11, T12, T13, T13 des ersten Stellmittels S1 derart gleichartig ausgestaltet sind, dass letztgenannte vier Halbleiterschalter also entweder einheitlich typenmäßig identische Verarmungs-Feldeffekttransistoren oder einheitlich typenmäßig identische Anreicherungs-Feldeffekttransistoren sind.
In vergleichbarer Weise ist es bevorzugt vorgesehen, dass der erste, zweite, dritte und vierte Halbleiterschalter T11, T12, T13, T13 des ersten Stellmittels S1 derart gleichartig ausgestaltet sind, dass letztgenannte vier Halbleiterschalter also entweder einheitlich typenmäßig identische p-Kanal-Feldeffekttransistoren oder einheitlich typenmäßig identische n-Kanal-Feldeffekttransistoren sind.
Besonders bevorzugt sind auch das zweite Stellmittel S2 und das dritte Stellmittel S3 jeweils mit typenmäßig identischen Halbleiterschaltern, wie sie bevorzugt bei dem ersten Stellmittel S1 verwendet sind, aufgebaut.

Gemäß einer weiteren bevorzugten Ausführungsform der erfindungsgemäßen Simulationsvorrichtung Hx ist es vorgesehen, dass die Simulationsvorrichtung Hx zur Beeinflussung des ersten Simulationsstromes Is1 neben dem ersten Stellmittel S1, ein zweites Stellmittel S2 und ein drittes Stellmittel S3 aufweist, wobei

- das erste Stellmittel S1 eingerichtet ist, um von dem ersten Halbleiterschaltersteuerungsmittel Tc1 gesteuert zu werden,
- ein zweites Stellmittel S2 eingerichtet ist, um von einem zweiten Halbleiterschaltersteuerungsmittel Tc2 gesteuert zu werden,

- ein drittes Stellmittel S3 eingerichtet ist, um von einem dritten Halbleiterschaltersteuerungsmittel Tc3 gesteuert zu werden, und wobei
- das erste Halbleiterschaltersteuerungsmittel Tc1 zumindest einen ersten Trägersignalgenerator Cg1 zur Bereitstellung eines mittenzentrierten periodischen ersten Trägersignals F1 umfasst, und
- das zweite Halbleiterschaltersteuerungsmittel Tc2 zumindest einen fünften Trägersignalgenerator Cg5 zur Bereitstellung eines mittenzentrierten periodischen fünften Trägersignals F5 umfasst, und
- das dritte Halbleiterschaltersteuerungsmittel Tc3 zumindest einen neunten Trägersignalgenerator Cg9 zur Bereitstellung eines mittenzentrierten periodischen neunten Trägersignals F9 umfasst, und

wobei das erste Trägersignal F1, das fünfte Trägersignal F5 und das neunte Trägersignal F9 in einem Zeitfenster von mehreren Perioden des ersten Trägersignals F1 einerseits jeweils als Dreieckssignale mit identischer Periodendauer ausgestaltet, und andererseits in dem Zeitfenster gegeneinander phasenverschoben sind.

Überraschenderweise haben Messungen gezeigt, dass sich die beschriebene Phasenverschiebung des ersten Trägersignals F1, des fünften Trägersignals F5 und des neunten Trägersignals F9 in dem genannten Zeitfenster positiv in Hinsicht auf die beabsichtigte Verringerung bzw. Vermeidung ungewollter transienter Ausgleichsströme an dem ersten Stellmittelausgang Out1 und/oder an dem zweiten Stellmittelausgang Out2 und/oder an dem dritten Stellmittelausgang Out3 auswirken, was letztlich zu einer realitätsnäheren Simulation beispielsweise des ersten Simulationsstromes Is1 beiträgt.

In einer Weiterbildung der letztgenannten Ausführungsform der erfindungsgemäßen Simulationsvorrichtung Hx ist in dem zuletzt genannten Zeitfenster einerseits der Betrag der Phasenverschiebung zwischen dem ersten Trägersignal F1 und dem fünften Trägersignal F5 ein Drittel der Periodendauer des ersten Trägersignals F1, und andererseits ist der Betrag der Phasenverschiebung zwischen dem fünften Trägersignal F5 und dem neunten Trägersignal F9 ein Drittel der Periodendauer des ersten Trägersignals F1. Besonders bevorzugt ist in der letztgenannten Weiterbildung vorgesehen, das hinsichtlich der Phasenverschiebung nach dem ersten Trägersignal F1 zunächst das fünfte Trägersignal F5 folgt und danach das neunte Trägersignal F9 folgt, und dass die Periodendauer des ersten Trägersignals F1 gleich der Periodendauer des fünften Trägersignal F5 und gleich der Periodendauer des neunten Trägersignals F9 ist, also gilt für die jeweilige Periodendauer $T_{Fn}$ mit n = Nr. des jeweiligen Trägersignals: $T_{F1} = T_{F5} = T_{F9}$

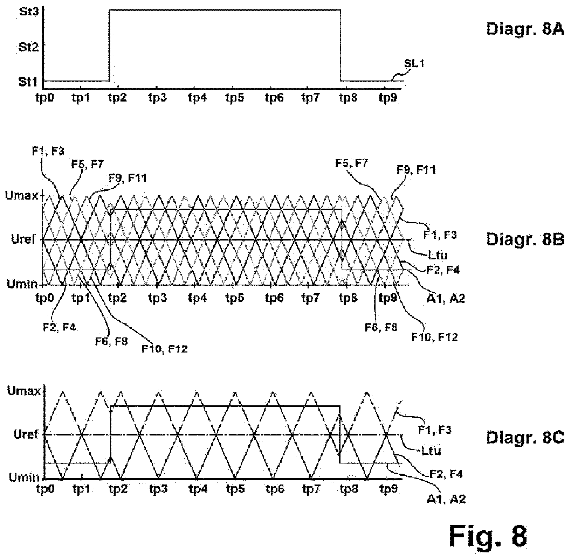

Eine Beeinflussung von Trägersignalen F1, F2 bis F12 zum Zeitpunkt eines Zustandswechsels des Regelungsgerätes DUT lässt sich anhand der in Figur 8 dargestellten drei schematischen Diagrammen 8A bis 8C, die exemplarische zeitliche Signalverläufe zeigen, anschaulich erläutern. Die Darstellung der Zeitfunktionen in den Diagrammen 8A, 8B und 8C zeigen identische Abszissenachsen mit äquidistanten Zeitschritten beginnend mit dem Zeitpunkt tp0 und endend bei dem Zeitpunkt tp9. Das Diagramm 8A der Figur 8 ist inhaltlich identisch zu dem Diagramm 7A der Figur 7, jedoch erneut in der Figur 8 angeordnet, um eine zeitliche Relation des in Diagramm 8A dargestellten Zustandswechsels und einer entsprechenden Beeinflussung der in Diagramm 8B dargestellten Trägersignale besser zu verdeutlichen. Das Diagramm 8C, das identische Angaben wie das Diagramm 7B enthält, enthält eine Teilmenge der Informationen des Diagramms 8B.

Die Figur 8 illustriert eine weitere bevorzugte Ausgestaltung der erfindungsgemäßen Simulationsvorrichtung Hx, wobei in einem Zeitfenster von mehreren Perioden des ersten Trägersignals F1 eine gleich lange Periodendauer für alle - in der Figur 8 gezeichneten - Trägersignale F1, F2, F3, F4, F5, F6, F7, F8, F9, F10, F11, F12 vorgesehen ist, und

- die Phasenverschiebung zwischen dem ersten Trägersignal F1 und dem fünften Trägersignal F5 in positiver Zeitrichtung ein Drittel der Periodendauer des ersten Trägersignals F1 ist,
- und die Phasenverschiebung zwischen dem fünften Trägersignal F5 und dem neunten Trägersignal F9 in positiver Zeitrichtung ein Drittel der Periodendauer des ersten Trägersignals F1 ist. Dabei gilt in dem letztgenannten Zeitfenster:
- das erste Trägersignal F1 gleicht dem dritten Trägersignal F3, und
- das fünfte Trägersignal F5 gleicht dem siebten Trägersignal F7, und
- das neunte Trägersignal F9 gleicht dem elften Trägersignal F11, und
- die Trägersignale mit den Bezugszeichen F1, F3, F5, F7, F9, F11 schwingen zwischen der gemeinsamen Bezugsspannung Uref, die das spannungsmäßige Minimum der Trägersignale mit den Bezugszeichen F1, F3, F5, F7, F9, F11 darstellt und der Maximalspannung Umax, die das spannungsmäßige Maximum der Trägersignale mit den Bezugszeichen F1, F3, F5, F7, F9, F11 darstellt.

In dem letztgenannten Zeitfenster

- ist die Phasenverschiebung zwischen dem zweiten Trägersignal F2 und dem sechsten Trägersignal F6 in positiver Zeitrichtung ein Drittel der Periodendauer des ersten Trägersignals F1, und

- ist die Phasenverschiebung zwischen dem sechsten Trägersignal F6 und dem zehnten Trägersignal F10 in positiver Zeitrichtung ein Drittel der Periodendauer des ersten Trägersignals F1, und
- das zweite Trägersignal F2 gleicht dem vierten Trägersignal F4, und
- das sechste Trägersignal F6 gleicht dem achten Trägersignal F8, und
- das zehnte Trägersignal F10 gleicht dem zwölften Trägersignal F12, und
- die Trägersignale mit den Bezugzeichen F2, F4, F6, F8, F10, F12 schwingen zwischen der gemeinsamen Bezugsspannung Uref, die das spannungsmäßige Maximum der Trägersignale mit den Bezugzeichen F2, F4, F6, F8, F10, F12 darstellt und der Minimalspannung Umin, die das spannungsmäßige Minimum der Trägersignale mit den Bezugzeichen F2, F4, F6, F8, F10, F12 darstellt.

Gemäß der mittels Diagramm 8B der Figur 8 illustrierten bevorzugten Ausgestaltung der erfindungsgemäßen Simulationsvorrichtung Hx werden in dem letztgenannten Zeitfensters bildlich ausgedrückt:

- per Spiegelung identischer Funktionskurven des ersten Trägersignals F1 und des dritten Trägersignals F3 an der Zeitachse Ltu gespiegelte identische Funktionskurven des zweiten Trägersignals F2 und des vierten Trägersignals F4 ausgebildet, und
- per Spiegelung identischer Funktionskurven des fünften Trägersignals F5 und des siebten Trägersignals F7 an der Zeitachse Ltu gespiegelte identische Funktionskurven des sechsten Trägersignals F6 und des achten Trägersignals F8 ausgebildet, und
- per Spiegelung identischer Funktionskurven des neunten Trägersignals F9 und des elften Trägersignals F11 an der Zeitachse Ltu gespiegelte identische Funktionskurven des zehnten Trägersignals F10 und des zwölften Trägersignals F12 ausgebildet.

In einer weiteren bevorzugten Ausgestaltung der erfindungsgemäßen Simulationsvorrichtung Hx sind der erste Trägersignalgenerator Cg1, der fünfte Trägersignalgenerator Cg5 und der neunte Trägersignalgenerator Cg9 vorgesehen und eingerichtet, um zu einem Zustandswechselzeitpunkt, an dem ein Wechsel von dem zweiten DUT-Betriebszustand in den ersten DUT-Betriebszustand oder ein entgegengesetzter Wechsel stattfindet, mittels des ersten Trägersignalgenerators Cg1 einen Vorzeichen-Wechsel der Steigung des ersten Trägersignals F1, und mittels des fünften Trägersignalgenerators Cg5 einen Vorzeichen-Wechsel der Steigung des fünften Trägersignals F5, und mittels des neunten Trägersignalgenerators Cg9 einen Vorzeichen-Wechsel der Steigung des neunten Trägersignals F9 vorzunehmen.

Ein Zustandswechselzeitpunkt ist bspw. ein Zeitpunkt einer Stromrichtungsumkehr des ersten Simulationsstromes Is1.

Soweit eine Ausgestaltung der Erfindung vorgesehen ist, die in oben beschriebener Weise bis zu zwölf Trägersignale mit den Bezugzeichen F1, F2, F3, F4, F5, F6, F7, F8, F9, F10, F11, F12 umfasst, dann ist es bevorzugt, dass alle jeweils von der Ausgestaltung umfassten Trägersignale zu einem Zustandswechselzeitpunkt, an dem ein Wechsel von dem zweiten DUT-Betriebszustand in den ersten DUT-Betriebszustand oder ein entgegengesetzter Wechsel stattfindet, mittels des entsprechenden Trägersignalgenerators mit dem Bezugzeichen Cg1, Cg2, Cg3, Cg4, Cg5, Cg6, Cg7, Cg8, Cg9, Cg10, Cg11, Cg12 einen entsprechenden Vorzeichen-Wechsel der Steigung des entsprechenden Trägersignals mit dem Bezugzeichen F1, F2, F3, F4, F5, F6, F7, F8, F9, F10, F11, F12 vornimmt.

Praktische Versuche der Schutzrechtsanmelderin haben gezeigt, dass ein ungewollter, den ersten Simulationsstrom Is1 überlagernder Rippelstrom (engl.: ripple current), der bspw. in vielen Anwendungsfällen den ersten Simulationsstrom Is1 mit bestimmten Oberwellen überlagernde zeitlich veränderliche Strom vorteilhafterweise mittels der Erfindung bzw. einer ihrer beschriebenen Ausgestaltungen reduzierbar ist. Die Rippelströme können prinzipiell in den hier beschriebenen Mehrstufen-Konvertern abhängig von deren möglichen unterschiedlichen Steuerverfahren in einer vergleichsweise stärkeren oder geringeren Ausprägung auftreten. Die vorliegende Lehre, insbesondere die vorliegenden Beschreibungsabsätze zu dem Diagramm 7B und zu dem Diagramm 8B zeigen Wege, um insbesondere die durch Umschaltvorgänge an dem ersten Mehrstufen-Konverter des ersten Stellmittels S1 und/oder durch Umschaltvorgänge an dem zweiten Mehrstufen-Konverter des zweiten Stellmittels S2 und/oder durch Umschaltvorgänge an dem dritten Mehrstufen-Konverter des dritten Stellmittels S3 hervorgerufen Rippelströme mit vergleichsweise einfachen Mitteln bzw. Verfahrensschritten zu reduzieren.

Eine vorteilhafte Weiterentwicklung der letztgenannten bevorzugten Ausführungsform, die insbesondere auf einen der Patentansprüche 11 oder 12 rückbezogen ist, zeichnet sich durch folgende weitere Merkmale in einer Kombination aus:

- von einem, dem ersten Stellmittel S1 zugehörigen, ersten Konverter-Ausgang M1 zu einem ersten Induktivitätsbauteil L1 ist ein erster Wicklungsstrom Iw1 weiterleitbar, und
- von einem, dem zweiten Stellmittel S2 zugehörigen, zweiten Konverter-Ausgang M2 zu einem zweiten Induktivitätsbauteil L2 ist ein zweiter Wicklungsstrom Iw2 weiterleitbar, und
- von einem, dem dritten Stellmittel S3 zugehörigen, dritten Konverter-Ausgang M3 zu einem dritten Induktivitätsbauteil L3 ist ein dritter Wicklungsstrom Iw3 weiterleitbar, und
- das erste Induktivitätsbauteil L1 weist einen ersten ferromagnetischen Kern Fe1 zur Bereitstellung einer magnetische Koppelung der Magnetfelder des ersten Wicklungsstromes Iw1 und des dritten Wicklungsstromes Iw3 auf, und
- das zweite Induktivitätsbauteil L2 weist einen zweiten ferromagnetischen Kern Fe2 zur Bereitstellung einer magnetische Koppelung der Magnetfelder des ersten Wicklungsstromes Iw1 und des zweiten Wicklungsstromes Iw2 auf, und
- das dritte Induktivitätsbauteil L3 weist einen dritten ferromagnetischen Kern Fe3 zur Bereitstellung einer magnetische Koppelung der Magnetfelder des zweiten Wicklungsstromes Iw2 und des dritten Wicklungsstromes Iw3 auf.

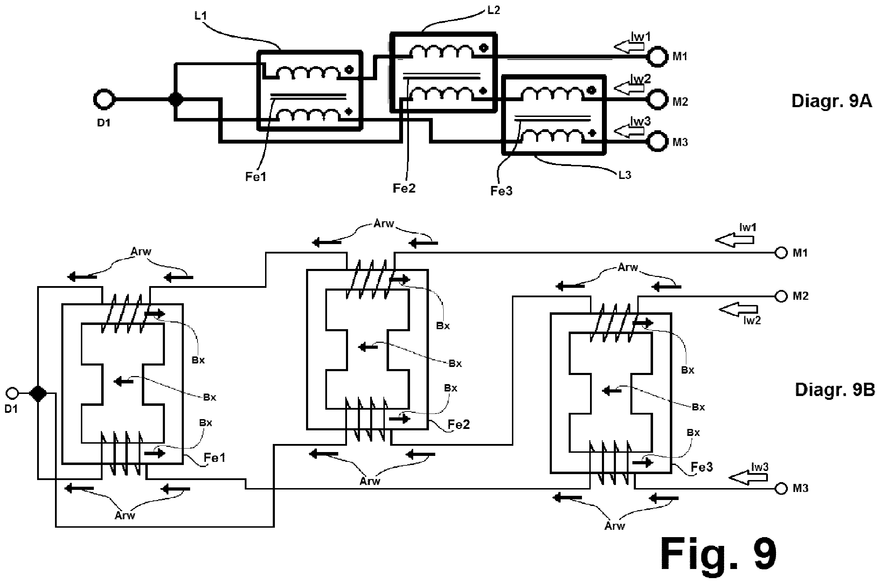

In der letztgenannten Weiterentwicklung sind vorzugsweise die an einem jeweiligen ferromagnetischen Kern Fe1, Fe2, Fe3 paarweise angeordneten Wicklungen derart angeordnet, dass sich entsprechende Gleichstromanteile der magnetischen Flüsse eines Wicklungspaares an dem zugeordneten ferromagnetischen Kern möglichst weitgehend gegenseitig aufheben. Die in Figur 9 dargestellte jeweils paarweise angeordneter Wicklungen an einem zugeordneten ferromagnetischen Kern tragen bevorzugt dazu bei, dass wirksame transiente Induktivitäten mit Bezug auf die Rippelströme, die dem ersten Wicklungsstrom Iw1 und dem zweiten Wicklungsstrom Iw2 und dem dritten Wicklungsstrom Iw3 überlagert sind, reduziert sind bzw. reduziert werden. Damit ist eine vergleichsweise höhere Dynamik der erfindungsgemäßen Simulationsvorrichtung Hx erreichbar, bspw. eine vergleichsweise schnellere Betrags- oder Richtungsänderung des ersten Simulationsstromes Is1, was einem weiteren Vorteil in hochdynamischen Simulationsszenarien gleichkommt.

Die Figur 9 zeigt in einer stärker schematisierten Darstellung gemäß Diagramm 9A und in einer vergleichsweise detaillierteren Darstellung gemäß Diagramm 9B dieselbe Schaltungsanordnung. Das Diagramm 9B zeigt eine Momentaufnahme, wobei in dem dargestellten Moment die magnetische Flussdichte in der mit Bx bezeichneten Pfeilrichtung verläuft und die technische Stromrichtung in dem dargestellten Moment eine Richtung gemäß der mit Arw bezeichneten Pfeile aufweist.

In einer bevorzugten Verwendung der erfindungsgemäßen Simulationsvorrichtung Hx wird diese als sogenannte "Hardware-in-the-loop-Simulationsvorrichtung", in Fachkreisen auch als HIL-Simulator bezeichnet, eingesetzt. Die Berechnung der Modellvariablen mittels des Modellcodes erfolgt hierbei bevorzugt in Echtzeit.

Zusammenfassend bestehen die Vorteile der Erfindung bzw. deren Ausführungsformen, Weiterbildungen, Ausgestaltungen, Verwendung etc. darin, dass verbesserte Simulationsergebnisse bereitstellbar sind, als dies ohne die Erfindung möglich ist.

## Patentansprüche

1. Verfahren zur Simulation einer an ein Regelungsgerät (DUT) anschließbaren peripheren Schaltungsanordnung, wobei eine Simulationsvorrichtung (Hx) mit dem Regelungsgerät (DUT) elektrisch verbunden ist, und wobei die Simulationsvorrichtung (Hx) ein erstes Stellmittel (S1) aufweist, mit dem ein von einem ersten Lastanschluss (D1) des Regelungsgerätes (DUT) zu einem ersten Stellmittelausgang (Out1) des ersten Stellmittels (S1) weiterleitbarer erster Simulationsstrom (Is1) beeinflussbar ist, und wobei das erste Stellmittel (S1) einen ersten Mehrstufen-Konverter, aufweisend zumindest einen ersten Halbleiterschalter (T11) mit einem ersten Steuerungs-Anschluss (G11), einen zweiten Halbleiterschalter (T12) mit einem zweiten Steuerungs-Anschluss (G12), einen dritten Halbleiterschalter (T13) mit einem dritten Steuerungs-Anschluss (G13), und einen vierten Halbleiterschalter (T14) mit einem vierten Steuerungs-Anschluss (G14), umfasst, und wobei die Simulationsvorrichtung (Hx) des Weiteren ein erstes Halbleiterschalter-steuerungsmittel (Tc1) und eine Recheneinheit (Cx) umfasst, und die Recheneinheit (Cx) einen Modellcode ausführt, wobei mittels der Recheneinheit (Cx) und des Modellcodes ein erstes Schaltersteuersignal (Ts1) zur Weitergabe an das erste Halbleiterschaltersteuerungsmittel (Tc1) berechnet und bereitstellt wird, und wobei das erste Halbleiterschaltersteuerungsmittel (Tc1) zumindest einen ersten Komparator (Co1) aufweist, und der erste Komparator (Co1) einen ersten Komparator-Eingang (E11) und einen zweiten Komparator-Eingang (E12) und einen ersten Komparator-Ausgang (X1) umfasst, und wobei aus dem ersten Schaltersteuersignal (Ts1) ein erstes Modulationssignal (A1) abgeleitet und an den ersten Komparator-Eingang (E11) angelegt wird, und an den zweiten Komparator-Eingang (E12) ein erstes Trägersignal (F1) eines ersten Trägersignalgenerators (Cg1) angelegt wird, und mittels des ersten Komparators (Co1) ein Vergleich des ersten Modulationssignals (A1) mit dem ersten Trägersignal (F1) ausgeführt wird, wobei im Zuge des Vergleichs an dem ersten Komparator-Ausgang (X1) eine pulsweitenmodulierte erste Gate-Source-Spannung (Ts11) erzeugt und an den ersten Steuerungs-Anschluss (G11) angelegt wird, und mittels der ersten Gate-Source-Spannung (Ts11) der erste Simulationsstrom (Is1) beeinflusst wird, wobei in einem ersten DUT-Betriebszustand des Regelungsgerätes (DUT) ein erster Treibertransistor (Td1) des Regelungsgerätes (DUT) durchleitend geschaltet wird, und in einem zweiten DUT-Betriebszustand des Regelungsgerätes (DUT) ein zweiter Treibertransistor (Td2) des Regelungsgerätes (DUT) durchleitend geschaltet wird, wobei ein Wechsel von dem ersten DUT-Betriebszustand in den zweiten DUTBetriebszustand und/oder ein Wechsel von dem zweiten DUT-Betriebszustand in den ersten DUT-Betriebszustand mit einem Aussenden eines ersten Invertier-Signals (Ts4) einhergeht/einhergehen, und wobei das Aussenden des ersten Invertier-Signal (Ts4) das erste Trägersignal (F1) und/oder ein zweites Trägersignal (F2) beeinflusst.

2. Verfahren nach Anspruch 1, **dadurch gekennzeichnet, dass** das erste Halbleiterschaltersteuerungsmittel (Tc1) zumindest einen zweiten Komparator (Co2) aufweist, und der zweite Komparator (Co2) einen dritten Komparator-Eingang (E21) und einen vierten Komparator-Eingang (E22) und einen zweiten Komparator-Ausgang (X2) umfasst, und wobei aus dem ersten Schaltersteuersignal (Ts1) ein zweites Modulationssignal (A2) abgeleitet und an den dritten Komparator-Eingang (E21) angelegt wird, und an den vierten Komparator-Eingang (E22) ein zweites Trägersignal (F2) eines zweiten Trägersignalgenerators (Cg2) angelegt wird, und mittels des zweiten Komparators (Co2) ein Vergleich des zweiten Modulationssignals (A2) mit dem zweiten Trägersignal (F2) ausgeführt wird, wobei im Zuge des Vergleichs an dem zweiten Komparator-Ausgang (X2) eine pulsweitenmodulierte zweite Gate-Source-Spannung (TsI2) erzeugt und an den zweiten Steuerungs-Anschluss (G12) angelegt wird, und mittels der zweiten Gate-Source-Spannung (Ts12) der erste Simulationsstrom (Is1) beeinflusst wird.

3. Verfahren nach einem der Ansprüche 1 oder 2, **dadurch gekennzeichnet, dass** das erste Trägersignal (F1) und/oder das zweite Trägersignal (F2) eine Dreiecksignalform oder eine Sägezahnsignalform aufweist oder aufweisen.

4. Verfahren nach einem der Ansprüche 1 bis 3, **dadurch gekennzeichnet, dass** der erste Trägersignalgenerators (Cg1) und/oder der zweite Trägersignalgenerator (Cg2) von dem ersten Halbleiterschaltersteuerungsmittel (Tel) umfasst ist.

5. Verfahren nach einem der Ansprüche 1 bis 4, **dadurch gekennzeichnet, dass** das Aussenden des ersten Invertier-Signals (Ts4) elektronisch ausgelöst wird mittels:

   i. einer Spannungsmessungs-Schaltung, die zur Messung einer ersten Ausgangsspannung (Uout1) an dem ersten Stellmittelausgang (Out1) eingerichtet ist, oder
   ii. einer Strommessungs-Schaltung, die zur Messung des ersten Simulationsstromes (Is1) eingerichtet ist, oder
   iii. einer allgemeinen Datenschnittstelle des Regelungsgerätes (DUT), oder
   iv. einer Debug-Schnittstelle des Regelungsgerätes (DUT).

6. Verfahren nach einem der Ansprüche 1 bis 5, **dadurch gekennzeichnet, dass** im Zuge einer Identifizierung des ersten Invertier-Signal (Ts4) ausgelöst wird, dass der erste Trägersignalgenerator (Cg1) das erste Trägersignals (F1) bezogen auf eine Zeitachse derart ändert, dass

   - in einer ersten Konstellation, bei der zu einem ersten Zeitpunkt einer Identifizierung des ersten Invertier-Signals (Ts4) eine fallende Trägersignal-Flanke vorliegt, eine sofortige Umschaltung auf eine steigende Trägersignal-Flanke ausgeführt wird,
   - in einer zweiten Konstellation, bei der zu einem zweiten Zeitpunkt einer Identifizierung des ersten InvertierSignals (Ts4) eine steigende Trägersignal-Flanke vorliegt, eine sofortige Umschaltung auf eine fallende Trägersignal-Flanke ausgeführt wird.

7. Verfahren nach einem der Ansprüche 2 bis 6, **dadurch gekennzeichnet, dass** in einem Zeitfenster von mehreren Perioden des ersten Trägersignals (F1) realisiert wird, dass das erste Modulationssignal (A1) dem zweiten Modulationssignal (A2) gleicht, und innerhalb des Zeitfensters einerseits das erste Trägersignal (F1) und das zweite Trägersignal (F2) betragsmäßig identische Spannungs-Zeit-Verläufe aufweisen und andererseits sowohl lokale Spannungs-Minima des ersten Trägersignals (F1) gleichzeitig mit lokalen Spannungs-Maxima des zweiten Trägersignals (F2) auftreten als auch lokale Spannungs-Maxima des ersten Trägersignals (F1) gleichzeitig mit den lokalen Spannungs-Minima des zweiten Trägersignals (F2) auftreten.

8. Verfahren nach einem der Ansprüche 1 bis 7 **dadurch gekennzeichnet, dass** die Simulationsvorrichtung (Hx) des Weiteren aufweist:

- ein zweites Stellmittel (S2) umfassend einen zweiten Mehrstufen-Konverter und einen zweiten Stellmittelausgang (Out2),
- ein drittes Stellmittel (S3) umfassend einen dritten Mehrstufen-Konverter und einen dritten Stellmittelausgang (Out3),
- ein zweites Halbleiterschaltersteuerungsmittel (Tc2) umfassend zumindest einen fünften Komparator (Co5), wobei der fünfte Komparator (Co5) einen neunten Komparator-Eingang (E51) und einen zehnten Komparator-Eingang (E52) und einen fünften Komparator-Ausgang (X5) umfasst, und
- ein drittes Halbleiterschaltersteuerungsmittel (Tc3) umfassend zumindest einen neunten Komparator (Co9), wobei der neunte Komparator (Co9) einen siebzehnten Komparator-Eingang (E91) und einen achtzehnten Komparator-Eingang (E92) und einen neunten Komparator-Ausgang (X9) aufweist,

wobei der zehnte Komparator-Eingang (E52) eingerichtet ist, um daran ein fünftes Trägersignal (F5) eines fünften Trägersignalgenerators (Cg5) anzulegen, und wobei der achtzehnte Komparator-Eingang (E92) eingerichtet ist, um daran ein neuntes Trägersignal (F9) eines neunten Trägersignalgenerators (Cg9) anzulegen, und wobei das erste Trägersignal (F1), das fünfte Trägersignal (F5) und das neunte Trägersignal (F9) jeweils eine identische Trägersignalfrequenz aufweisen, und eine erste zeitliche Differenz von einem Signalmaximum des ersten Trägersignals (F1) zu einem zeitlich nachfolgenden Signalmaximum des fünften Trägersignals (F5) gleicht einer zweiten zeitlichen Differenz von dem Signalmaximum des fünften Trägersignals (F5) zu einem zeitlich nachfolgenden Signalmaximum des neunten Trägersignals (F9), und wobei der erste Stellmittelausgang (Out1) und der zweite Stellmittelausgang (Out2) und der dritte Stellmittelausgang (Out3) elektrisch miteinander verbunden sind.

9. Simulationsvorrichtung (Hx) zur Simulation einer an ein Regelungsgerät (DUT) anschließbaren peripheren Schaltungsanordnung, wobei die Simulationsvorrichtung (Hx) mit dem Regelungsgerät (DUT) elektrisch verbindbar ist, und wobei die Simulationsvorrichtung (Hx) ein erstes Stellmittel (S1) aufweist, mit dem ein von einem ersten Lastanschluss (D1) des Regelungsgerätes (DUT) zu einem ersten Stellmittelausgang (Out1) des ersten Stellmittels (S1) weiterleitbarer erster Simulationsstrom (Is1) beeinflussbar ist, und wobei das erste Stellmittel (S1) einen ersten Mehrstufen-Konverter, aufweisend zumindest einen ersten Halbleiterschalter (T11) mit einem ersten Steuerungs-Anschluss (G11),

einen zweiten Halbleiterschalter (T12) mit einem zweiten Steuerungs-Anschluss (G12), einen dritten Halbleiterschalter (T13) mit einem dritten Steuerungs-Anschluss (G13), und einen vierten Halbleiterschalter (T14) mit einem vierten Steuerungs-Anschluss (G14), umfasst, und wobei die Simulationsvorrichtung (Hx) des Weiteren ein erstes Halbleiterschalter-steuerungsmittel (Tc1) und eine Recheneinheit (Cx) umfasst, und die Recheneinheit (Cx) zur Ausführung eines Modellcodes vorgesehen und eingerichtet ist, wobei vorgesehen ist, dass mittels der Recheneinheit (Cx) und des Modellcodes ein erstes Schaltersteuersignal (Ts1) zur Weitergabe an das erste Halbleiterschaltersteuerungsmittel (Tc1) berechnet und bereitgestellt wird, und wobei das erste Halbleiterschaltersteuerungsmittel (Tc1) zumindest einen ersten Komparator (Co1) aufweist, und der erste Komparator (Co1) einen ersten Komparator-Eingang (E11) und einen zweiten Komparator-Eingang (E12) und einen ersten Komparator-Ausgang (X1) umfasst, und der erste Komparator-Eingang (E11) eingerichtet ist, um daran ein von dem ersten Schaltersteuersignal (Ts1) abgeleitetes erstes Modulationssignal (A1) anzulegen, und der zweite Komparator-Eingang (E12) eingerichtet ist, um daran ein erstes Trägersignal (F1) eines ersten Trägersignalgenerators (Cg1) anzulegen, und mittels des ersten Komparators (Co1) ein Vergleich des ersten Modulationssignals (A1) mit dem ersten Trägersignal (F1) ausführbar ist, wobei im Zuge des Vergleichs an dem ersten Komparator-Ausgang (XI) eine pulsweitenmodulierte erste Gate-Source-Spannung (Ts11) erzeugbar ist und wobei vorgesehen ist, dass die erste Gate-Source-Spannung (Ts11) an den ersten Steuerungs-Anschluss (G11) angelegt wird, und mittels der ersten Gate-Source-Spannung (Ts11) der erste Simulationsstrom (Is1) beeinflussbar ist, wobei die Simulationsvorrichtung (Hx) ein Invertier-Signal (Ts4) identifiziert, das das Regelungsgerät (DUT) bei einem Wechsel von einem ersten DUT-Betriebszustand des Regelungsgerätes (DUT), bei dem ein erster Treibertransistor (Td1) des Regelungsgerätes (DUT) durchleitend geschaltet ist, in einen zweiten DUT-Betriebszustand des Regelungsgerätes (DUT), bei dem ein zweiter Treibertransistor (Td2) des Regelungsgerätes (DUT) durchleitend geschaltet ist, und/oder bei einem Wechsel von dem zweiten DUT-Betriebszustand in den ersten DUT-Betriebszustand aussendet, und wobei das Aussenden des ersten Invertier-Signals (Ts4) das erste Trägersignal (F1) und/oder ein zweites Trägersignal (F2) beeinflusst, und wobei die Simulationsvorrichtung vorgesehen und eingerichtet ist, um ein Verfahren nach einem der Ansprüche 1 bis 8 auszuführen.

**10.** Simulationsvorrichtung (Hx) nach Anspruch 9, **dadurch gekennzeichnet, dass** die Simulationsvorrichtung zur Beeinflussung des ersten Simulationsstromes (Is1) neben dem ersten Stellmittel (S1), ein zweites Stellmittel (S2) und ein drittes Stellmittel (S3) aufweist, wobei

- das erste Stellmittel (S1) eingerichtet ist, um von dem ersten Halbleiterschaltersteuerungsmittel (Tc1) gesteuert zu werden,

- ein zweites Stellmittel (S2) eingerichtet ist, um von einem zweiten Halbleiterschaltersteuerungsmittel (Tc2) gesteuert zu werden,
- ein drittes Stellmittel (S3) eingerichtet ist, um von einem dritten Halbleiterschaltersteuerungsmittel (Tc3) gesteuert zu werden, und wobei
- das erste Halbleiterschaltersteuerungsmittel (Tc1) zumindest einen ersten Trägersignalgenerator (Cg1) zur Bereitstellung eines mittenzentrierten periodischen ersten Trägersignals (F1) umfasst, und
- das zweite Halbleiterschaltersteuerungsmittel (Tc2) zumindest einen fünften Trägersignalgenerator (Cg5) zur Bereitstellung eines mittenzentrierten periodischen fünften Trägersignals (F5) umfasst, und
- das dritte Halbleiterschaltersteuerungsmittel (Tc3) zumindest einen neunten Trägersignalgenerator (Cg9) zur Bereitstellung eines mittenzentrierten periodischen neunten Trägersignals (F9) umfasst, und

wobei das erste Trägersignal (F1), das fünfte Trägersignal (F5) und das neunte Trägersignal (F9) in einem Zeitfenster von mehreren Perioden des ersten Trägersignals (F1) einerseits jeweils als Dreieckssignale mit identischer Periodendauer ausgestaltet, und andererseits in dem Zeitfenster gegeneinander phasenverschoben sind.

**11.** Simulationsvorrichtung nach Anspruch 10, **dadurch gekennzeichnet, dass** einerseits der Betrag der Phasenverschiebung zwischen dem ersten Trägersignal (F1) und dem fünften Trägersignal (F5) ein Drittel der Periodendauer des ersten Trägersignals (F1) ist, und andererseits der Betrag der Phasenverschiebung zwischen dem fünften Trägersignal (F5) und dem neunten Trägersignal (F9) ein Drittel der Periodendauer des ersten Trägersignals (F1) ist.

**12.** Simulationsvorrichtung nach einem der Ansprüche 9 bis 11, **dadurch gekennzeichnet, dass** der erste Trägersignalgenerator (Cg1), der fünfte Trägersignalgenerator (Cg5) und der neunte Trägersignalgenerator (Cg9) vorgesehen und eingerichtet sind, um zu einem Zustandswechselzeitpunkt, an dem ein Wechsel von einem zweiten DUTBetriebszustand in einen ersten DUT-Betriebszustand oder ein Wechsel von dem zweiten DUT-Betriebszustand in den ersten DUT-Betriebszustand stattfindet,

mittels des ersten Trägersignalgenerators (Cg1) einen Vorzeichen-Wechsel der Steigung des ersten Trägersignals (F1), und
mittels des fünften Trägersignalgenerators (Cg5) einen Vorzeichen-Wechsel der Steigung des fünften Trägersignals (F5), und
mittels des neunten Trägersignalgenerators (Cg9) einen Vorzeichen-Wechsel der Steigung des neunten Trägersignals (F9) vorzunehmen.

**13.** Simulationsvorrichtung (Hx) nach einem der Ansprüche 10 oder 11, **dadurch gekennzeichnet, dass**

- von einem, dem ersten Stellmittel (S1) zugehörigen, ersten Konverter-Ausgang (M1) zu einem ersten Induktivitätsbauteil (L1) ein erster Wicklungsstrom (Iw1) weiterleitbar ist, und
- von einem, dem zweiten Stellmittel (S2) zugehörigen, zweiten Konverter-Ausgang (M2) zu einem zweiten Induktivitätsbauteil (L2) ein zweiter Wicklungsstrom (Iw2) weiterleitbar ist, und
- von einem, dem dritten Stellmittel (S3) zugehörigen, dritten Konverter-Ausgang (M3) zu einem dritten Induktivitätsbauteil (L3) ein dritter Wicklungsstrom (Iw3) weiterleitbar ist,
und wobei das erste Induktivitätsbauteil (L1) einen ersten ferromagnetischen Kern (Fe1) zur Bereitstellung einer magnetische Koppelung der Magnetfelder des ersten Wicklungsstromes (Iw1) und des dritten Wicklungsstromes (Iw3), aufweist, und
wobei das zweite Induktivitätsbauteil (L2) einen zweiten ferromagnetischen Kern (Fe2) zur Bereitstellung einer magnetische Koppelung der Magnetfelder des ersten Wicklungsstromes (Iw1) und des zweiten Wicklungsstromes (Iw2), aufweist, und
wobei das dritte Induktivitätsbauteil (L3) einen dritten ferromagnetischen Kern (Fe3) zur Bereitstellung einer magnetische Koppelung der Magnetfelder des zweiten Wicklungsstromes (Iw2) und des dritten Wicklungsstromes (Iw3), aufweist.

**EP 3 196 714 B2**

**Claims**

1. A method for simulating a peripheral circuit configuration for connecting to a control device (DUT), a simulation device (Hx) being electrically connected to the control device (DUT), and the simulation device (Hx) comprising a first adjusting means (S 1) by means of which a first simulation current (Is1) for forwarding from a first load connection (D1) of the control device (DUT) to a first adjusting means output (Out1) of the first adjusting means (S 1) can be influenced, and the first adjusting means (S 1) comprising a first multistage converter comprising at least one first semiconductor switch (T11) having a first control connection (G11), a second semiconductor switch (T12) having a second control connection (G12), a third semiconductor switch (T13) having a third control connection (G13), and a fourth semiconductor switch (T14) having a fourth control connection (G14), and the simulation device (Hx) further comprising a first semiconductor control means (Tc1) and a computing unit (Cx), and the computing unit (Cx) executing a model code, a first switch control signal (Ts1) being computed and provided by means of the computing unit (Cx) and the model code for forwarding to the first semiconductor switch control means (Tc1), and the first semiconductor switch control means (Tc1) comprising at least one first comparator (Co1), and the first comparator (Co1) comprising a first comparator input (E11) and a second comparator input (E12) and a first comparator output (X1), and a first modulation signal (A1) being derived from the first switch control signal (Ts1) and applied at the first comparator input (E11), and a first carrier signal (F1) of a first carrier signal generator (Cg1) being applied at the second comparator input (E12), and a comparison of the first modulation signal (A1) with the first carrier signal (F1) being performed by means of the first comparator (Co1), a pulse-width modulated first gate source voltage (Ts11) being generated at the first comparator output (X1) as part of the comparison and applied at the first control connection (G11), and the first simulation current (Is1) being influenced by means of the first gate source voltage (Ts11), wherein in a first DUT operating state of the control device (DUT), a first driver transistor (Td1) of the control device (DUT) is switched for conducting, and in a second DUT operating state of the control device (DUT), a second driver transistor (Td2) of the control device (DUT) is switched for conducting, wherein changing from the first DUT operating state to the second DUT operating state and/or changing from the second DUT operating state to the first DUT operating state is accompanied by transmitting a first inverting signal (Ts4), and wherein transmitting the first inverting signal (Ts4) influences the first carrier signal (F1) and/or the second carrier signal (F2).

2. The method according to claim 1, **characterized in that** the first semiconductor switch control means (Tc1) comprises at least one second comparator (Co2) and the second comparator (Co2) comprises a third comprise input (E21) and a fourth comparator input (E22) and a second comparator output (X2), and wherein a second modulation signal (A2) is derived from the first switch control signal (Ts1) and applied at the third comparator input (E21), and a second carrier signal (F2) of a second carrier signal generator (Cg2) is applied at the fourth comparator input (E22), and a comparison of the second modulation signal (A2) with the second carrier signal (F2) is performed by means of the second comparator (Co2), wherein a pulse-width modulated second gate source voltage (Ts12) is generated at the second comparator output (X2) in the course of comparing and is applied at the second control connection (G12), and the first simulation current (Is1) is influenced by means of the second gate source voltage (Ts12).

3. The method according to any one of the claims 1 or 2, **characterized in that** the first carrier signal (F1) and/or the second carrier signal (F2) comprises or comprise a triangular signal shape or a sawtooth signal shape.

4. The method according to any one of the claims 1 through 3, **characterized in that** the first carrier signal generator (Cg1) and/or the second carrier signal generator (Cg2) is comprised by the first semiconductor switch control means (Tc1).

5. The method according to any one of claims 1 to 4, **characterized in that** transmitting the first inverting signal (Ts4) is initiated electronically by means of:

   i. a voltage measuring circuit set up for measuring a first output voltage (Uout1) at the first adjusting means output (Out1), or
   ii. a current measuring circuit set up for measuring the first simulation current (Is1), or
   iii. a general data interface of the control device (DUT), or
   iv. a debug interface of the control device (DUT).

6. The method according to any one of claims 1 to 5, **characterized in that** in the course of identifying the first inverting signal (Ts4), it is initiated that the first carrier signal generator (Cg1) modifies the first carrier signal (F1) with respect to a time axis, such that

31

- in a first constellation, wherein a falling carrier signal flank exists at a first point in time of identifying the first inverting signal (Ts4), immediate switching over to a rising carrier signal flank is executed,
- in a second constellation, wherein a rising carrier signal flank exists at a second point in time of identifying the first inverting signal (Ts4), immediate switching over to a falling carrier signal flank is executed.

7.  The method according to any one of the claims 2 through 6, **characterized in that** it is implemented in a time window of a plurality of periods of the first carrier signal (F1) that the first modulation signal (A1) is equal to the second modulation signal (A2), and within the time window the first carrier signal (F1) and the second carrier signal (F2) comprise voltage-time curves having identical magnitude and both local voltage minima of the first carrier signal (F1) occur simultaneously with and local voltage maxima of the second carrier signal (F2) and local voltage maximum of the first carrier signal (F1) occur simultaneously with the local voltage minima of the second carrier signal (F2) .

8.  The method according to any one of the claims 1 through 7, **characterized in that** the simulation device (Hx) further comprises:

    - a second adjusting means (S2) comprising a second multistage converter and a second adjusting means output (Out2),
    - a third adjusting means (S3) comprising a third multistage converter and a third adjusting means output (Out3),
    - a second semiconductor switch control means (Tc2) comprising at least one fifth comparator (Co5), wherein the fifth comparator (Co5) comprises a ninth comparator input (E51) and a tenth comparator input (E52) and a fifth comparator output (X5), and
    - a third semiconductor switch control means (Tc3) comprising at least one ninth comparator (Co9), wherein the ninth comparator (Co9) comprises a seventeenth comparator input (E91) and an eighteenth comparator input (E92) and a ninth comparator output (X9),

    wherein the tenth comparator input (E52) is set up for applying a fifth carrier signal (F5) of a fifth carrier signal generator (Cg5) thereto, and wherein the eighteenth comparator input (E92) is set up for applying a ninth carrier signal (F9) of a ninth carrier signal generator (Cg9) thereto, and wherein the first carrier signal (F1), the fifth carrier signal (F5), and the ninth carrier signal (F9) each comprise an identical carrier signal frequency, and a first time difference between a signal maximum of the first carrier signal (F1) and a subsequent signal maximum of the fifth carrier signal (F5) is equal to a second time difference between the signal maximum of the fifth carrier signal (F5) and a subsequent signal maximum of the ninth carrier signal (F9), wherein the first adjusting means output (Out1) and the second adjusting means output (Out2) and the third adjusting means (Out3) are electrically connected to each other.

9.  A simulation device (Hx) for simulating a peripheral circuit configuration for connecting to a control device (DUT), the simulation device (Hx) being electrically connectable to the control device (DUT), and the simulation device (Hx) comprising a first adjusting means (S1) by means of which a first simulation current (Is1) for forwarding from a first load connection (D1) of the control device (DUT) to a first adjusting means output (Out1) of the first adjusting means (S1) can be influenced, and the first adjusting means (S1) comprising a first multistage converter comprising at least one first semiconductor switch (T11) having a first control connection (G11),

    a second semiconductor switch (T12) having a second control connection (G12),
    a third semiconductor switch (T13) having a third control connection (G13), and a fourth semiconductor switch (T14) having a fourth control connection (G14), and
    the simulation device (Hx) further comprising a first semiconductor control means (Tc1) and a computing unit (Cx), and the computing unit (Cx) being provided and set up for executing a model code, it being provided that a first switch control signal (Ts1) is computed and provided by means of the computing unit (Cx) and the model code for forwarding to the first semiconductor switch control means (Tc1), and the first semiconductor switch control means (Tc1) comprising at least one first comparator (Co1), and the first comparator (Co1) comprising a first comparator input (E11) and a second comparator input (E12) and a first comparator output (X1), and the first comparator input (E11) being set up for applying thereto a first modulation signal (A1) derived from the first switch control signal (Ts1), and the second comparator input (E12) is set up for applying thereto a first carrier signal (F1) of a first carrier signal generator (Cg1), and comparing the first modulation signal (A1) with the first carrier signal (F1) being able to be executed by means of the first comparator (Co1), a pulse-width modulated first gate source voltage (Ts11) being able to be generated at the first comparator output (X1) in the course of comparing, and it being provided that the first gate source voltage (Ts11) is applied at the first control connection (G11) and the first simulation current (Is1) can be influenced by means of the first gate source voltage (Ts11), wherein the simulation device (Hx) identifies an inverting signal (Ts4) which the control device (DUT) transmits when changing from a first DUT operating state of the control device (DUT) in which a first driver transistor (Td1) of the control device (DUT) is switched for conducting into a second DUT operating state of the control device (DUT) in which a second driver transistor (Td2) of the control device (DUT) is switched for conducting and/or when changing from the second DUT operating state into the first DUT operating state and wherein the transmitting of the first inverting signal (Ts4) influences the first carrier signal (F1) and/or a second carrier signal (F2), the simulation device being provided and set up for performing a method according to any one of the claims 1 through 8.

10. The simulation device (Hx) according to claim 9, **characterized in that** the simulation device comprises a second adjusting means (S2) and a third adjusting means (S3) in addition to the first adjusting means (S1) for influencing the first simulation current (Is1), wherein

- the first adjusting means (S 1) is set up for being controlled by the first semiconductor switch control means (Tc1),

- a second adjusting means (S2) is set up for being controlled by a second semiconductor switch control means (Tc2),
- a third adjusting means (S3) is set up for being controlled by a third semiconductor switch control means (Tc3), and wherein
- the first semiconductor switch control means (Tc1) comprises at least one first carrier signal generator (Cg1) for providing a centered periodic first carrier signal (F1), and
- the second semiconductor switch control means (Tc2) comprises at least one fifth carrier signal generator (Cg5) for providing a centered periodic fifth carrier signal (F5), and
- the third semiconductor switch control means (Tc3) comprises at least one ninth carrier signal generator (Cg9) for providing a centered periodic ninth carrier signal (F9), and

wherein the first carrier signal (F1), the fifth carrier signal (F5), and the ninth carrier signal (F9) are each embodied as a triangular signals having identical period duration in a time window of a plurality of periods of the first carrier signal (F1) and are also phase offset relative to each other in the time window.

11. The simulation device according to claim 10, **characterized in that** the magnitude of the phase offset between the first carrier signal (F1) and the fifth carrier signal (F5) is one-third of the period duration of the first carrier signal (F1), and the magnitude of the phase offset between the fifth carrier signal (F5) and the ninth carrier signal (F9) is one-third of the period duration of the first carrier signal (F1).

12. The simulation device according to any one of the claims 9 through 11, **characterized in that** the first carrier signal generator (Cg1), the fifth carrier signal generator (Cg5), and the ninth carrier signal generator (Cg9) are provided and set up for performing, at a point in time of state change at which a change from a second DUT operating state to a first DUT operating state or a change from the second DUT operating state to the first DUT operating state takes place,

a sign change of the slope of the first carrier signal (F 1) by means of the first carrier signal generator (Cg1), and
a sign change of the slope of the fifth carrier signal (F5) by means of the fifth carrier signal generator (Cg5), and
a sign change of the slope of the ninth carrier signal (F9) by means of the ninth carrier signal generator (Cg9) .

13. The simulation device (Hx) according to any one of the claims 10 or 11, **characterized in that**

- a first winding current (Iw1) can be forwarded from a first converter output (M1) associated with the first adjusting means (S1) to a first inductor component (L1), and
- a second winding current (Iw2) can be forwarded from a second converter output (M2) associated with the second adjusting means (S2) to a second inductor component (L2), and
- a third winding current (Iw3) can be forwarded from a third converter output (M3) associated with the third adjusting means (S3) to a third inductor component (L3),
and wherein the first inductor component (L1) comprises a first ferromagnetic core (Fe1) for providing a magnetic coupling of the magnetic fields of the first winding current (Iw1) and of the third winding current (Iw3), and
wherein the second inductor component (L2) comprises a second ferromagnetic core (Fe2) for providing a magnetic coupling of the magnetic fields of the first winding current (Iw1) and of the second winding current (Iw2), and

wherein the third inductor component (L3) comprises a third ferromagnetic core (Fe3) for providing a magnetic coupling of the magnetic fields of the second winding current (Iw2) and of the third winding current (Iw3).

**Revendications**

1. Procédé de simulation d'un arrangement de circuit périphérique pouvant être connecté à un régulateur (DUT), un dispositif de simulation (Hx) étant relié électriquement au régulateur (DUT) et le dispositif de simulation (Hx) possédant un premier moyen de réglage (S1), avec lequel peut être influencé un premier courant de simulation (Is1) pouvant être retransmis d'une première borne de charge (D1) du régulateur (DUT) à une première sortie de moyen de réglage (Out1) du premier moyen de réglage (S1), et le premier moyen de réglage (S1) comportant un premier convertisseur à étages multiples, possédant au moins un premier commutateur à semiconducteur (T11) pourvu d'une première borne de commande (G11), un deuxième commutateur à semiconducteur (T12) pourvu d'une deuxième borne de commande (G12), un troisième commutateur à semiconducteur (T13) pourvu d'une troisième borne de commande (G13) et un quatrième commutateur à semiconducteur (T14) pourvu d'une quatrième borne de commande (G14), et le dispositif de simulation (Hx) comportant en outre un premier moyen de commande de commutateur à semiconducteur (Tc1) et une unité de calcul (Cx), et l'unité de calcul (Cx) exécutant un code de modèle, un premier signal de commande de commutateur (Ts1) étant calculé et fourni au moyen de l'unité de calcul (Cx) et du code de modèle en vue de sa retransmission au premier moyen de commande de commutateur à semiconducteur (Tc1), et le premier moyen de commande de commutateur à semiconducteur (Tc1) possédant au moins un premier comparateur (Co1), et le premier comparateur (Co1) comportant une première entrée de comparateur (E11) et une deuxième entrée de comparateur (E12) et une première sortie de comparateur (X1), et un premier signal de modulation (A1) étant dérivé du premier signal de commande de commutateur (Ts1) et appliqué à la première entrée de comparateur (E11), et un premier signal porteur (F1) d'un premier générateur de signal porteur (Cg1) étant appliqué à la deuxième entrée de comparateur (E12), et une comparaison du premier signal de modulation (A1) et du premier signal porteur (F1) étant effectuée au moyen du premier comparateur (Co1), une première tension gâchette-source (Ts11) modulée en largeur d'impulsions étant générée au niveau de la première sortie de comparateur (X1) dans le cadre de la comparaison et appliquée à la première borne de commande (G11), et le premier courant de simulation (Is1) étant influencé au moyen de la première tension gâchette-source (Ts11), un premier transistor d'attaque (Td1) du régulateur (DUT) étant commuté à l'état passant dans un premier état opérationnel de DUT, et un deuxième transistor d'attaque (Td2) du régulateur (DUT) étant commuté à l'état passant dans un deuxième état opérationnel de DUT, un changement du premier état opérationnel de DUT au deuxième état opérationnel de DUT et/ou un changement du deuxième état opérationnel de DUT au premier état opérationnel de DUT s'accompagnant d'une émission d'un premier signal inverseur (Ts4), et l'émission du premier signal inverseur (Ts4) influençant le premier signal porteur (F1) et/ou un deuxième signal porteur (F2).

2. Procédé selon la revendication 1, **caractérisé en ce que** le premier moyen de commande de commutateur à semiconducteur (Tc1) possède au moins un deuxième comparateur (Co2) et le deuxième comparateur (Co2) comportant une troisième entrée de comparateur (E21) et une quatrième entrée de comparateur (E22) et une deuxième sortie de comparateur (X2), et un deuxième signal de modulation (A2) étant dérivé du premier signal de commande de commutateur (Ts1) et appliqué à la troisième entrée de comparateur (E21), et un deuxième signal porteur (F2) d'un deuxième générateur de signal porteur (Cg2) étant appliqué à la quatrième entrée de comparateur (E22), et une comparaison du deuxième signal de modulation (A2) et du deuxième signal porteur (F2) étant effectuée au moyen du deuxième comparateur (Co2), une deuxième tension gâchette-source (Ts12) modulée en largeur d'impulsions étant générée au niveau de la deuxième sortie de comparateur (X2) dans le cadre de la comparaison et appliquée à la deuxième borne de commande (G12), et le premier courant de simulation (Is1) étant influencé au moyen de la deuxième tension gâchette-source (Ts12).

3. Procédé selon l'une des revendications 1 ou 2, **caractérisé en ce que** le premier signal porteur (F1) et/ou le deuxième signal porteur (F2) possède ou possèdent une forme de signal triangulaire ou une forme de signal en dents de scie.

4. Procédé selon l'une des revendications 1 à 3, **caractérisé en ce que** le premier générateur de signal porteur (Cg1) et/ou deuxième générateur de signal porteur (Cg2) est compris par le premier moyen de commande de commutateur à semiconducteur (Tc1).

5. Procédé selon l'une des revendications 1 à 4, **caractérisé en ce que** l'émission du premier signal inverseur (Ts4) est déclenchée électroniquement au moyen de :

i. un circuit de mesure de tension, lequel est conçu pour mesure une première tension de sortie (Uout1) au niveau de la première sortie de moyen de réglage (Out1), ou

ii. un circuit de mesure de courant, lequel est conçu pour mesurer le premier courant de simulation (Is1), ou

iii. une interface de données universelle du régulateur (DUT), ou

iv. une interface de débogage du régulateur (DUT).

6. Procédé selon l'une des revendications 1 à 5, **caractérisé en ce que** dans le cadre d'une identification du premier signal inverseur (Ts4), il est déclenché que le premier générateur de signal porteur (Cg1) modifie le premier signal porteur (F1) en référence à un axe de temps de telle sorte que

- dans une première constellation, avec laquelle un front descendant de signal porteur est présent à un premier instant d'une identification du premier signal inverseur (Ts4), une permutation immédiate sur un front montant de signal porteur est effectuée,

- dans une deuxième constellation, avec laquelle un front montant de signal porteur est présent à un deuxième instant d'une identification du premier signal inverseur (Ts4), une permutation immédiate sur un front descendant de signal porteur est effectuée.

7. Procédé selon l'une des revendications 2 à 6, **caractérisé en ce que** dans un créneau temporel de plusieurs périodes du premier signal porteur (F1), il est réalisé que le premier signal de modulation (A1) est identique au deuxième signal de modulation (A2) et, à l'intérieur du créneau temporel, d'une part le premier signal porteur (F1) et le deuxième signal porteur (F2) présentent des courbes tension-temps de valeurs identiques et, d'autre part, à la fois des minimums de tension locaux du premier signal porteur (F1) se produisent simultanément avec des maximums de tension locaux du deuxième signal porteur (F2) et aussi des maximums de tension locaux du premier signal porteur (F1) se produisent simultanément avec des minimums de tension locaux du deuxième signal porteur (F2).

8. Procédé selon l'une des revendications 1 à 7, **caractérisé en ce que** le dispositif de simulation (Hx) possède en outre :

- un deuxième moyen de réglage (S2) comportant un deuxième convertisseur à étages multiples et une deuxième sortie de moyen de réglage (Out2),

- un troisième moyen de réglage (S3) comportant un troisième convertisseur à étages multiples et une troisième sortie de moyen de réglage (Out3),

- un deuxième moyen de commande de commutateur à semiconducteur (Tc2) comportant au moins un cinquième comparateur (Co5), le cinquième comparateur (Co5) comportant une neuvième entrée de comparateur (E51) et une dixième entrée de comparateur (E52) et une cinquième sortie de comparateur (X5), et

- un troisième moyen de commande de commutateur à semiconducteur (Tc3) comportant au moins un neuvième comparateur (Co9), le neuvième comparateur (Co9) comportant une dix-septième entrée de comparateur (E91) et une dix-huitième entrée de comparateur (E92) et une neuvième sortie de comparateur (X9),

la dixième entrée de comparateur (E52) étant conçue pour y appliquer un cinquième signal porteur (F5) d'un cinquième générateur de signal porteur (Cg5), et la dix-huitième entrée de comparateur (E92) étant conçue pour y appliquer un neuvième signal porteur (F9) d'un neuvième générateur de signal porteur (Cg9), et le premier signal porteur (F1), le cinquième signal porteur (F5) et le neuvième signal porteur (F9) possédant respectivement une fréquence de signal porteur identique, et une première différence dans le temps entre un maximum de signal du premier signal porteur (F1) et un maximum de signal suivant dans le temps du cinquième signal porteur (F5) étant égale à une deuxième différence dans le temps entre un maximum de signal du cinquième signal porteur (F5) et un maximum de signal suivant dans le temps du neuvième signal porteur (F9), et la première sortie de moyen de réglage (Out1) et la deuxième sortie de moyen de réglage (Out2) et la troisième sortie de moyen de réglage (Out3) étant reliées électriquement les unes aux autres.

9. Dispositif de simulation (Hx) destiné à la simulation d'un arrangement de circuit périphérique pouvant être connecté à un régulateur (DUT), le dispositif de simulation (Hx) étant relié électriquement au régulateur (DUT) et le dispositif de simulation (Hx) possédant un premier moyen de réglage (S1), avec lequel peut être influencé un premier courant de simulation (Is1) pouvant être retransmis d'une première borne de charge (D1) du régulateur (DUT) à une première sortie de moyen de réglage (Out1) du premier moyen de réglage (S1), et le premier moyen de réglage (S1) comportant un premier convertisseur à étages multiples, possédant au moins un premier commutateur à semiconducteur (T11) pourvu d'une première borne de commande (G11),

un deuxième commutateur à semiconducteur (T12) pourvu d'une deuxième borne de commande (G12),
un troisième commutateur à semiconducteur (T13) pourvu d'une troisième borne de commande (G13) et un quatrième commutateur à semiconducteur (T14) pourvu d'une quatrième borne de commande (G14), et
le dispositif de simulation (Hx) comportant en outre un premier moyen de commande de commutateur à semiconducteur (Tc1) et une unité de calcul (Cx), et l'unité de calcul (Cx) étant prévue et conçue pour exécuter un code de modèle, le calcul et la fourniture d'un premier signal de commande de commutateur (Ts1) au moyen de l'unité de calcul (Cx) et du code de modèle étant prévus en vue de sa retransmission au premier moyen de commande de commutateur à semiconducteur (Tc1), et le premier moyen de commande de commutateur à semiconducteur (Tc1) possédant au moins un premier comparateur (Co1), et le premier comparateur (Co1) comportant une première entrée de comparateur (E11) et une deuxième entrée de comparateur (E12) et une première sortie de comparateur (X1), et la première entrée de comparateur (E11) étant conçue pour y appliquer un premier signal de modulation (A1) dérivé du premier signal de commande de commutateur (Ts1), et la deuxième entrée de comparateur (E12) étant conçue pour y appliquer un premier signal porteur (F1) d'un premier générateur de signal porteur (Cg1), et une comparaison du premier signal de modulation (A1) et du premier signal porteur (F1) pouvant être effectuée au moyen du premier comparateur (Co1), une première tension gâchette-source (Ts11) modulée en largeur d'impulsions pouvant être générée au niveau de la première sortie de comparateur (X1) dans le cadre de la comparaison et l'application de la première tension gâchette-source (Ts11) à la première borne de commande (G11) étant prévue, et le premier courant de simulation (Is1) pouvant être influencé au moyen de la première tension gâchette-source (Ts11), le dispositif de simulation (Hx) identifiant un signal inverseur (Ts4) qu'émet le régulateur (DUT) lors d'un changement d'un premier état opérationnel de DUT du régulateur (DUT), avec lequel un premier transistor d'attaque (Td1) du régulateur (DUT) est commuté à l'état passant, à un deuxième état opérationnel de DUT du régulateur (DUT), avec lequel un deuxième transistor d'attaque (Td2) du régulateur (DUT) est commuté à l'état passant, et/ou lors d'un changement du deuxième état opérationnel de DUT au premier état opérationnel de DUT, et l'émission du premier signal inverseur (Ts4) influençant le premier signal porteur (F1) et/ou un deuxième signal porteur (F2), et le dispositif de simulation étant prévu et conçu pour mettre en oeuvre un procédé selon l'une des revendications 1 à 8.

10. Dispositif de simulation (Hx) selon la revendication 9, **caractérisé en ce que** le dispositif de simulation, en vue d'influencer le premier courant de simulation (Is1), possède un deuxième moyen de réglage (S2) et un troisième moyen de réglage (S3) en plus du premier moyen de réglage (S1),

- le premier moyen de réglage (S1) étant conçu pour être commandé par le premier moyen de commande de commutateur à semiconducteur (Tc1),

- un deuxième moyen de réglage (S2) étant conçu pour être commandé par un deuxième moyen de commande de commutateur à semiconducteur (Tc2),
- un troisième moyen de réglage (S3) étant conçu pour être commandé par le troisième moyen de commande de commutateur à semiconducteur (Tc3), et
- le premier moyen de commande de commutateur à semiconducteur (Tc1) comportant au moins un premier générateur de signal porteur (Cg1) destiné à fournir un premier signal porteur (F1) périodique centré sur le milieu, et
- le deuxième moyen de commande de commutateur à semiconducteur (Tc2) comportant au moins un cinquième générateur de signal porteur (Cg5) destiné à fournir un cinquième signal porteur (F5) périodique centré sur le milieu, et
- le troisième moyen de commande de commutateur à semiconducteur (Tc3) comportant au moins un neuvième générateur de signal porteur (Cg9) destiné à fournir un neuvième signal porteur (F9) périodique centré sur le milieu, et

le premier signal porteur (F1), le cinquième signal porteur (F5) et le neuvième signal porteur (F9), dans un créneau temporel de plusieurs périodes du premier signal porteur (F1), étant d'une part respectivement configurés en tant que signaux triangulaires ayant une durée de période identique et, d'autre part, étant déphasés les uns par rapport aux autres dans le créneau temporel.

11. Dispositif de simulation selon la revendication 10, **caractérisé en ce que** d'une part, l'amplitude du déphasage entre le premier signal porteur (F1) et le cinquième signal porteur (F5) est égale à un tiers de la durée de la période du premier signal porteur (F1) et, d'autre part, l'amplitude du déphasage entre le cinquième signal porteur (F5) et le neuvième signal porteur (F9) est égale à un tiers de la durée de la période du premier signal porteur (F1).

**12.** Dispositif de simulation selon l'une des revendications 9 à 11, **caractérisé en ce que** le premier générateur de signal porteur (Cg1), le cinquième générateur de signal porteur (Cg5) et le neuvième générateur de signal porteur (Cg9) sont prévus et conçus pour, à un instant de changement d'état, auquel il se produit un changement d'un deuxième état opérationnel de DUT à un premier état opérationnel de DUT ou un changement du deuxième état opérationnel de DUT au premier état opérationnel de DUT, effectuer

un changement de signe de la pente du premier signal porteur (F1) au moyen du premier générateur de signal porteur (Cg1), et
un changement de signe de la pente du cinquième signal porteur (F5) au moyen du cinquième générateur de signal porteur (Cg5), et
un changement de signe de la pente du neuvième signal porteur (F9) au moyen du neuvième générateur de signal porteur (Cg9).

**13.** Dispositif de simulation selon l'une des revendications 10 ou 11, **caractérisé en ce que**

- un premier courant d'enroulement (Iw1) peut être retransmis d'une première sortie de convertisseur (M1), associée au premier moyen de réglage (S1), à un premier composant inductif (L1), et
- un deuxième courant d'enroulement (Iw2) peut être retransmis d'une deuxième sortie de convertisseur (M2), associée au deuxième moyen de réglage (S2), à un deuxième composant inductif (L2), et
- un troisième courant d'enroulement (Iw3) peut être retransmis d'une troisième sortie de convertisseur (M3), associée au troisième moyen de réglage (S3), à un troisième composant inductif (L3),
et le premier composant inductif (L1) possédant un premier noyau ferromagnétique (Fe1) destiné à fournir un couplage magnétique des champs magnétiques du premier courant d'enroulement (Iw1) et du troisième courant d'enroulement (Iw3), et
le deuxième composant inductif (L2) possédant un deuxième noyau ferromagnétique (Fe2) destiné à fournir un couplage magnétique des champs magnétiques du premier courant d'enroulement (Iw1) et du deuxième courant d'enroulement (Iw2), et
le troisième composant inductif (L3) possédant un troisième noyau ferromagnétique (Fe3) destiné à fournir un couplage magnétique des champs magnétiques du deuxième courant d'enroulement (Iw2) et du troisième courant d'enroulement (Iw3).

**Fig. 1a**
**(Stand der**
**Technik)**

104   106   108   101
102   103
110

105   107   109
GND   GND   GND

**Fig. 1b**
**(Stand der**
**Technik)**

111   111

104   106   108   101
102   103
120

105   107   109
GND   GND   GND

**Fig. 1c**
**(Stand der**
**Technik)**

17
13
18   14
3

$i_{ist}$   $i_{soll}$

**Fig. 2**

Fig. 3

Fig. 4

EP 3 196 714 B2

Fig. 5

EP 3 196 714 B2

Fig. 6

Diagr. 7A

Diagr. 7B

Diagr. 7C

Fig. 7

EP 3 196 714 B2

Diagr. 8A

Diagr. 8B

Diagr. 8C

Fig. 8

EP 3 196 714 B2

Diagr. 9A

Diagr. 9B

Fig. 9

EP 3 196 714 B2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2010010022 A1
- US 9020798 B2